# EUROPEAN PATENT APPLICATION

(11) **EP 2 871 223 A1**
(43) Date of publication of application: **13.05.2015**
(21) Application number: 13813173.5
(22) Date of filing: 04.07.2013
(51) Int. Cl.: C09K 11/06, H01L 51/50

(54) **COMPOSITE FOR ORGANIC LIGHT-EMITTING DIODE, ORGANIC LIGHT-EMITTING LAYER INCLUDING SAME, AND ORGANIC LIGHT-EMITTING DIODE**

(30) Priority: 04.07.2012 KR 20120073091; 06.11.2012 KR 20120124954
(71) Applicant: Samsung SDI Co., Ltd., Gyeonggi-do 446-902 (KR)
(72) Inventor: YU, Eun-Sun, Suwon-si Gyeonggi-do 443-803 (KR); CHAE, Mi-Young, Suwon-si Gyeonggi-do 443-803 (KR); KIM, Chang-Woo, Suwon-si Gyeonggi-do 443-803 (KR); LEE, Ho-Jae, Suwon-si Gyeonggi-do 443-803 (KR); LEE, Seung-Jae, Suwon-si Gyeonggi-do 443-803 (KR); HUH, Dal-Ho, Suwon-si Gyeonggi-do 443-803 (KR); KIM, Hyung-Sun, Suwon-si Gyeonggi-do 443-803 (KR); KIM, Wook, Suwon-si Gyeonggi-do 443-803 (KR); PARK, Moo-Jin, Suwon-si Gyeonggi-do 443-803 (KR)
(74) Representative: Michalski Hüttermann & Partner Patentanwälte mbB
(86) International application number: PCT/KR2013/005952
(87) International publication number: WO 2014/007564

(57) **Abstract**

Provided is a composition for an organic light emitting diode including a compound for an organic optoelectric device represented by Chemical Formula S-1; and a compound for an organic optoelectric device represented by Chemical Formula X-1, and an organic emission layer and organic light emitting diode.

## Description

### [Technical Field]

A composition for an organic light emitting diode, and an organic emission layer and an organic light emitting diode including the same are disclosed.

### [Background Art]

An organic optoelectric device is a device requiring a charge exchange between an electrode and an organic material by using holes or electrons.

An organic optoelectric device may be classified as follows in accordance with its driving principles. A first organic optoelectric device is an electronic device driven as follows: excitons are generated in an organic material layer by photons from an external light source; the excitons are separated into electrons and holes; and the electrons and holes are transferred to different electrodes as a current source (a voltage source).

A second organic optoelectric device is an electronic device driven as follows: a voltage or a current is applied to at least two electrodes to inject holes and/or electrons into an organic material semiconductor positioned at an interface of the electrodes, and the device is driven by the injected electrons and holes.

Examples of an organic optoelectric device include an organic photoelectric device, an organic light emitting diode, an organic solar cell, an organic photo conductor drum, an organic transistor, and the like, which require a hole injecting or transport material, an electron injecting or transport material, or a light emitting material.

Particularly, an organic light emitting diode (OLED) has recently drawn attention due to an increase in demand for flat panel displays. In general, organic light emission refers to conversion of electrical energy into photo-energy.

Such an organic light emitting diode converts electrical energy into light by applying current to an organic light emitting material. It has a structure in which a functional organic material layer is interposed between an anode and a cathode. Herein, the organic material layer includes a multi-layer including different materials, for example a hole injection layer, a hole transport layer, an emission layer, an electron transport layer, and an electron injection layer, in order to improve efficiency and stability of an organic light emitting diode.

In such an organic light emitting diode, when a voltage is applied between an anode and a cathode, holes from the anode and electrons from the cathode are injected to an organic material layer and recombined to generate excitons having high energy. The generated excitons generate light having certain wavelengths while shifting to a ground state.

Recently, it has become known that a phosphorescent light emitting material may be used for a light emitting material of an organic light emitting diode in addition to the fluorescent light emitting material. Such a phosphorescent material emits lights by transporting the electrons from a ground state to an exited state, non-radiance transiting of a singlet exciton to a triplet exciton through intersystem crossing, and transiting a triplet exciton to a ground state to emit light.

As described above, in an organic light emitting diode, an organic material layer includes a light emitting material and a charge transport material, for example a hole injection material, a hole transport material, an electron transport material, an electron injection material, and the like.

The light emitting material is classified as blue, green, and red light emitting materials according to emitted colors, and yellow and orange light emitting materials to emit colors approaching natural colors.

When one material is used as a light emitting material, a maximum light emitting wavelength is shifted to a long wavelength or color purity decreases because of interactions between molecules, or device efficiency decreases because of a light emitting quenching effect. Therefore, a host/dopant system is included as a light emitting material in order to improve color purity and increase luminous efficiency and stability through energy transfer.

In order to implement excellent performance of an organic light emitting diode, a material constituting an organic material layer, for example a hole injection material, a hole transport material, a light emitting material, an electron transport material, an electron injection material, and a light emitting material such as a host and/or a dopant, should be stable and have good efficiency. However, development of an organic material layer forming material for an organic light emitting diode has thus far not been satisfactory and thus there is a need for a novel material. This material development is also required for other organic optoelectric devices.

The low molecular organic light emitting diode is manufactured as a thin film in a vacuum deposition method and can have good efficiency and life-span performance, and a polymer organic light emitting diode is manufactured in an inkjet or spin coating method has an advantage of low initial cost and being large-sized.

Both low molecular organic light emitting and polymer organic light emitting diodes have an advantage of self-light emitting, high speed response, wide viewing angle, ultra-thin, high image quality, durability, large driving temperature range, and the like. In particular, they have good visibility due to self-light emitting characteristics compared with a conventional LCD (liquid crystal display) and have an advantage of decreasing a thickness and weight of LCD up to a third, because they do not need a backlight.

In addition, since they have a response speed 1000 time faster microsecond unit than LCD, they can realize a perfect motion picture without after-image. Accordingly, based on these advantages, they have been remarkably developed to have 80 times efficiency and more than 100 times life-span since they come out for the first time in the late 1980s, and recently, they keep being rapidly larger such as a 40-inch organic light emitting diode panel.

They are simultaneously required to have improved luminous efficiency and life-span in order to be larger. Therefore, there are needs for developments for a stable and efficient organic material layer material for an organic light emitting diode.

### [DISCLOSURE]

### [Technical Problem]

A composition for an organic optoelectric device being capable of providing an organic light emitting diode having characteristics such as high efficiency, long life-span and the like may be provided.

An organic emission layer, an organic light emitting diode and a display device including the composition for an organic optoelectric device may be provided.

### [Technical Solution]

In one embodiment of the present invention, a composition for an organic light emitting diode including a compound for an organic optoelectric device represented by the following Chemical Formula S-1 and a compound for an organic optoelectric device represented by the following Chemical Formula X-1 is provided.

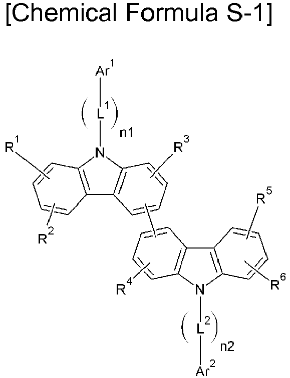

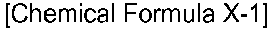

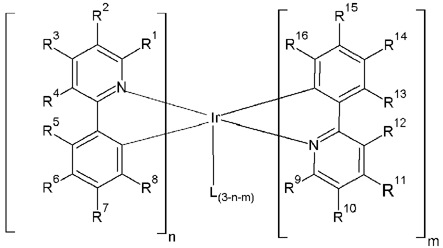

In the above Chemical Formulae S-1 and X-1, each substituent is the same as in the following "the detailed description of the present invention."

### [Advantageous Effects]

The organic optoelectric device including the composition for an organic optoelectric device has excellent electrochemical and thermal stability and life-span characteristics, and high luminous efficiency at a low driving voltage.

### [Description of the Drawings]

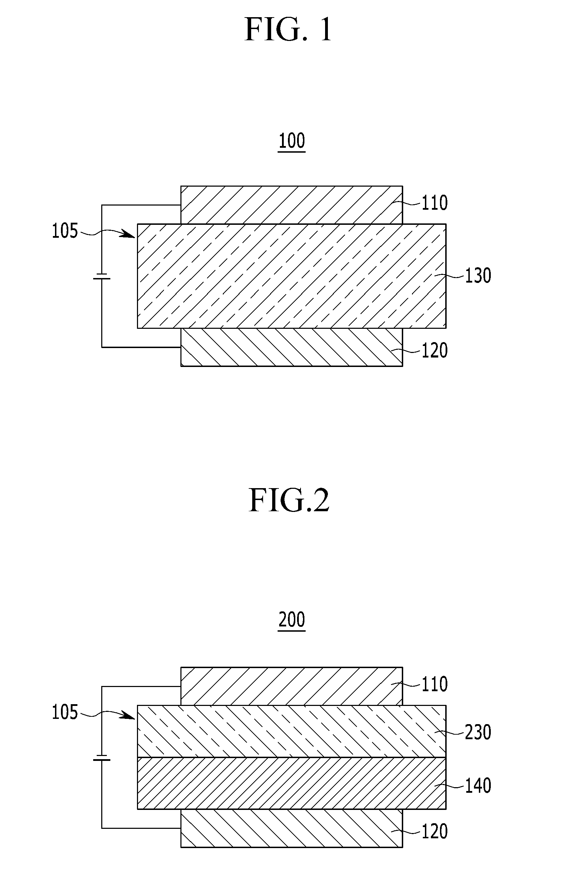

FIGS. 1 and 2 are cross-sectional views showing organic light emitting diodes according to various embodiments of the present invention including the compounds for an organic optoelectric device according to one embodiment of the present invention.

### [Mode for Invention]

Hereinafter, embodiments of the present invention are described in detail. However, these embodiments are exemplary, and the present invention is not limited thereto and is limited by the claims.

In the present specification, when a definition is not otherwise provided, "substituted" refers to one substituted with deuterium, a halogen, hydroxy group, an amino group, a substituted or unsubstituted C1 to C30 amine group, a nitro group, a substituted or unsubstituted C3 to C40 silyl group, a C1 to C30 alkyl group, a C1 to C10 alkylsilyl group, a C3 to C30 cycloalkyl group, a C6 to C30 aryl group, a C1 to C20 alkoxy group, a fluoro group, a C1 to C10 trifluoroalkyl group such as a trifluoromethyl group and the like, or a cyano group, instead of at least one hydrogen of a substituent or a compound.

The two adjacent substituents of the substituted halogen, hydroxy group, an amino group, a substituted or unsubstituted C1 to C20 amine group, a nitro group, a substituted or unsubstituted C3 to C40 silyl group, C1 to C30 alkyl group, C1 to C10 alkylsilyl group, C3 to C30 cycloalkyl group, C6 to C30 aryl group, C1 to C20 alkoxy group, fluoro group, C1 to C10 trifluoroalkyl group such as trifluoromethyl group and the like, or cyano group may be fused to form a ring.

In the present specification, when specific definition is not otherwise provided, "hetero" refers to one including 1 to 3 hetero atoms selected from the group consisting of N, O, S, and P, and remaining carbons in one functional group.

In the present specification, when a definition is not otherwise provided, "alkyl group" refers to an aliphatic hydrocarbon group.

The alkyl group may be a C1 to C20 alkyl group. More specifically, the alkyl group may be a C1 to C10 alkyl group or a C1 to C6 alkyl group. For example, a C1 to C4 alkyl group may have 1 to 4 carbon atoms in alkyl chain which may be selected from the group consisting of methyl, ethyl, propyl, isopropyl, n-butyl, iso-butyl, sec-butyl, and t-butyl.

Specific examples of the alkyl group may be a methyl group, an ethyl group, a propyl group, an isopropyl group, a butyl group, an isobutyl group, a t-butyl group, a pentyl group, a hexyl group, an ethenyl group, a propenyl group, a butenyl group, a cyclopropyl group, a cyclobutyl group, a cyclopentyl group, a cyclohexyl group, and the like.

"Aryl group" refers to a cyclic functional group where all elements have p-orbitals, and these p-orbitals forms conjugation and includes monocyclic or fused ring polycyclic (i.e., rings sharing adjacent pairs of carbon atoms) groups.

"Heteroaryl group" refers to aryl group including 1 to 3 hetero atoms selected from the group consisting of N, O, S, and P, and remaining carbons. When the heteroaryl group is a fused ring, each ring may include 1 to 3 hetero atoms.

More specifically, the substituted or unsubstituted aryl group and/or a substituted or unsubstituted heteroaryl group may be a substituted or unsubstituted phenyl group, a substituted or unsubstituted naphthyl group, a substituted or unsubstituted anthracenyl group, a substituted or unsubstituted phenanthryl group, a substituted or unsubstituted naphthacenyl group, a substituted or unsubstituted pyrenyl group, a substituted or unsubstituted biphenylyl group, a substituted or unsubstituted p-terphenyl group, a substituted or unsubstituted m-terphenyl group, a substituted or unsubstituted chrysenyl group, a substituted or unsubstituted triphenylenyl group, a substituted or unsubstituted perylenyl group, a substituted or unsubstituted indenyl group, a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, or a combination thereof, but is not limited thereto.

In the present specification, hole characteristics refer to characteristics that holes formed in the anode is easily injected into the emission layer and transported in the emission layer due to conductive characteristics according to HOMO level. More specifically, it is similar to electron-repelling characteristics.

Electron characteristics refer to characteristics that electron formed in the cathode is easily injected into the emission layer and transported in the emission layer due to conductive characteristics according to LUMO level. More specifically, it is similar to electron-withdrawing characteristics.

According to one embodiment of the present invention, provided is a composition for an organic light emitting diode including a compound for an organic optoelectric device represented by the following Chemical Formula S-1; and a compound for an organic optoelectric device represented by the following Chemical Formula X-1.

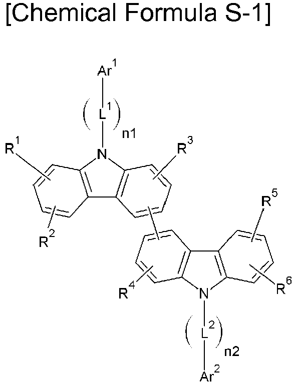

In the above Chemical Formula S-1, Ar¹ and Ar² are independently, a substituted or unsubstituted C6 to C30 aryl group or a substituted or unsubstituted C2 to C30 heteroaryl group.

At least one of the Ar¹ or Ar² may be a substituted or unsubstituted C2 to C30 heteroaryl group having electron characteristics.

The L¹ and L² may be independently, a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof.

The n1 and n2 may be independently integers of 1 to 3.

The R¹ to R⁶ may be independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

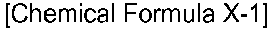

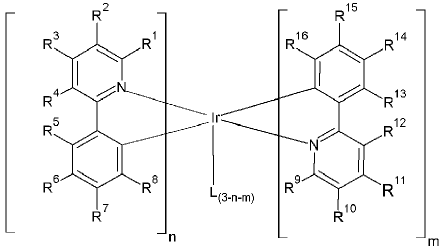

In the above Chemical Formula X-1, R¹ to R¹⁶ are independently hydrogen, deuterium, a substituted or unsubstituted C1 to C10 alkyl group, a substituted or unsubstituted C6 to C20 aryl group, or -SiR¹⁷R¹⁸R¹⁹, wherein the R¹⁷ to R¹⁹ are independently a C1 to C6 alkyl group, one of the R¹ to R⁸ is a functional group represented by the following Chemical Formula X-2, one of the R⁹ to R¹⁶ is a functional group represented by the following Chemical Formula X-2, L is a bidentate ligand of a monovalent anion, and is a ligand coordination-bonding with iridium through unshared electron pair of carbon or heteroatom, and n and m are independently integers of 0 to 3, and n + m is one of integers of 1 to 3,

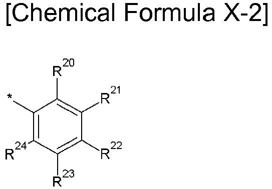

In the above Chemical Formula X-2, R²⁰ to R²⁴ are independently hydrogen, deuterium, a substituted or unsubstituted C1 to C10 alkyl group, a substituted or unsubstituted C6 to C20 aryl group, or -SiR¹⁷R¹⁸R¹⁹, * is a portion where it linked to a carbon atom, in the above Chemical Formulae X-1 and X-2, one of the R¹ to R¹⁶ and R²⁰ to R²⁴ is -SiR¹⁷R¹⁸R¹⁹ or a tert-butyl group.

The compound for an organic optoelectric device represented by the above Chemical Formula X-1 necessarily has a substituted or unsubstituted phenyl group represented by the above Chemical Formula X-2 in a main ligand having a 2-phenylpyridine backbone and in addition, necessarily -SiR¹⁷R¹⁸R¹⁹ or a tert-butyl group. The main ligand is marked as a bonding number of n or m among the ligands combined with iridium through a coordination bond.

Herein, the compound for an organic optoelectric device represented by the above Chemical Formula X-1 may have excellent heat resistance stability and life-span characteristics and high luminous efficiency at a low driving voltage.

An organic optoelectric device manufactured by using a phosphorescent material has a drawbak of sharply decreased efficiency at a high current density by an extinction phenomenon due to saturation of a triplet exited state. This drawback may be overcome by introducing a very bulky substitutent into a luminous material or making the luminous material have a branch having a dendrimer structure to prevent the triplet-triplet extinction phenomenon. A dopant as the luminous material according to one embodiment of the present invention also has decreased interactions among molecules due to introduction of -SiR¹⁷R¹⁸R¹⁹ or a stert-butyl group and a phenyl group having a large steric hindrance and thus, prevents the triplet-triplet extinction phenomenon and resulantly, may realize excellent life-span and luminous efficiency.

In addition, the introduction of a bulky substitutent may have an effect on decreasing a deposition temperature due to decreased interactions among the molecules.

More specifically, in the above Chemical Formula X-1, one main ligand may have one -SiR¹⁷R¹⁸R¹⁹, or one tert-butyl group.

For example, in the above Chemical Formula X-1, n may be an integers of 1 to 3, one of the R¹ to R⁴ may be -SiR¹⁷R¹⁸R¹⁹ or a tert-butyl group, and the rest of the R¹ to R⁴ may be independently hydrogen, deuterium, or a substituted or unsubstituted C1 to C10 alkyl group. At the same time, one of the R⁵ to R⁸ may be the functional group represented by the above Chemical Formula X-2, and the rest of the R⁵ to R⁸ may be independently hydrogen, deuterium, or a substituted or unsubstituted C1 to C10 alkyl group. In this case, the compound for an organic optoelectric device may realize excellent heat resistance stability, life-span characteristics and luminous efficiency. A ligand may have an overall three dimensional shape by introducing a bulky substituent such as the - SiR¹⁷R¹⁸R¹⁹ or the tert-butyl group and the phenyl group thereinto, and accordingly, a dopant as a luminous material also has a bulky three dimensional structure and suppresses interactions among the molecules and thus, realizes a device having excellent life-span characteristics and luminous efficiency.

For specific examples, in the above Chemical Formula X-1, n may be an integer of 1 to 3 R² may be -SiR¹⁷R¹⁸R¹⁹ or a tert-butyl group, R⁶ may be a phenyl group, and R¹, R³ to R⁵, R⁷ and R⁸ may be independently hydrogen, deuterium, or a substituted or unsubstituted C1 to C10 alkyl group. In this case, the compound for an organic optoelectric device may have excellent heat resistance stability, life-span characteristic and luminous efficiency.

Specifically, when a phenyl group is substituted at the R⁶ position, the phenyl group may not change color purity of green luminescence but increases entire volume of molecules and minimizes interactions among the molecules and thus, realize a light emitting device having high efficiency and a long life-span.

For another example, in the above Chemical Formula X-1, n may be an integer of 1 to 3, one of the R¹ to R⁴ may be the functional group represented by the above Chemical Formula X-2, another of R¹ to R⁴ may be -SiR¹⁷R¹⁸R¹⁹ or a tert-butyl group, and the rest of the R¹ to R⁴ and R⁵ to R⁸ may be independently hydrogen, deuterium, or a substituted or unsubstituted C1 to C10 alkyl group. Herein, the -SiR¹⁷R¹⁸R¹⁹ or tert-butyl group and the functional group represented by Chemical Formula X-2 may be bonded at an ortho, meta, or para position.

For specific examples, in the above Chemical Formula X-1, n may be an integer of 1 to 3, R² may be a phenyl group, R³ may be -SiR¹⁷R¹⁸R¹⁹ or a tert-butyl group, and R¹, R⁴ to R⁸ are independently hydrogen, deuterium, or a substituted or unsubstituted C1 to C10 alkyl group. In this case, the compound for an organic optoelectric device may have excellent heat resistance stability, life-span characteristics, and luminous efficiency.

For another example, in the above Chemical Formula X-1, n may be an integer of 1 to 3, one of the R¹ to R⁴ may be -SiR¹⁷R¹⁸R¹⁹ or a tert-butyl group, and the rest of the R¹ to R⁴ may be independently hydrogen, deuterium, or a substituted or unsubstituted C1 to C10 alkyl group. At the same time, one of the R⁵ to R⁸ may be the functional group represented by the above Chemical Formula X-2, and the rest of the R⁵ to R⁸ may be independently hydrogen, deuterium, or a substituted or unsubstituted C1 to C10 alkyl group. At the same time, m may be an integer of 1 to 3, one of the R⁹ to R¹² may be the functional group represented by the above Chemical Formula X-2, another of R⁹ to R¹² may be -SiR¹⁷R¹⁸R¹⁹ or a tert-butyl group, and the rest of the R⁹ to R¹² and R¹³ to R¹⁶ are independently hydrogen, deuterium, or a substituted or unsubstituted C1 to C10 alkyl group.

Herein, the -SiR¹⁷R¹⁸R¹⁹ or tert-butyl group and the functional group represented by Chemical Formula X-2 may be bonded at an ortho, meta, or para position.

For another example, in the above Chemical Formula X-1, the main ligand may have a phenyl group substituted with the -SiR¹⁷R¹⁸R¹⁹ or the tert-butyl group. That is to say, in the above Chemical Formula X-1, one of the R¹ to R⁸ may be a functional group represented by the following Chemical Formula X-2, one of the R⁹ to R¹⁶ may be a functional group represented by the following Chemical Formula X-2, and in the above Chemical Formula X-2, one of the R²⁰ to R²⁴ may be -SiR¹⁷R¹⁸R¹⁹ or a tert-butyl group, and the rest of the R¹ to R¹⁶ that is unsubstituted with the functional group represented by the above Chemical Formula X-2 may be independently hydrogen, deuterium, or a substituted or unsubstituted C1 to C10 alkyl group. Herein, the compound for an organic optoelectric device is suppressed from interactions among molecules due to introduction of the -SiR¹⁷R¹⁸R¹⁹ or the tert-butyl group as a bulky substitutent and may realize excellent heat resistance stability, life-span characteristics and luminous efficiency and also, lower a deposition temperature.

Specifically, when the -SiR¹⁷R¹⁸R¹⁹ or tert-butyl group is substituted at the R²² in Chemical Formula X-2, the -SiR¹⁷R¹⁸R¹⁹ or tert-butyl group has an effect on increasing the entire volume of molecules and thus, minimizing interactions among the molecules.

In the above Chemical Formula X-1, n may be an integer of 1 to 3, at least one of the R¹ to R⁸ may be a substituted or unsubstituted C1 to C20 alkyl group, and specifically an unsubstituted C1 to C10 alkyl group. In this case, thermal stability may be improved.

In the -SiR¹⁷R¹⁸R¹⁹, the R¹⁷ to R¹⁹ may be independently a methyl group. That is to say, the -SiR¹⁷R¹⁸R¹⁹ may be a trimethylsilyl group. In this case, the compound for an organic optoelectric device may realize excellent heat resistance stability, life-span characteristics and luminous efficiency.

In the above Chemical Formula X-1, n + m may be 3. In addition, in the above Chemical Formula X-1, n or m may be 3. This means that the ligand represented by L is not included in the Chemical Formula X-1. In this case, its synthesis may become easier and the compound may be stabilized. Accordingly, it may be applied to provide a light emitting device having excellent life-span characteristics.

In addition, in the above Chemical Formula X-1, n + m may be 1 or 2. This means that at least one ligand represented by L is included in Chemical Formula X-1. In this case, a color of the compound may be tuned.

In the above Chemical Formula X-1, L may be an auxiliary ligand, and may be selected from the following Chemical Formula L-1 to Chemical Formula L-14. However, these are examples of the ligand represented by L, which is not limited thereto.

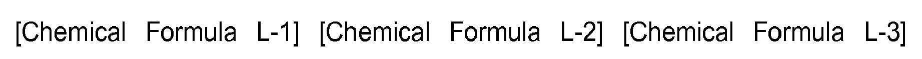

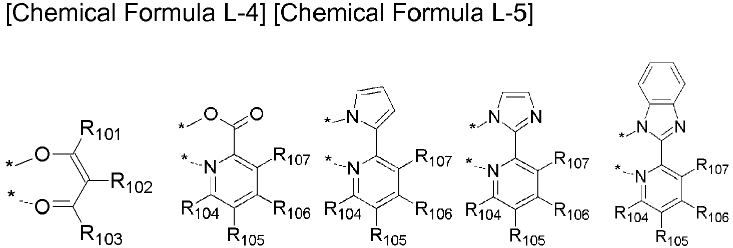

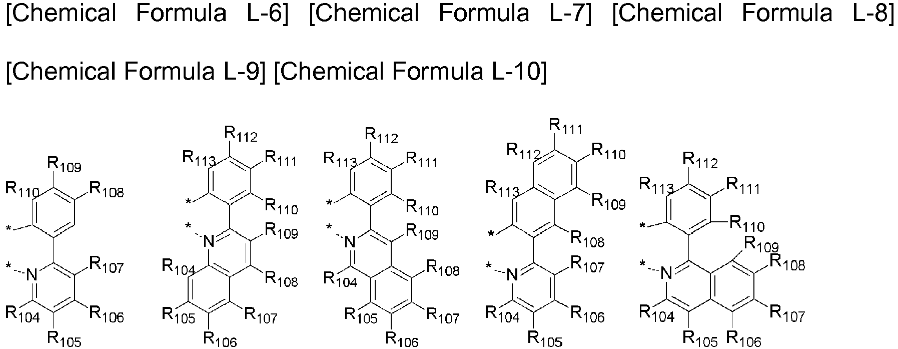

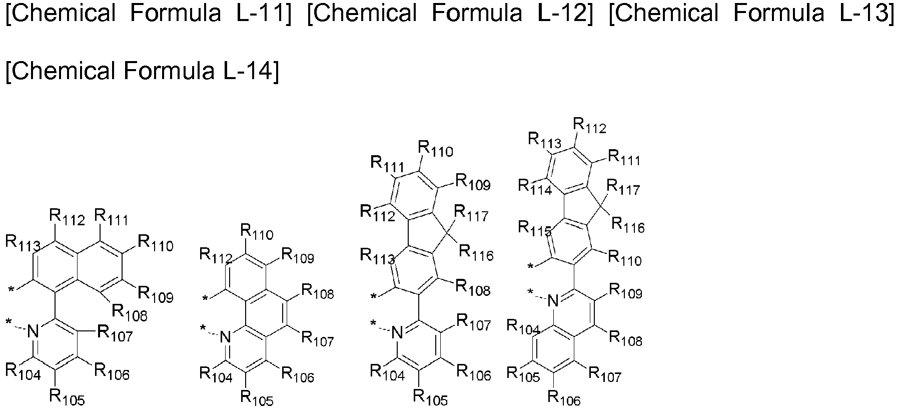

In the above Chemical Formulae L-1 to L-14, the asterisk (*) denotes a position bonding with iridium (Ir), and R₁₀₁ to R₁₀₃ are independently hydrogen, deuterium, a C1 to C30 alkyl group substituted or unsubstituted with a halogen, a C6 to C30 aryl group substituted or unsubstituted with a C1 to C30 alkyl, or a halogen.

R₁₀₄ to R₁₁₅ are independently hydrogen, deuterium, a halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and a C6 to C30 aryl group, or a triarylsilyl group having a substituted or unsubstituted C6 to C30 aryl group.

R₁₁₆ to R₁₁₇ are independently hydrogen, deuterium, a C1 to C30 alkyl group substituted or unsubstituted with a halogen, or a C6 to C30 aryl group substituted or unsubstituted with a C1 to C30 alkyl.

Specific examples of the above Chemical Formula X-1 may be one of the following Chemical Formulae M-1 to M-55, Chemical Formulae P-1 to P-26 and Chemical Formulae Q-1 to Q-11. These have a structure where the main ligand is substituted with one phenyl group and one trimethylsilyl group. However, these are specific examples of Chemical Formula X-1 which is not limited thereto.

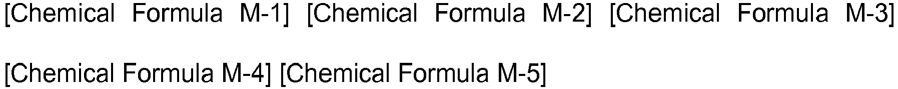

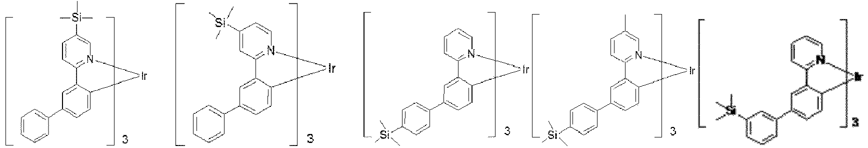

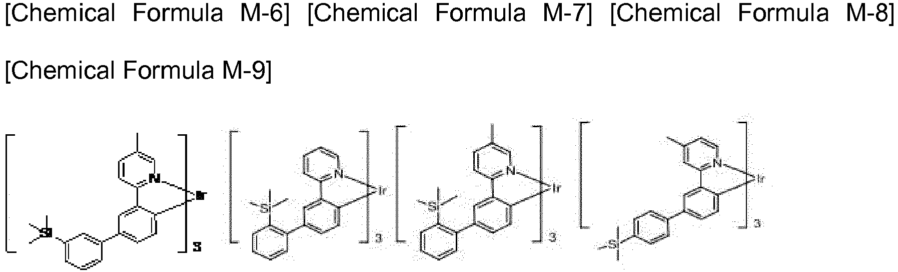

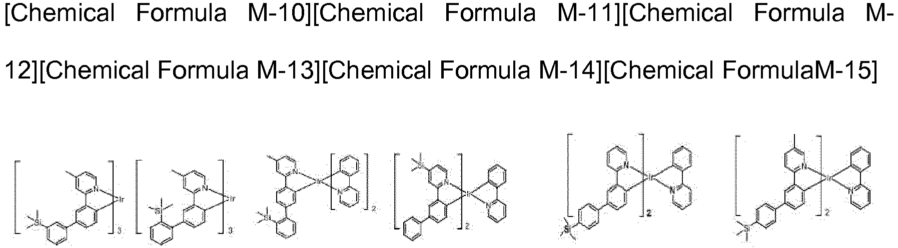

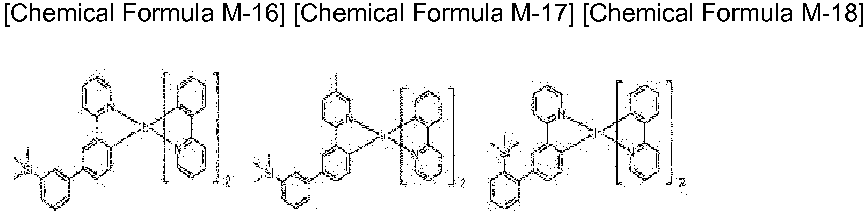

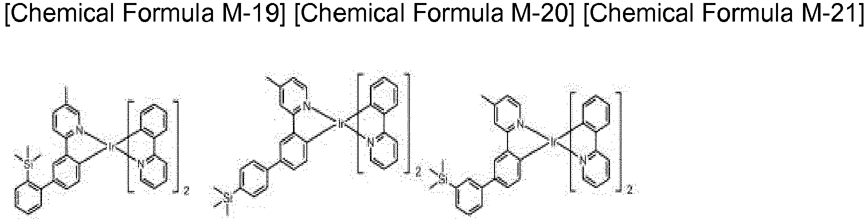

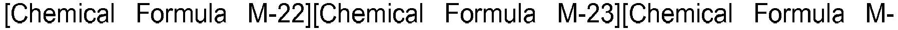

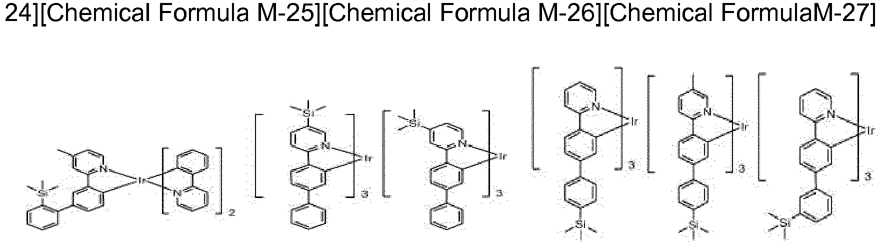

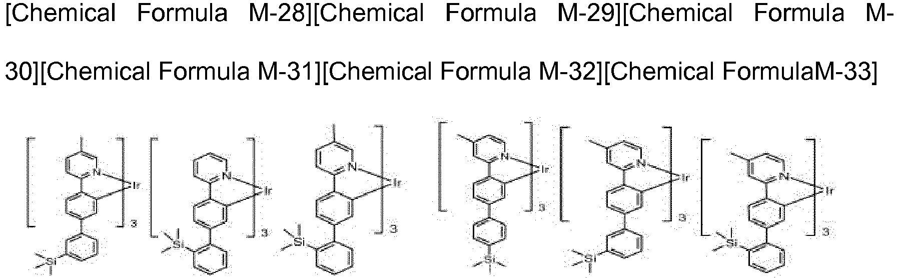

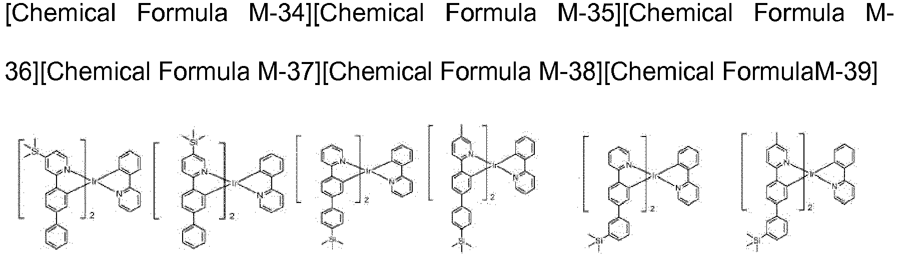

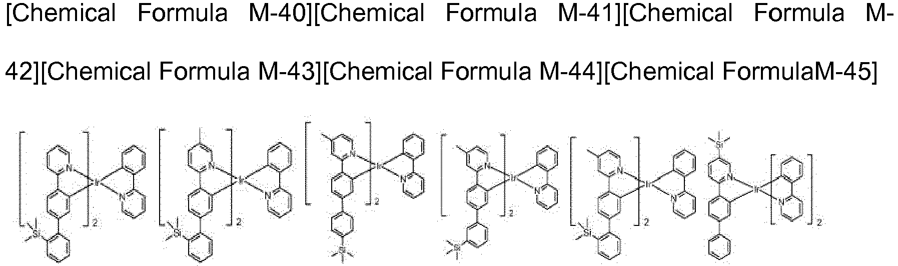

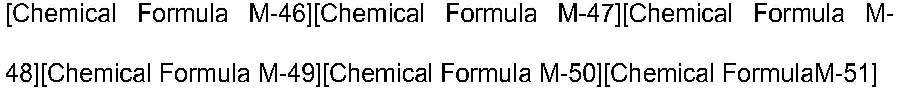

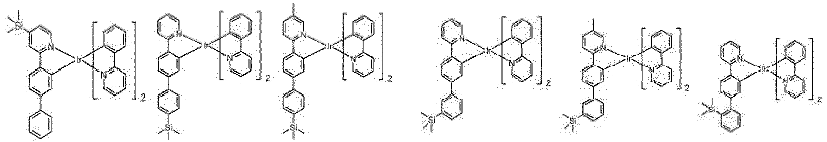

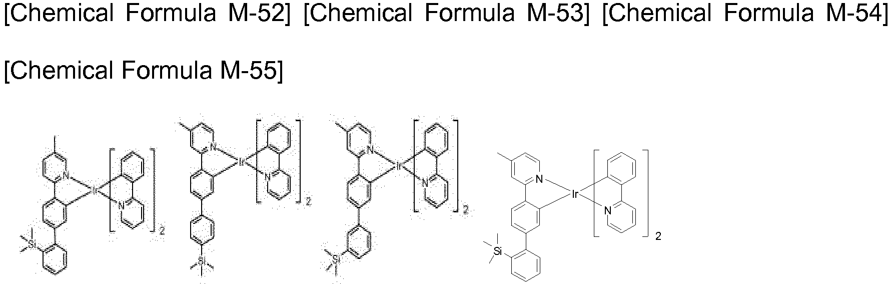

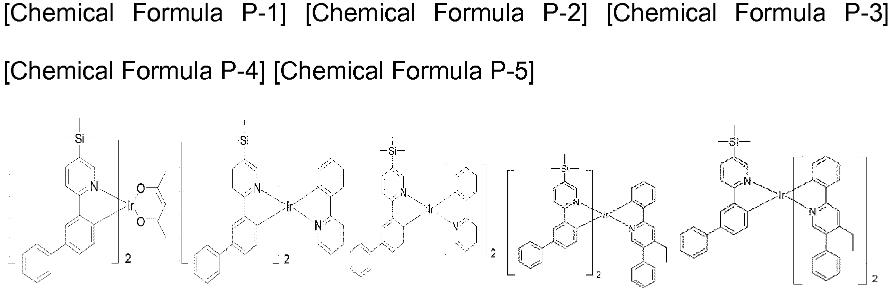

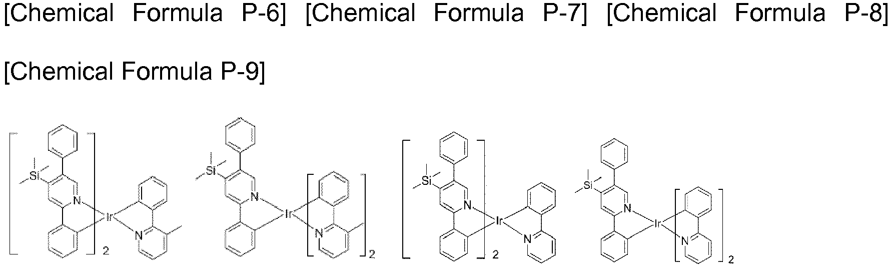

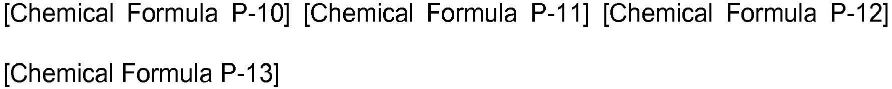

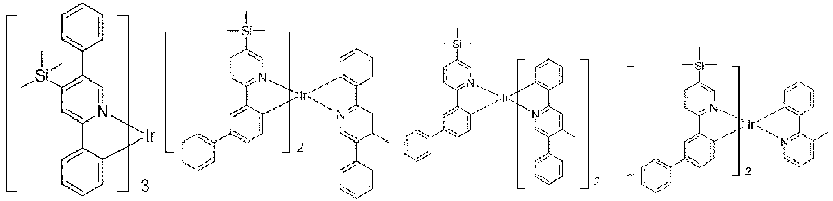

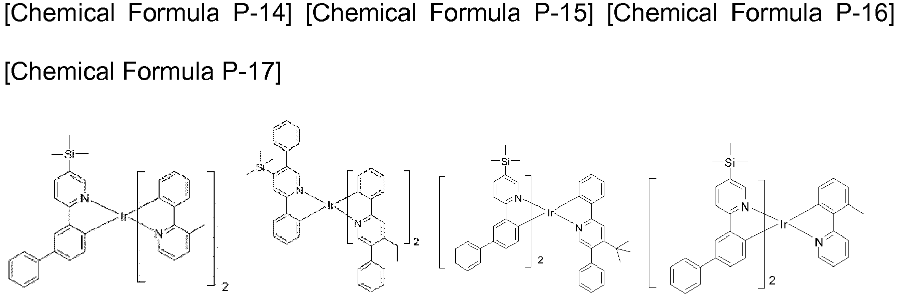

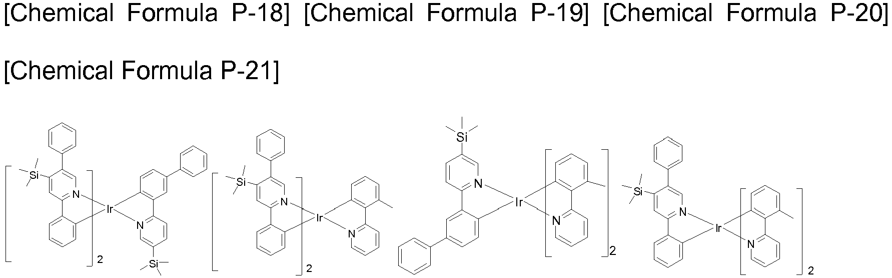

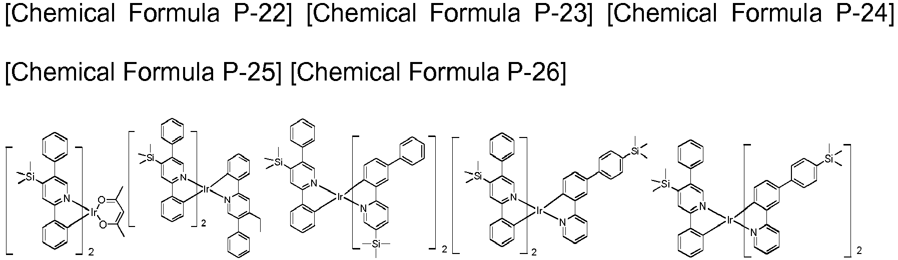

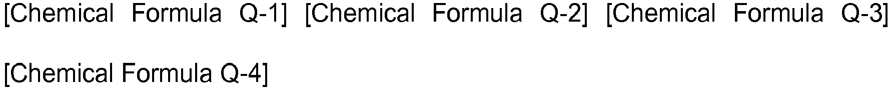

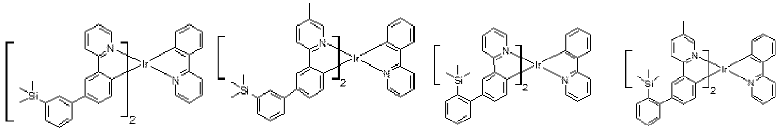

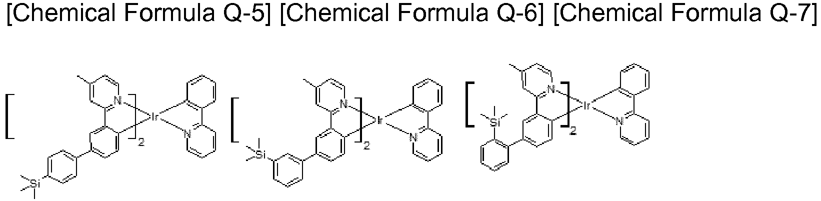

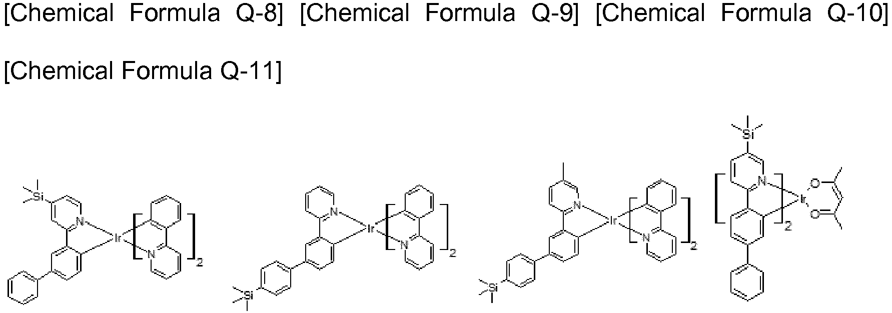

For another example, the above Chemical Formula X-1 may be one of the following Chemical Formulae B-1 to B-65, Chemical Formulae C-1 to C-18, and Chemical Formulae D-1 to D-6. These have a structure where the main ligand is substituted with one phenyl group and one trimethylsilyl group in Chemical Formula X-1. However, these are examples of Chemical Formula X-1 which is not limited thereto.

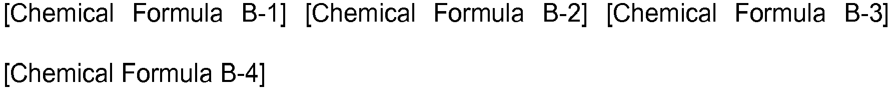

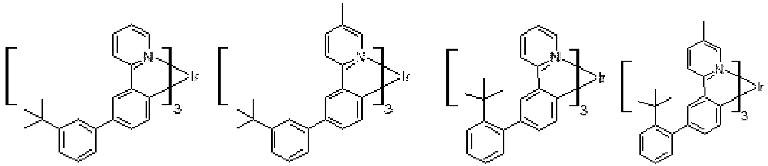

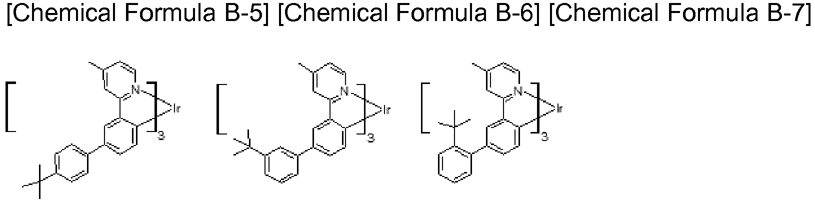

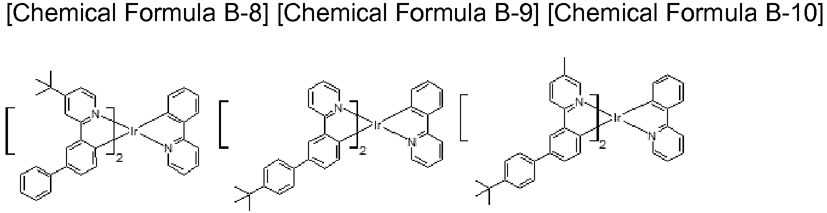

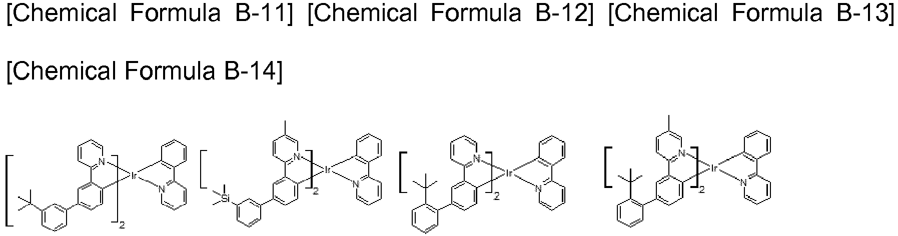

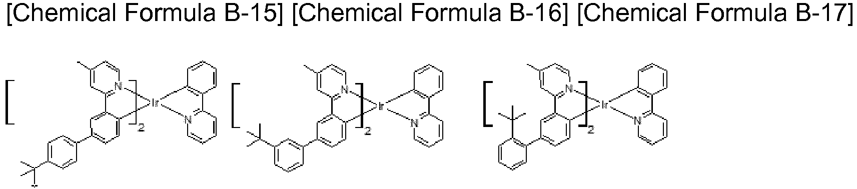

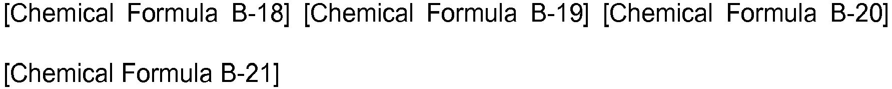

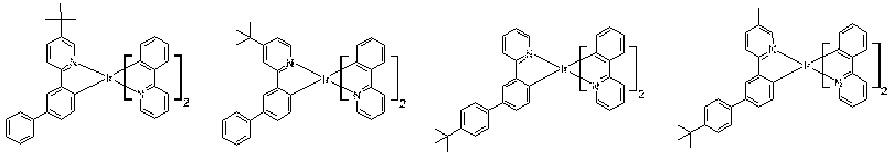

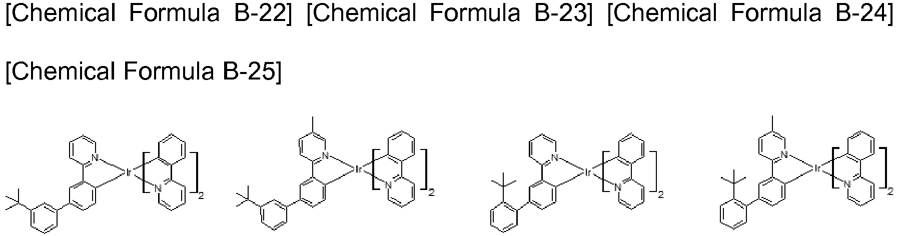

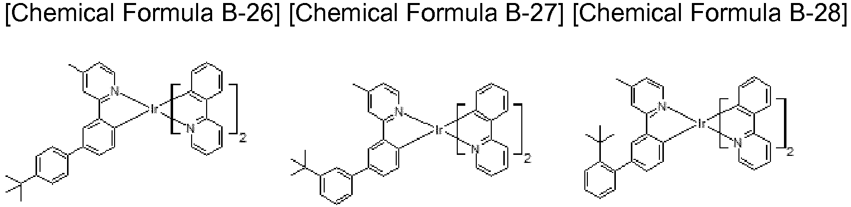

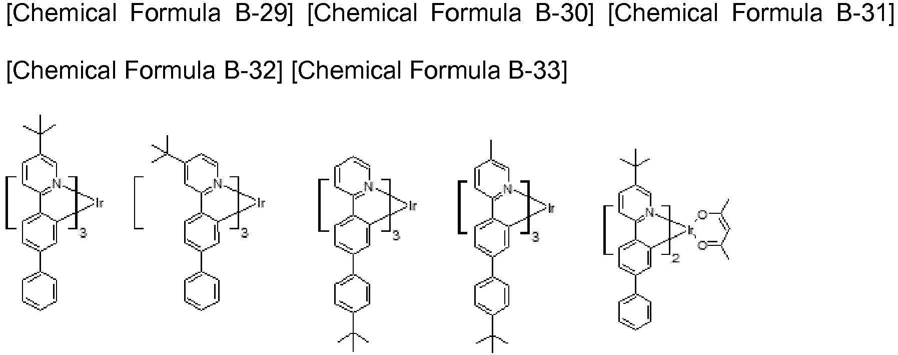

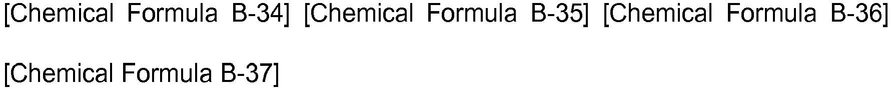

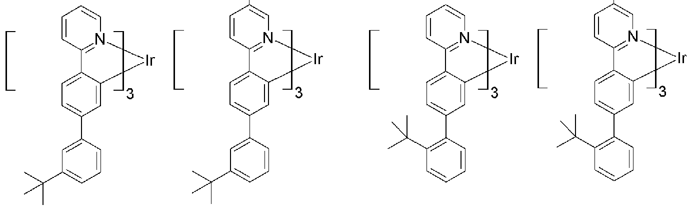

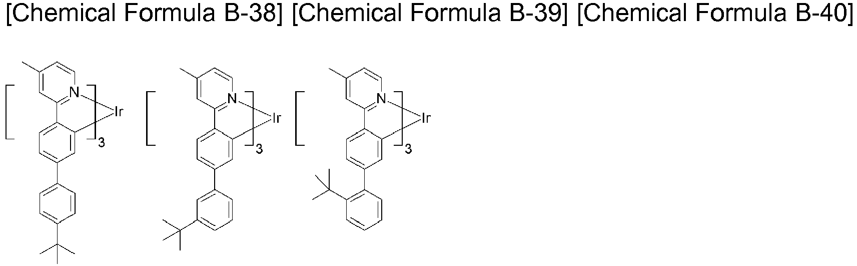

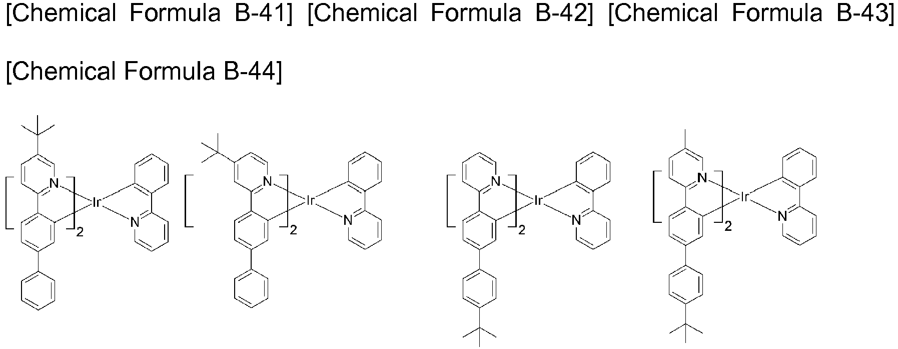

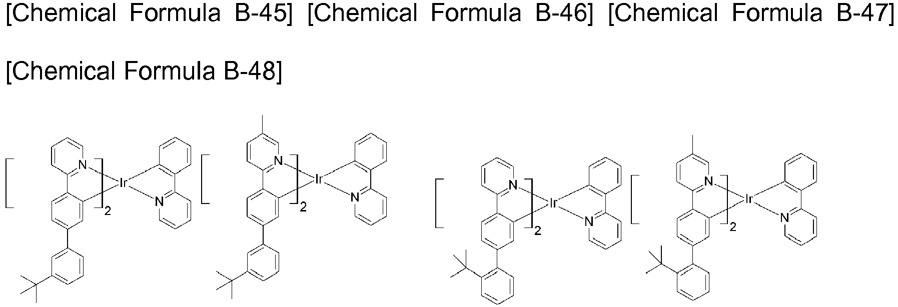

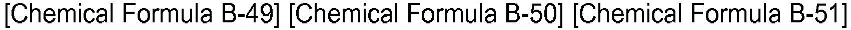

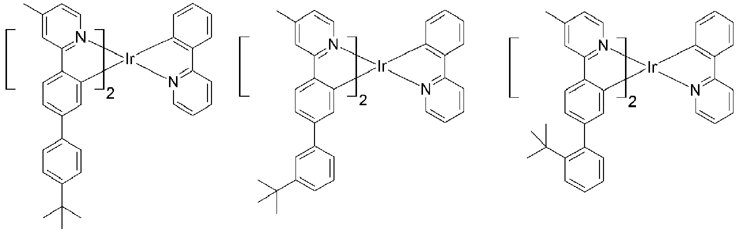

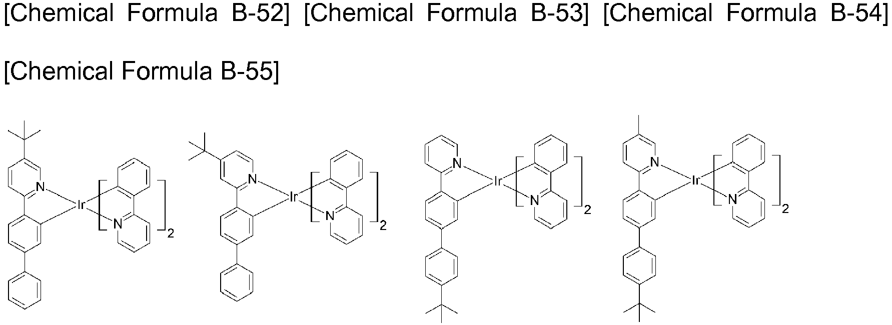

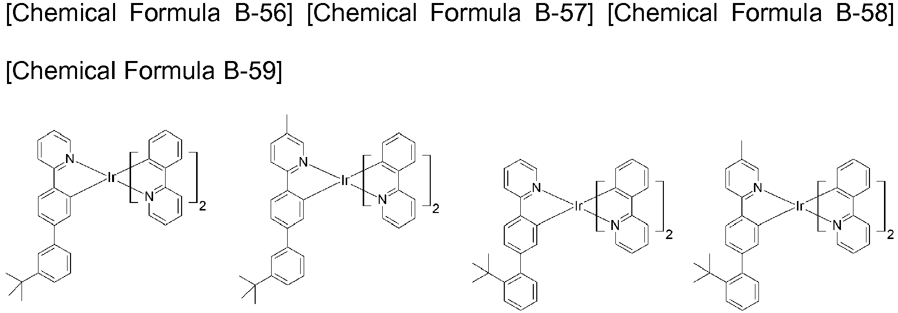

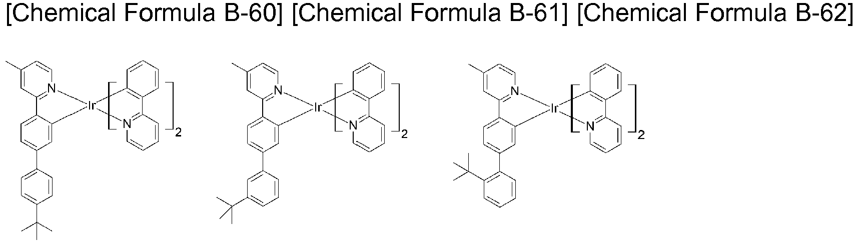

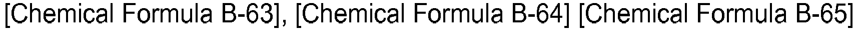

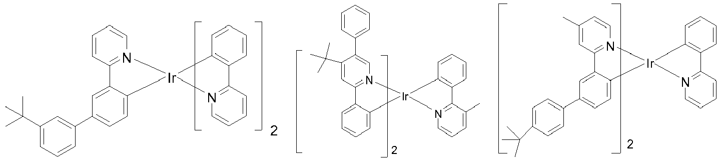

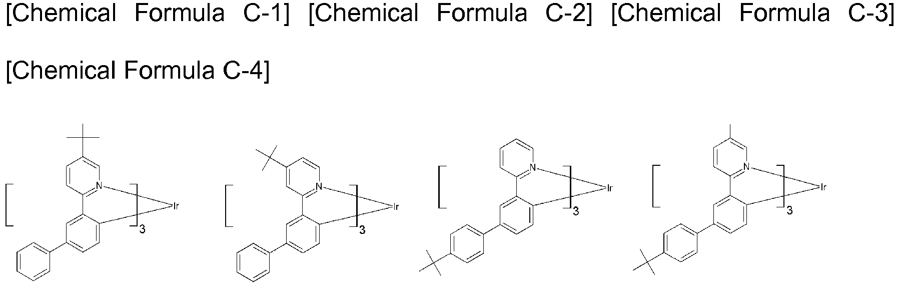

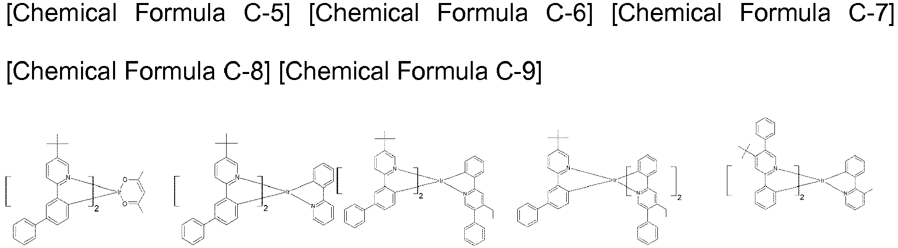

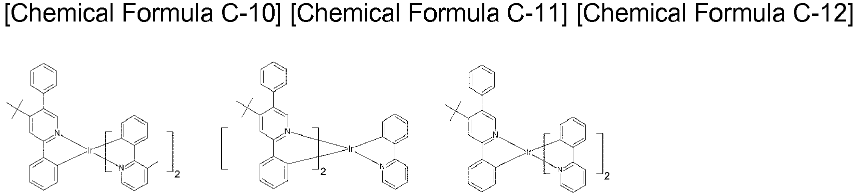

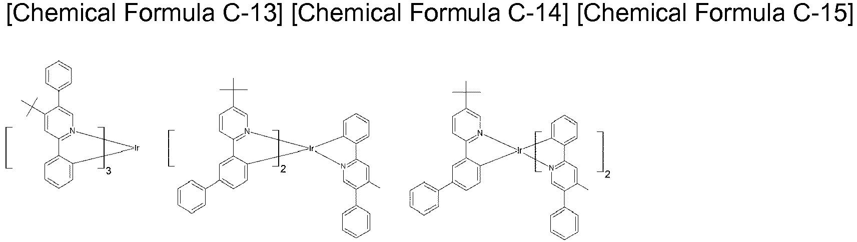

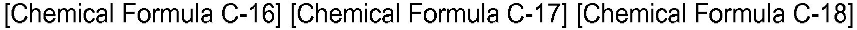

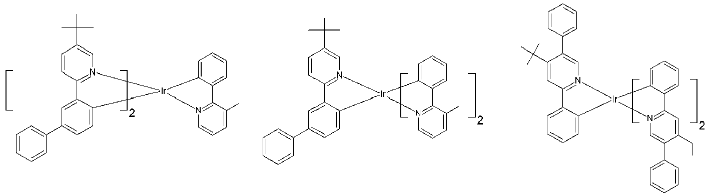

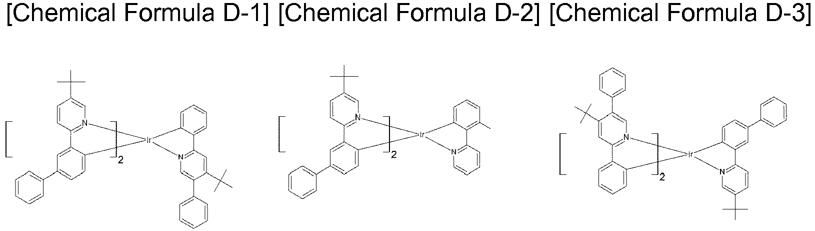

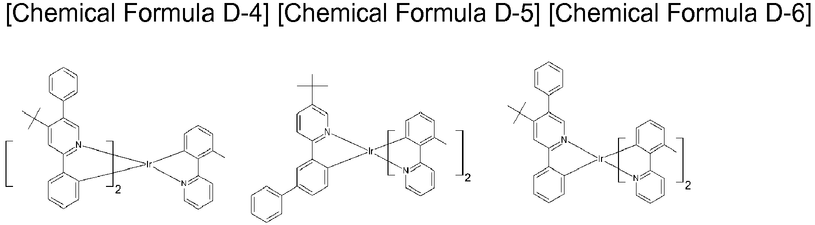

The above Chemical Formula S-1 may be represented by the following Chemical Formula S-2. In this case, the ligand may be advantageous in terms of synthesis and also, stably prepared by substituting the position No. 3 of electrochemically unstable carbazole.

In addition, a bandgap and a triplet energy bandgap may be improved by further non-flattening a molecular structure and limiting a conjugation length.

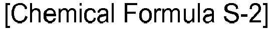

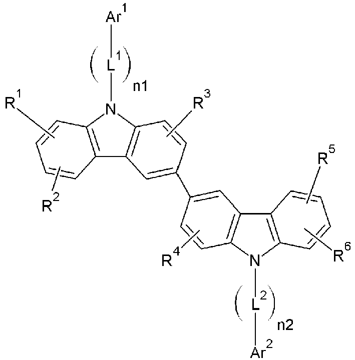

In the above Chemical Formula S-2, Ar¹ and Ar² are independently a substituted or unsubstituted C6 to C30 aryl group or a substituted or unsubstituted C2 to C30 heteroaryl group, at least one of Ar¹ or Ar² is a substituted or unsubstituted C2 to C30 heteroaryl group having electron characteristics, L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 and n2 are independently integers of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The above Chemical Formula S-1 may be represented by the following Chemical Formula S-3. In this case, a bandgap and a triplet energy bandgap may be improved by further non-flattening a molecular structure and limiting a conjugation length.

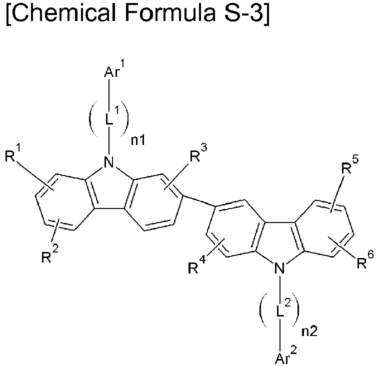

In the above Chemical Formula S-3, Ar¹ and Ar² are independently a substituted or unsubstituted C6 to C30 aryl group or a substituted or unsubstituted C2 to C30 heteroaryl group, at least one of Ar¹ or Ar² is a substituted or unsubstituted C2 to C30 heteroaryl group having electron characteristics, L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 and n2 are independently integers of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The above Chemical Formula S-1 may be represented by the following Chemical Formula S-4. In this case, a bandgap and a triplet energy bandgap may be improved by further non-flattening a molecular structure and limiting a conjugation length.

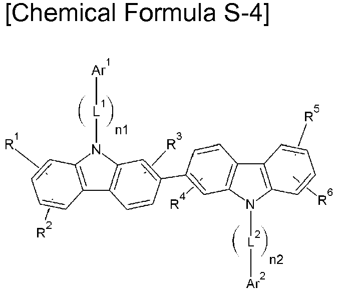

In the above Chemical Formula S-4, Ar¹ and Ar² are independently a substituted or unsubstituted C6 to C30 aryl group or a substituted or unsubstituted C2 to C30 heteroaryl group, at least one of Ar¹ or Ar² is a substituted or unsubstituted C2 to C30 heteroaryl group having electron characteristics, L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 and n2 are independently integers of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The above Chemical Formula S-1 may be represented by the following Chemical Formula S-5. In this case, thermal stability may be increased by introducing a bulky biphenyl substitutent.

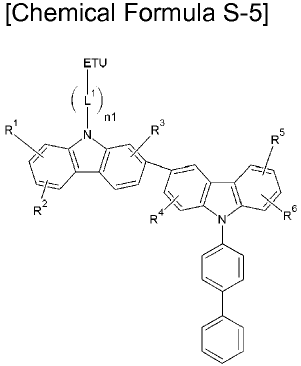

In the above Chemical Formula S-5, ETU is a substituted or unsubstituted C2 to C30 heteroaryl group having electron characteristics, L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 is an integer of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The above Chemical Formula S-1 may be represented by the following Chemical Formula S-6. In this case, luminous efficiency and life-span of a device may be increased, since a kink-shaped bulky biphenyl substitutent suppresses interactions among molecules.

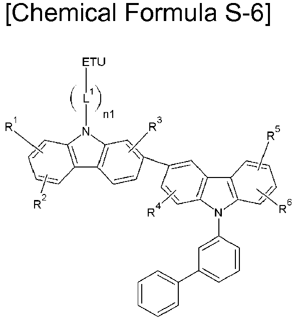

In the above Chemical Formula S-6, ETU is a substituted or unsubstituted C2 to C30 heteroaryl group having electron characteristics, L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 is an integer of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The above Chemical Formula S-1 may be represented by the following Chemical Formula S-7. In this case, the introduction of the methyl substitutent may lower a deposition temperature and thus, a process temperature in a process of manufacturing a device.

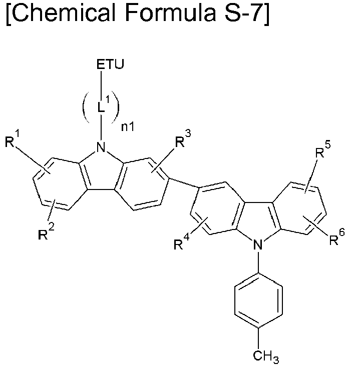

In the above Chemical Formula S-7, ETU is a substituted or unsubstituted C2 to C30 heteroaryl group having electron characteristics, L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof, n1 is an integer of 1 to 3, and R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The substituted or unsubstituted C2 to C30 heteroaryl group having electron characteristics may be selected from the group consisting of a substituted or unsubstituted imidazolyl group, a substituted or unsubstituted triazolyl group, a substituted or unsubstituted tetrazolyl group, a substituted or unsubstituted oxadiazolyl group, a substituted or unsubstituted oxatriazolyl group, a substituted or unsubstituted thiatriazolyl group, a substituted or unsubstituted benzimidazolyl group, a substituted or unsubstituted benzotriazolyl group, a substituted or unsubstituted pyridinyl group, a substituted or unsubstituted pyrimidinyl group, a substituted or unsubstituted triazinyl group, a substituted or unsubstituted pyrazinyl group, a substituted or unsubstituted pyridazinyl group, a substituted or unsubstituted purinyl group, a substituted or unsubstituted quinolinyl group, a substituted or unsubstituted isoquinolinyl group, a substituted or unsubstituted phthalazinyl group, a substituted or unsubstituted benzoquinolinyl group, a substituted or unsubstituted quinoxalinyl group, a substituted or unsubstituted quinazolinyl group, a substituted or unsubstituted acridinyl group, a substituted or unsubstituted phenanthrolinyl group, and a substituted or unsubstituted phenazinyl group, but is not limited thereto.

More specifically, the substituted or unsubstituted C2 to C30 heteroaryl group having electron characteristics may be represented by one of the following Chemical Formulae E-1 to E-5.

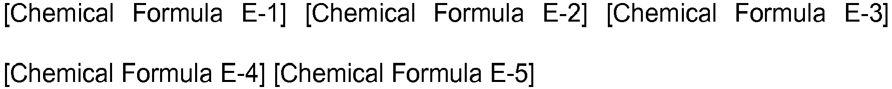

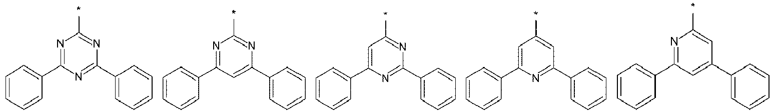

The above Chemical Formula S-1 may be represented by one of the following Chemical Formulae 3 to 54. But, it is not limited thereto.

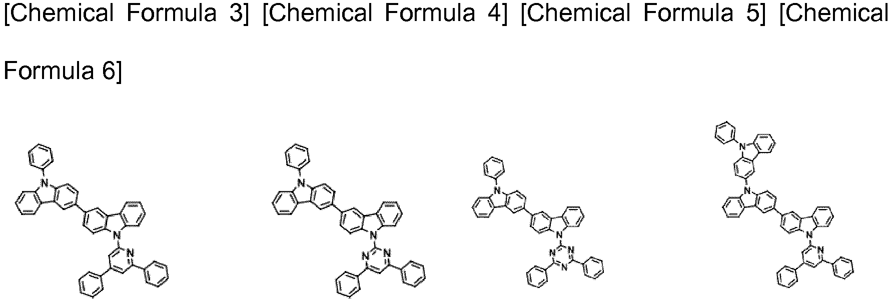

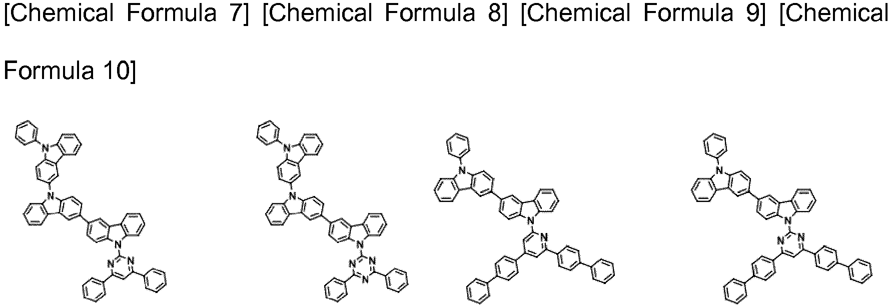

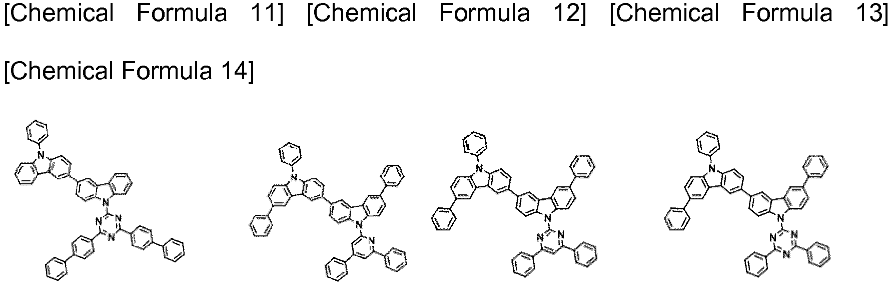

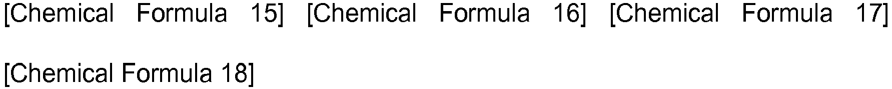

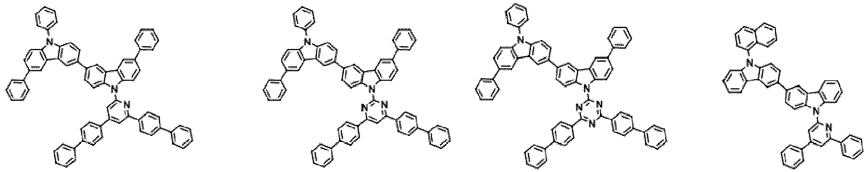

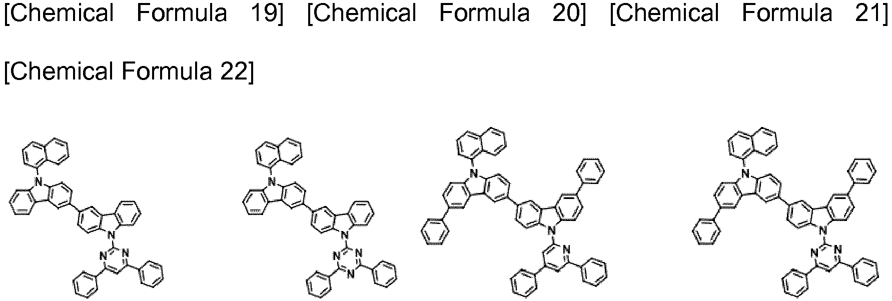

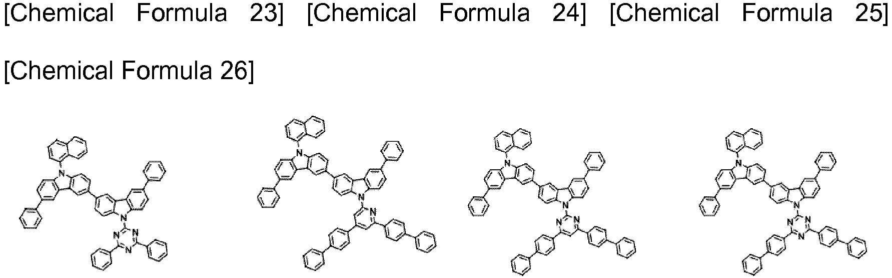

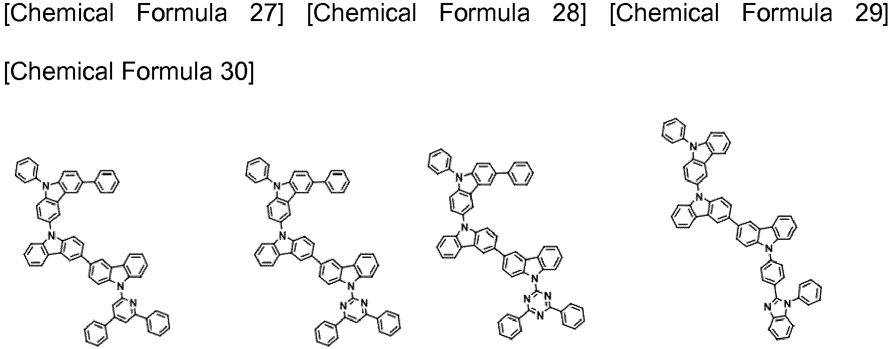

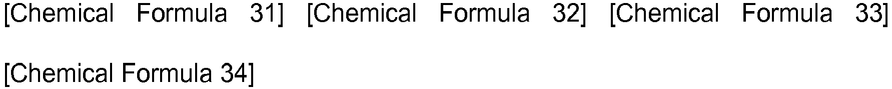

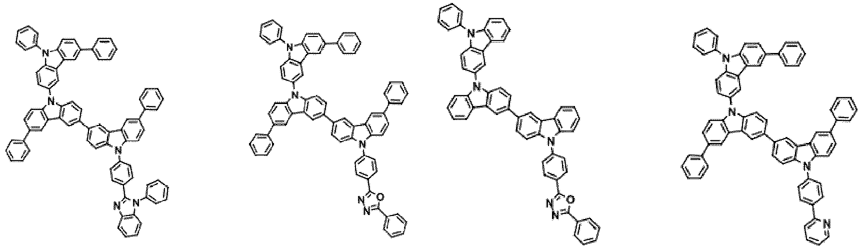

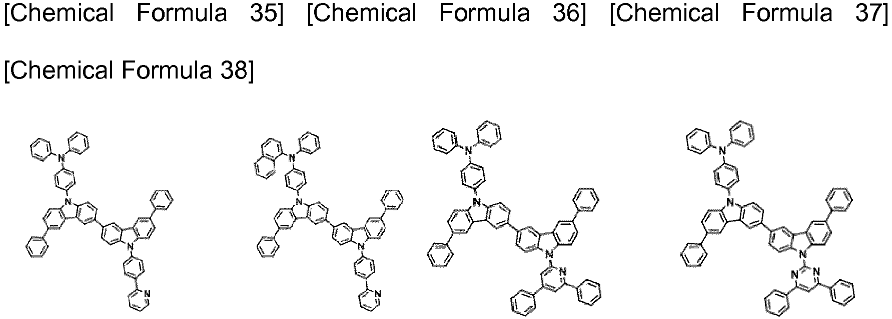

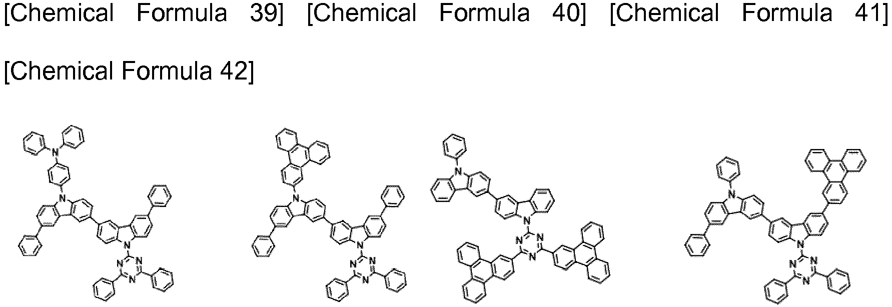

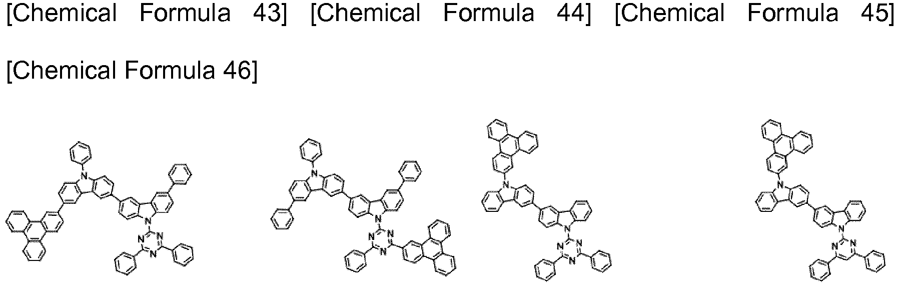

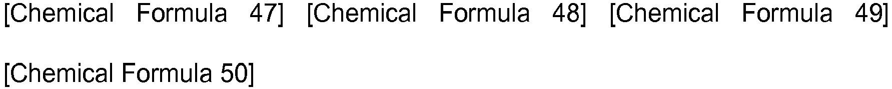

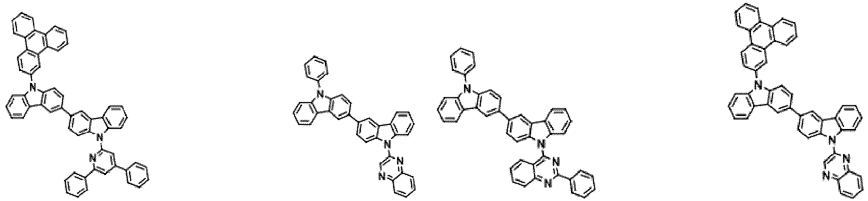

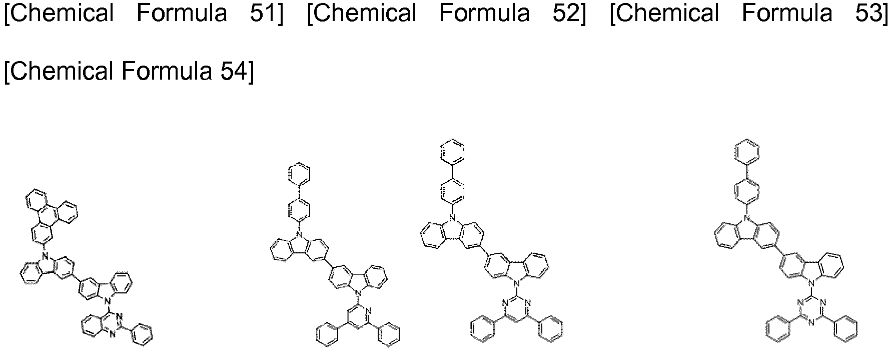

The above Chemical Formula S-1 may be represented by one of the following Chemical Formulae A-2 to A-26. But, it is not limited thereto.

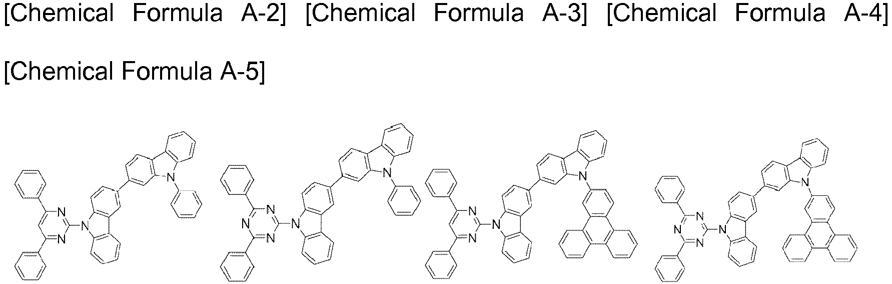

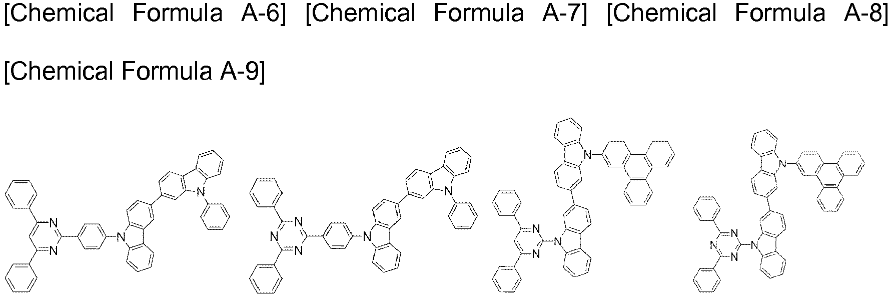

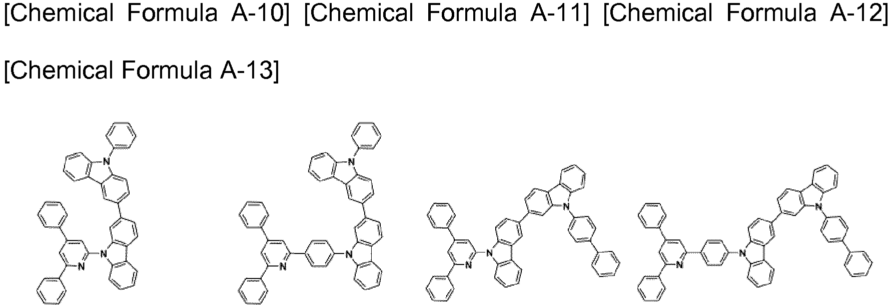

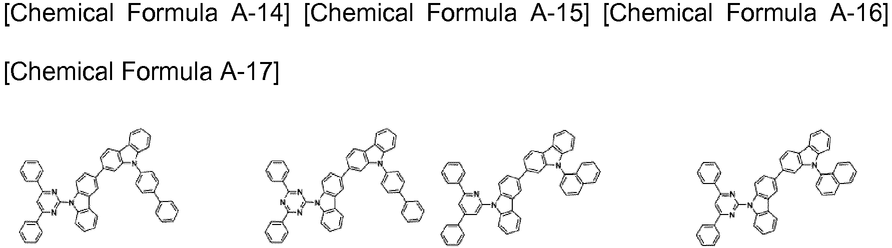

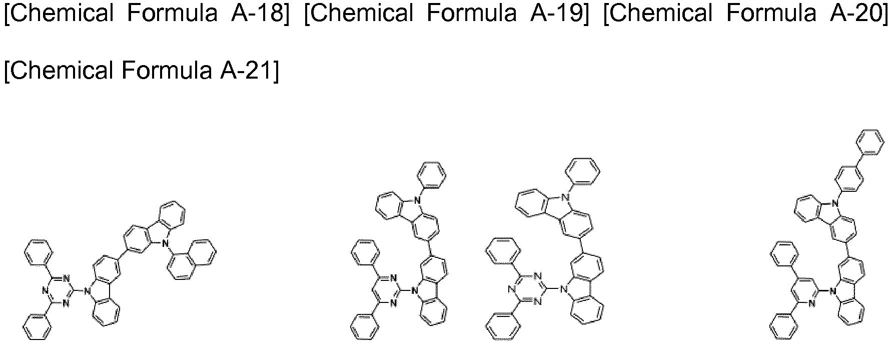

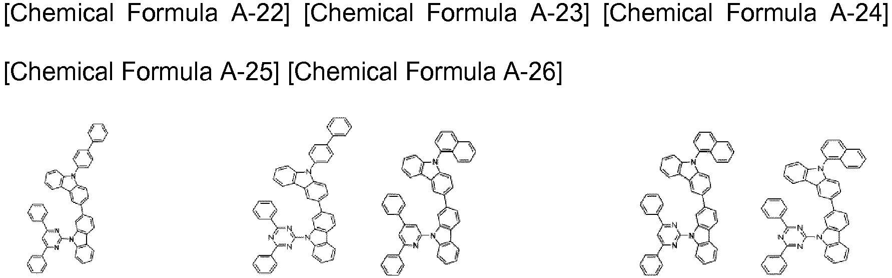

The above Chemical Formula S-1 may be represented by one of the following Chemical Formulae O-1 to 0-18. But, it is not limited thereto.

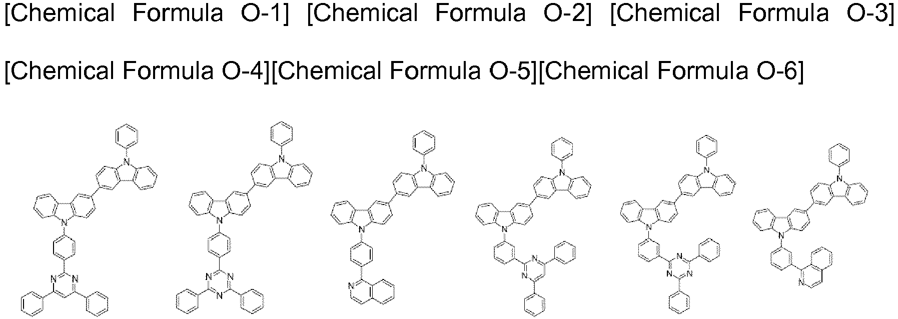

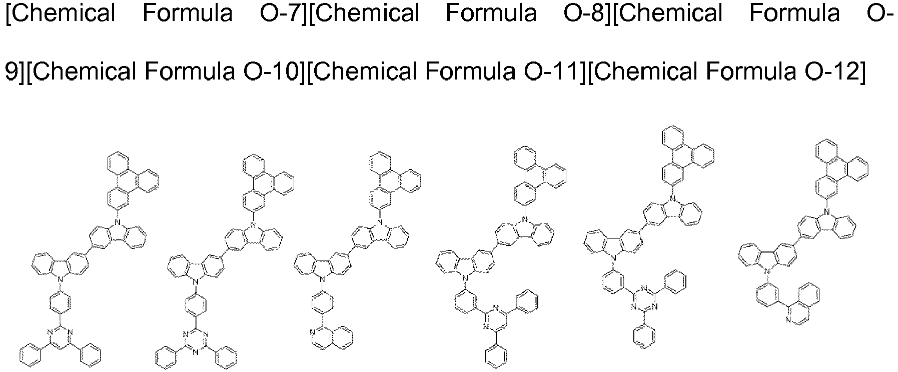

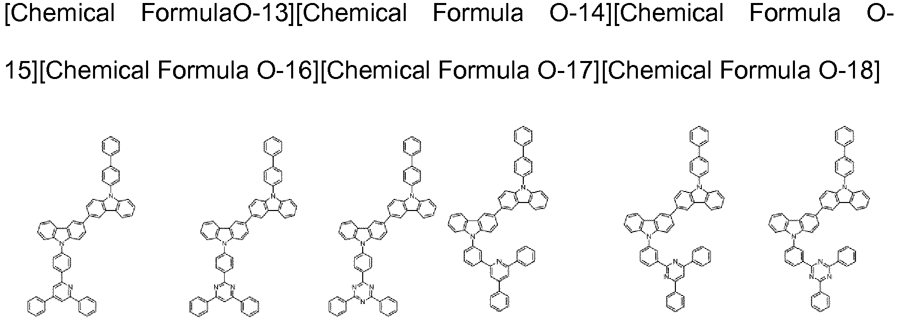

The above Chemical Formula S-1 may be represented by one of the following Chemical Formulae T-1 to T-474. But, it is not limited thereto.

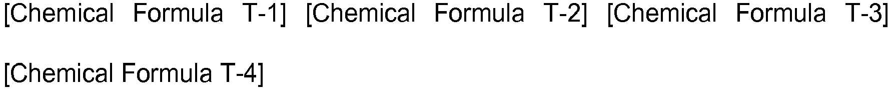

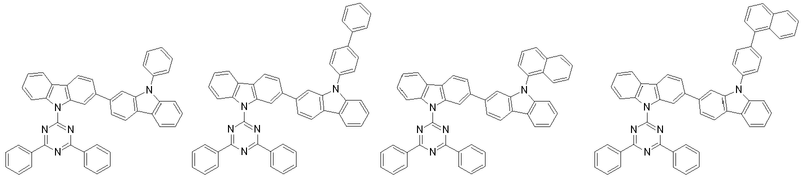

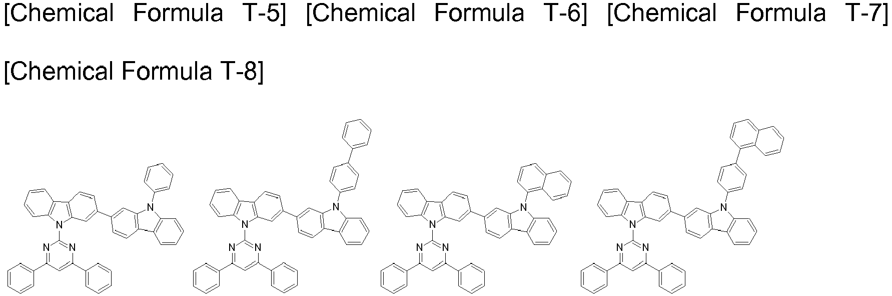

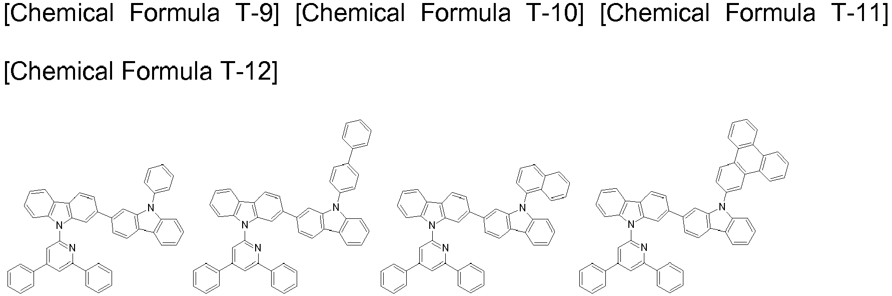

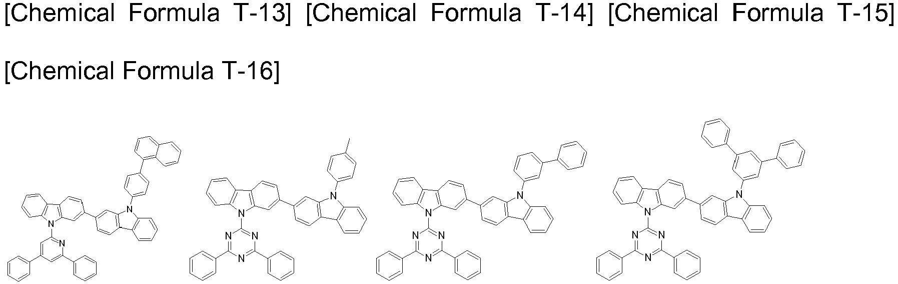

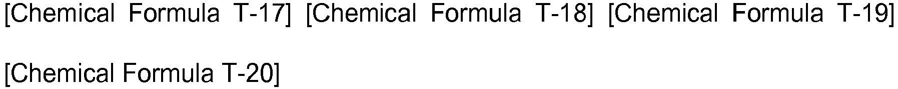

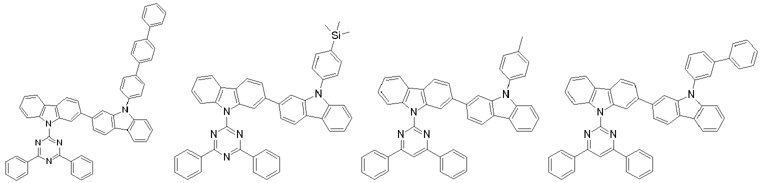

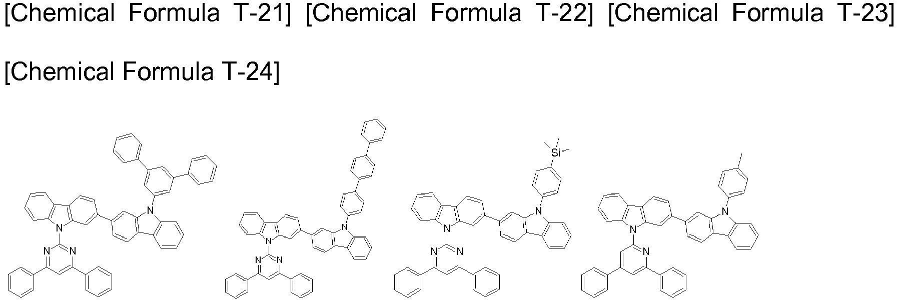

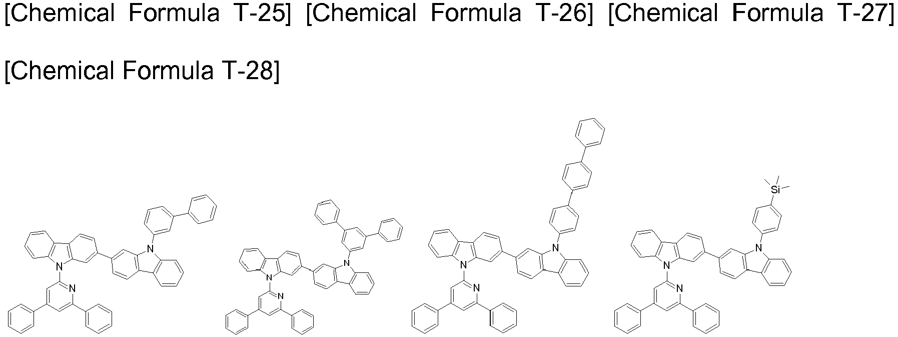

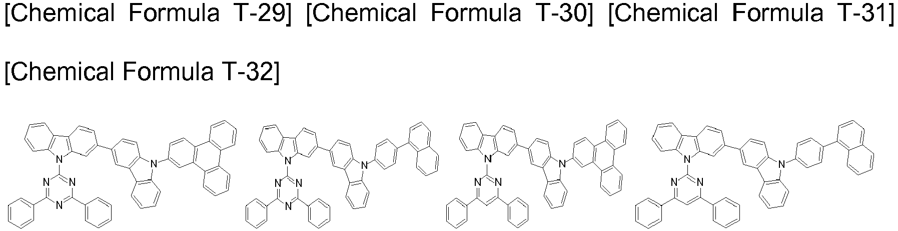

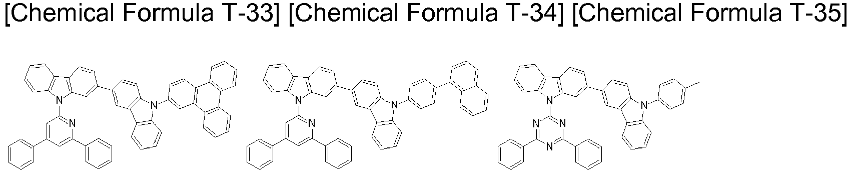

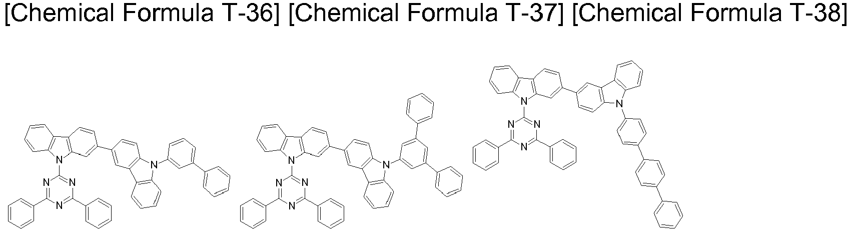

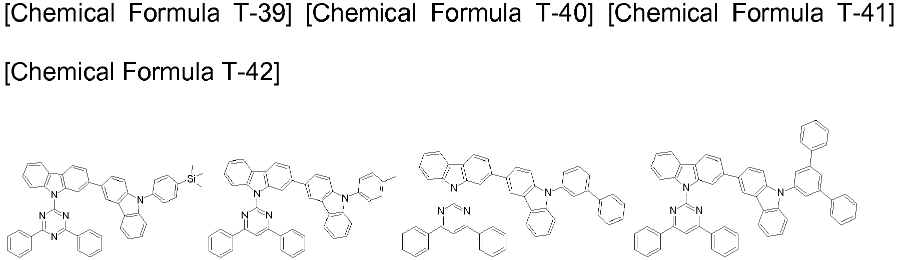

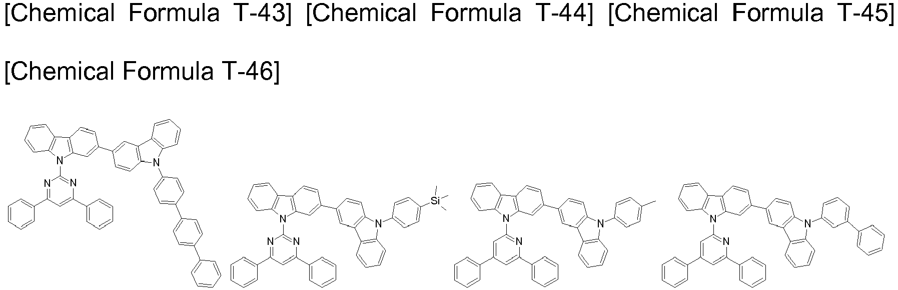

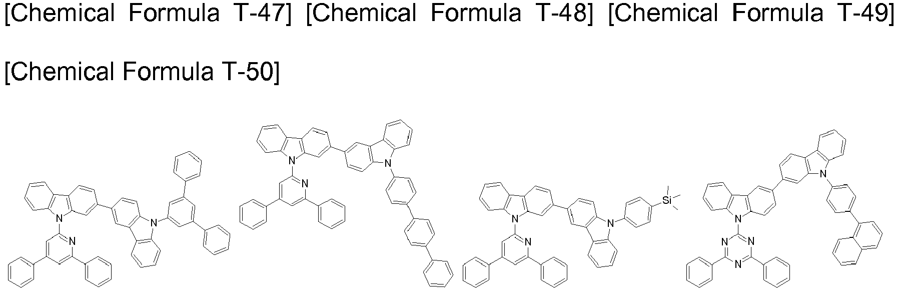

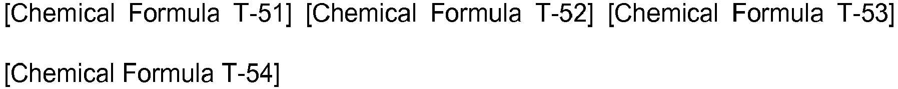

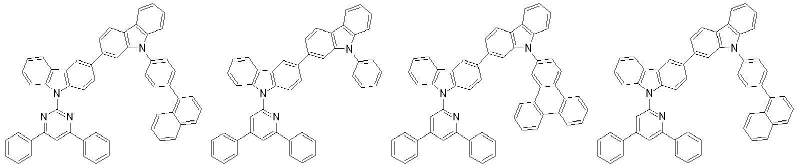

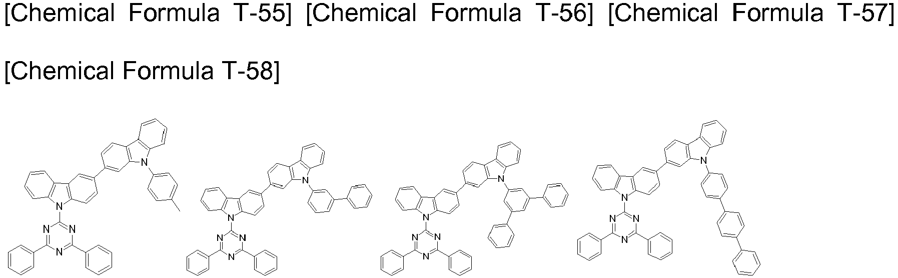

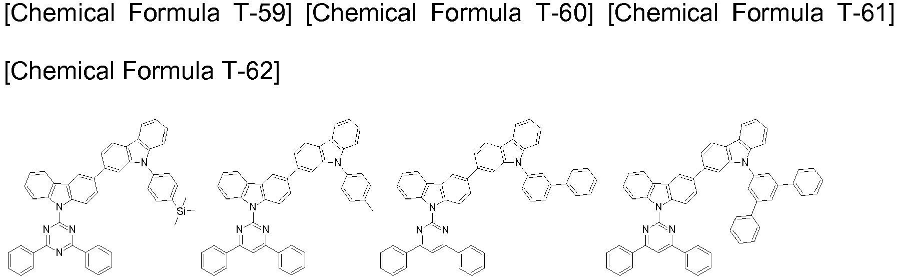

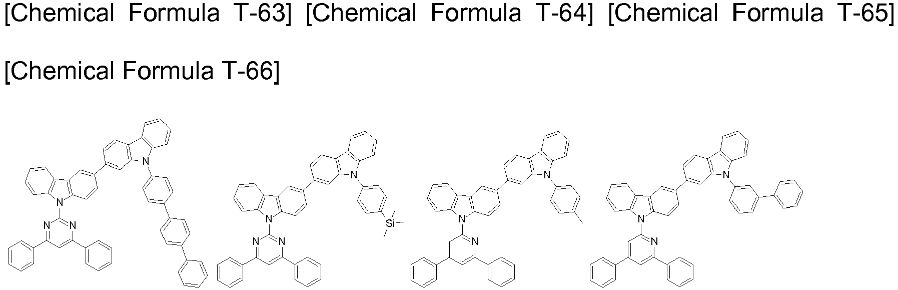

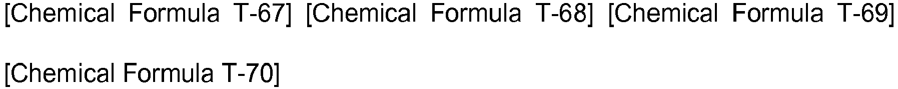

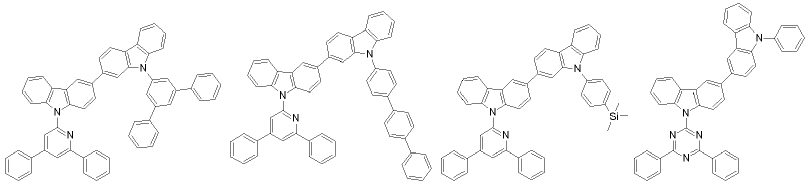

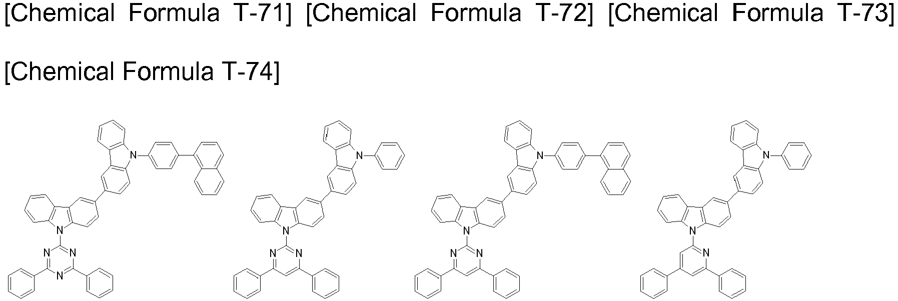

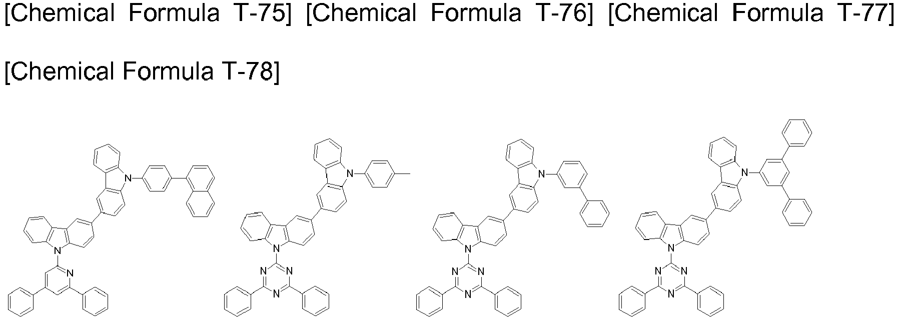

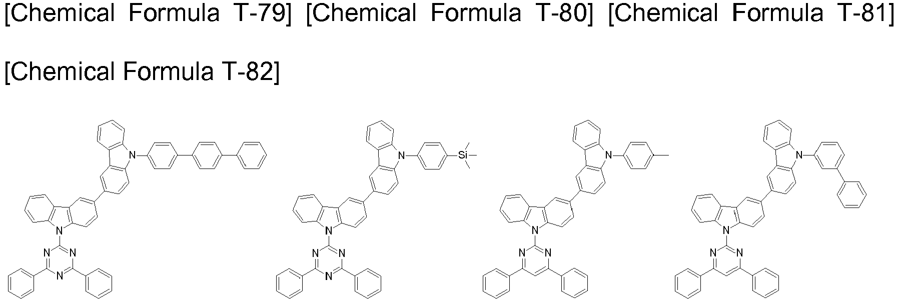

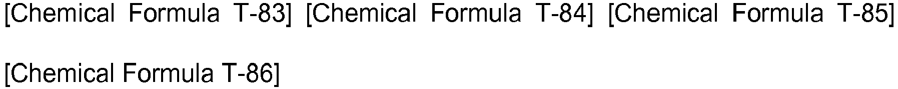

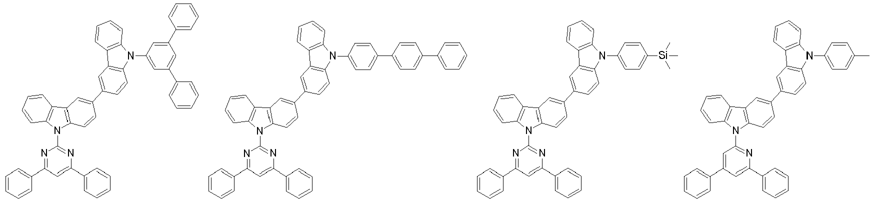

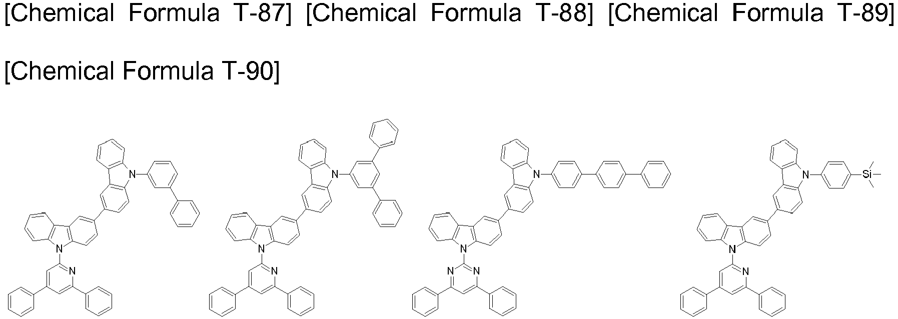

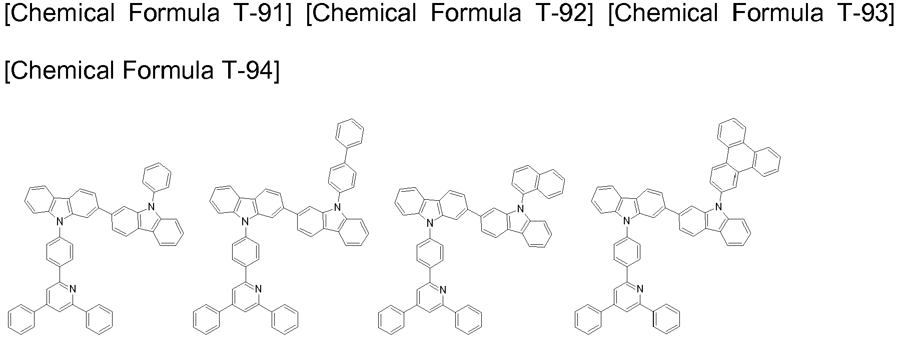

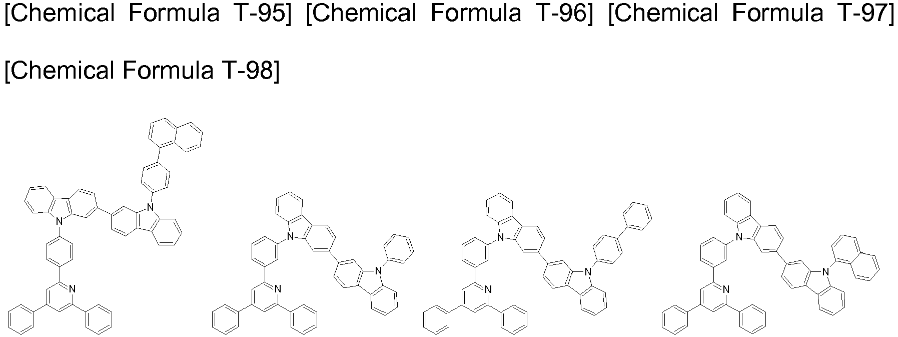

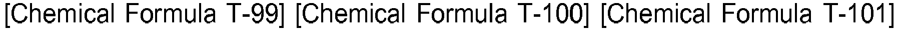

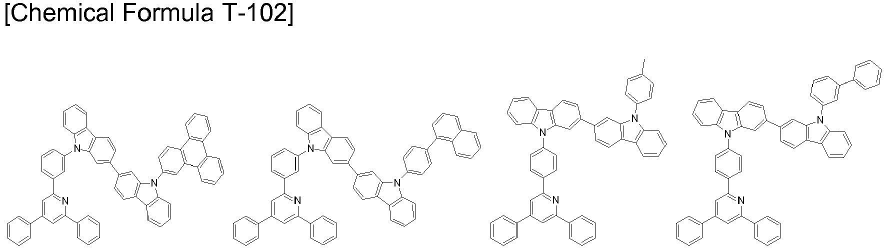

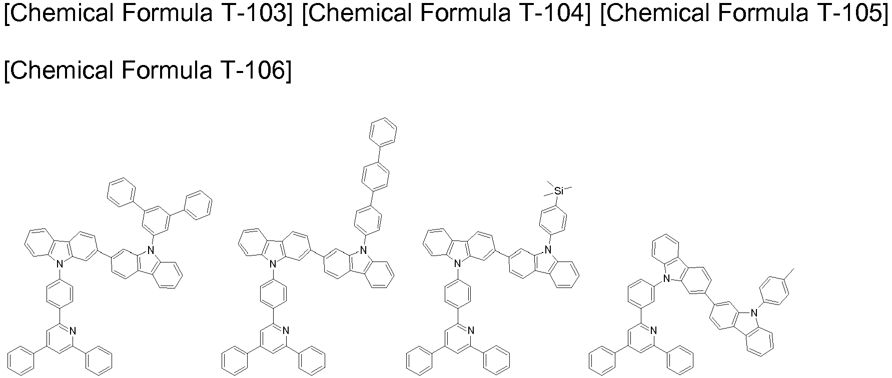

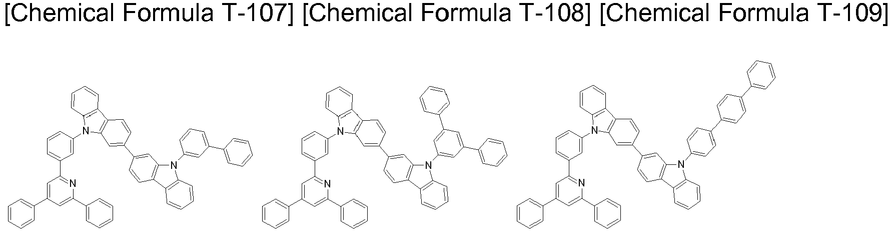

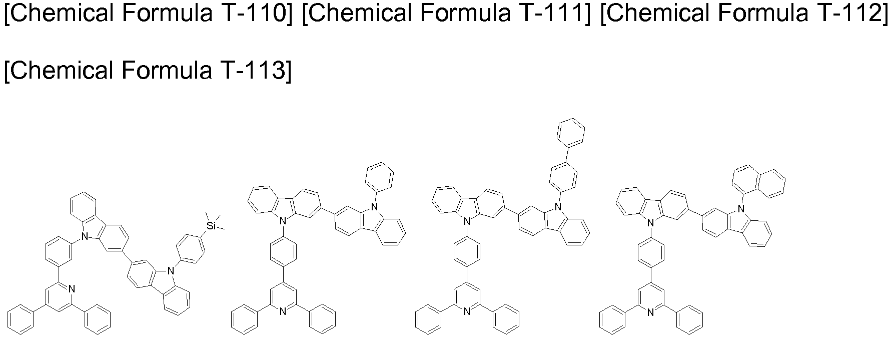

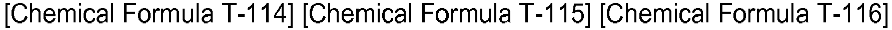

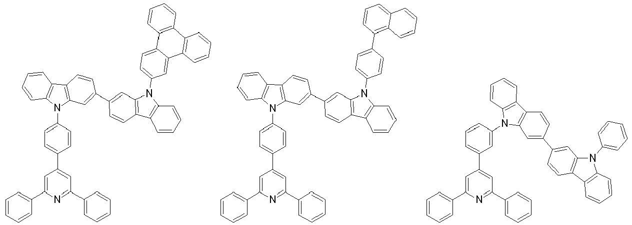

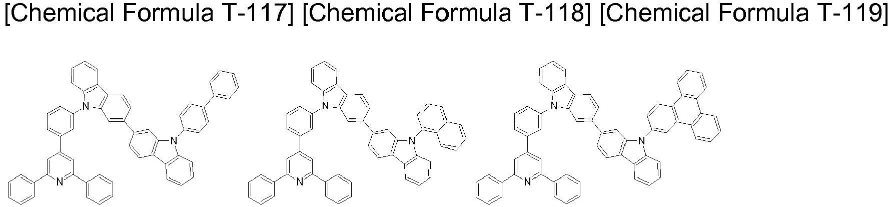

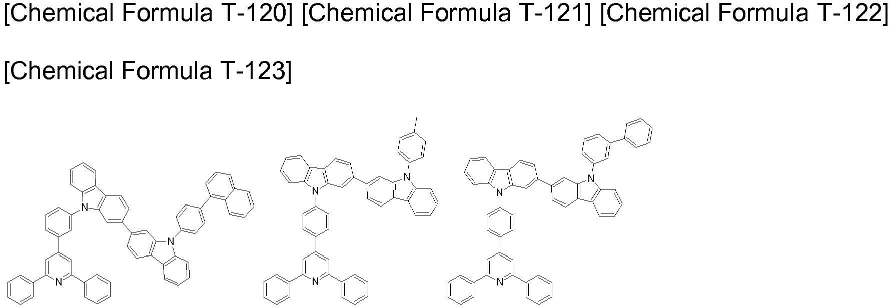

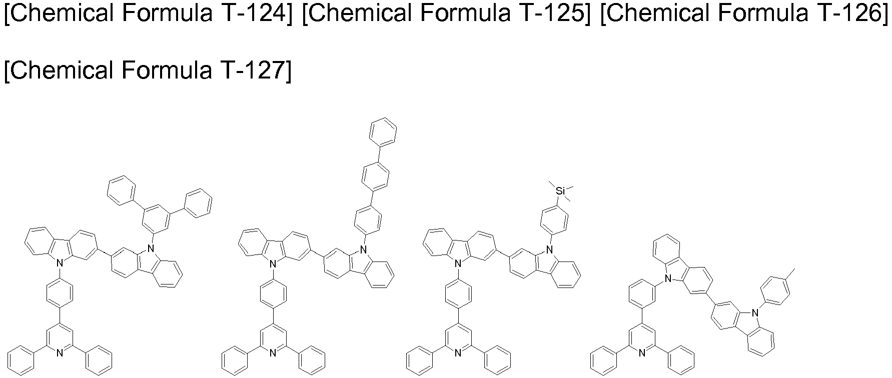

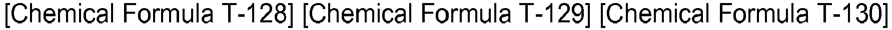

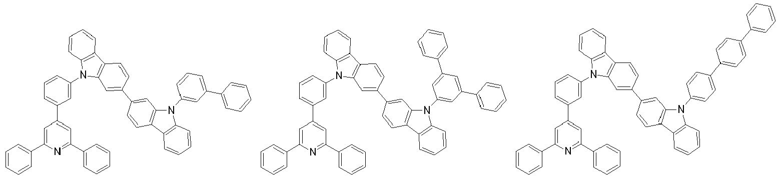

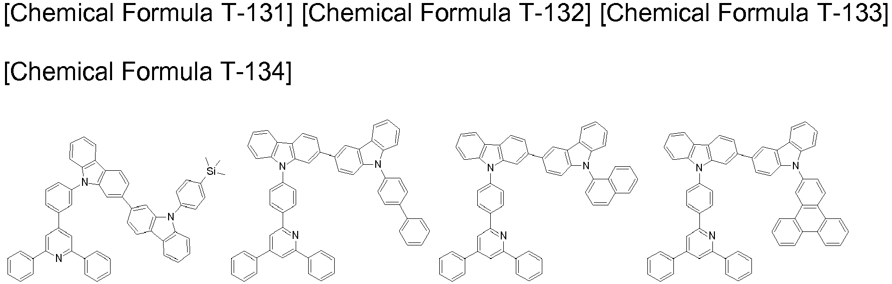

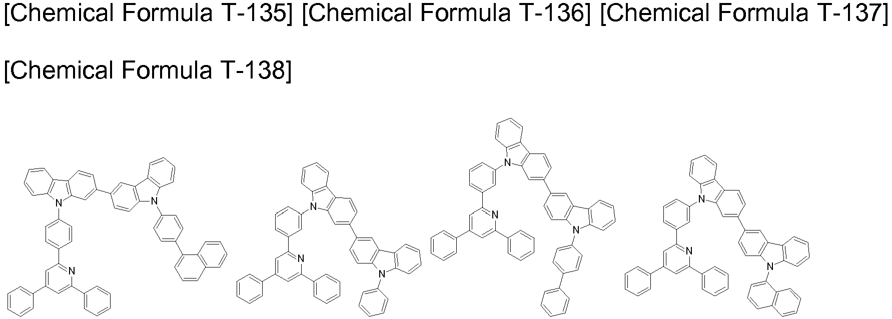

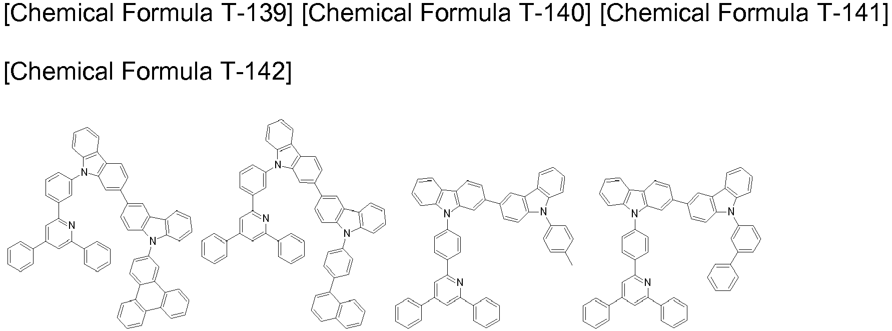

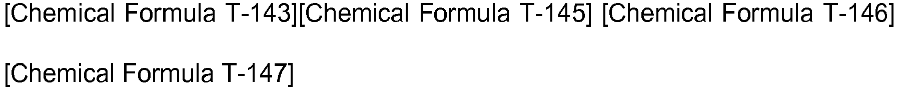

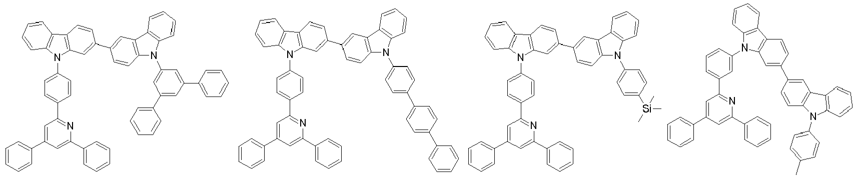

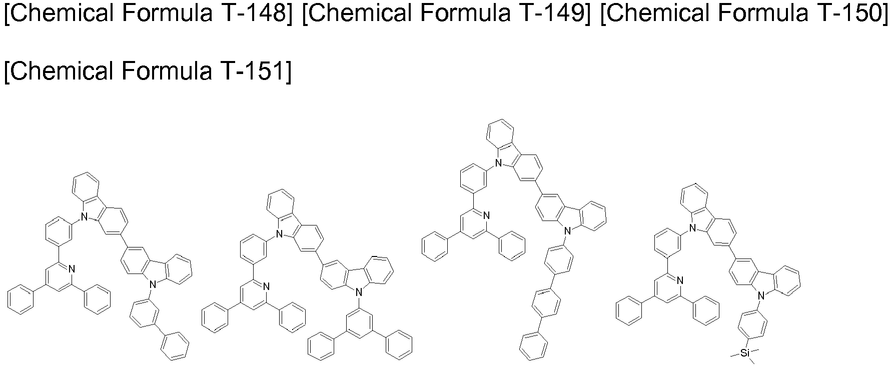

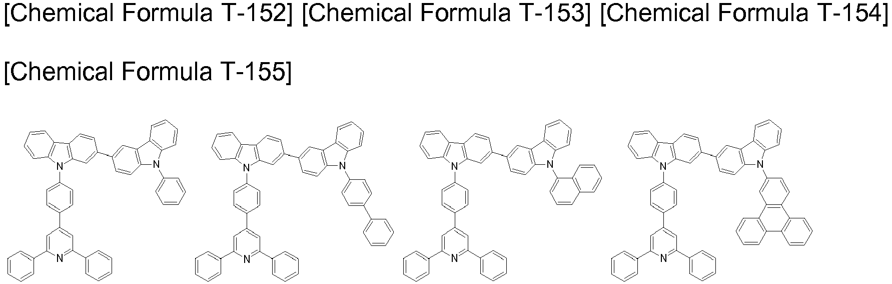

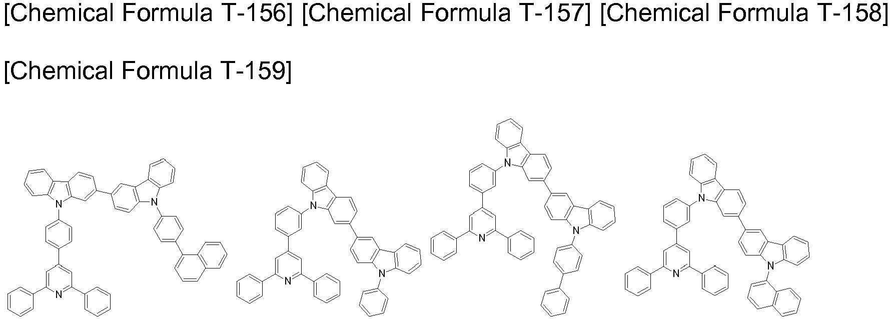

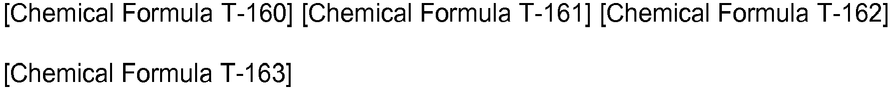

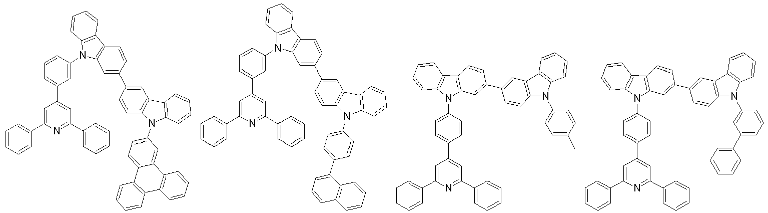

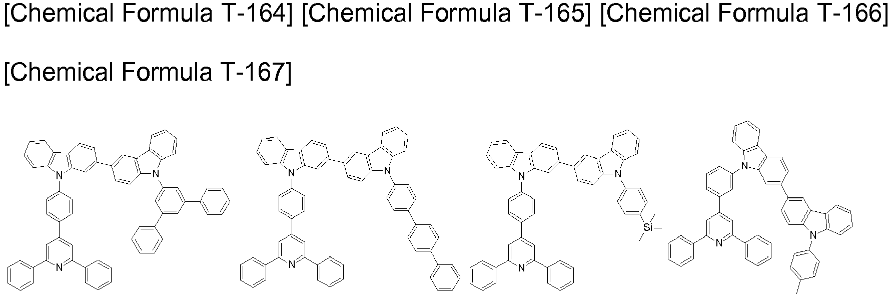

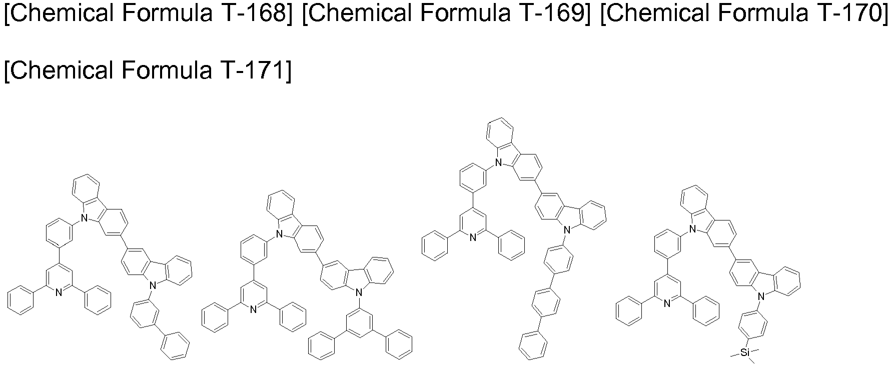

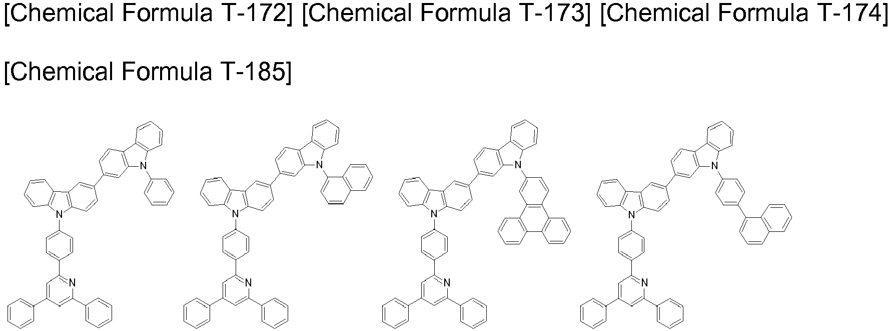

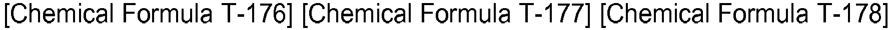

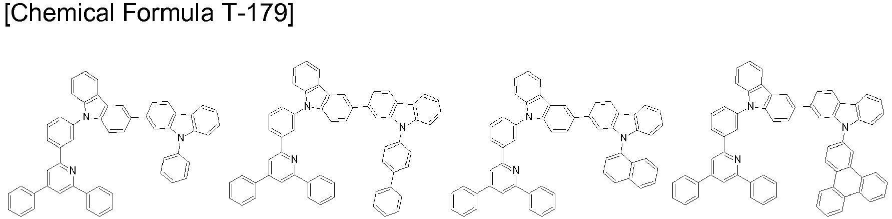

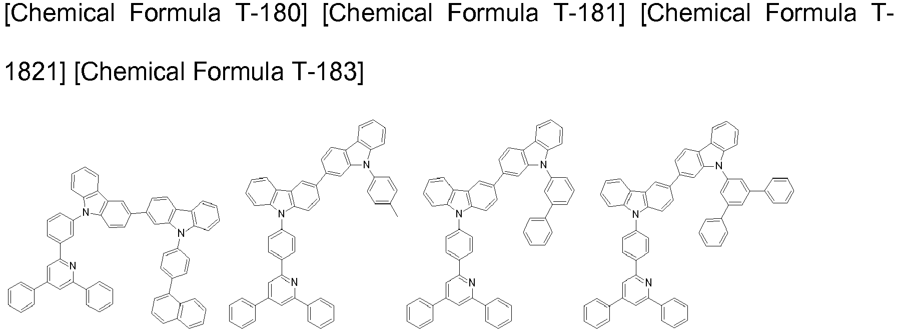

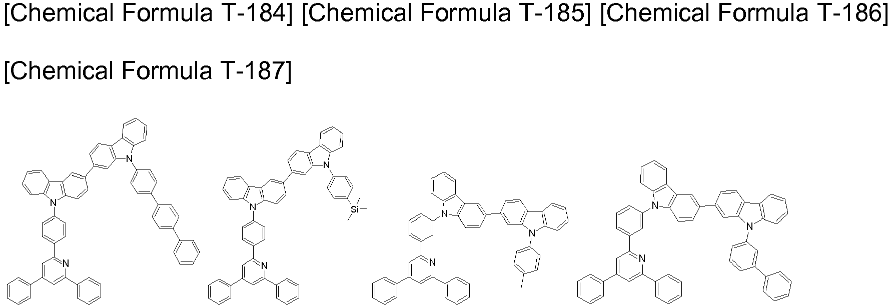

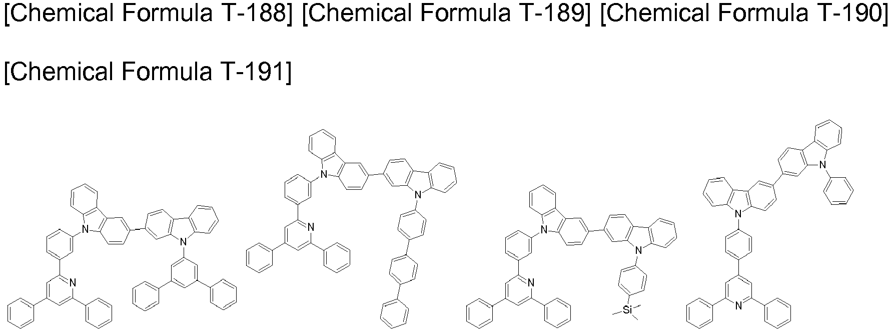

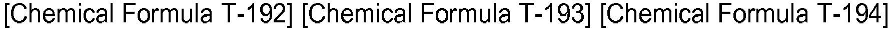

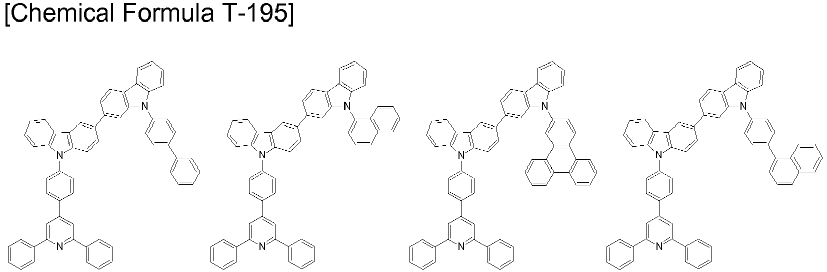

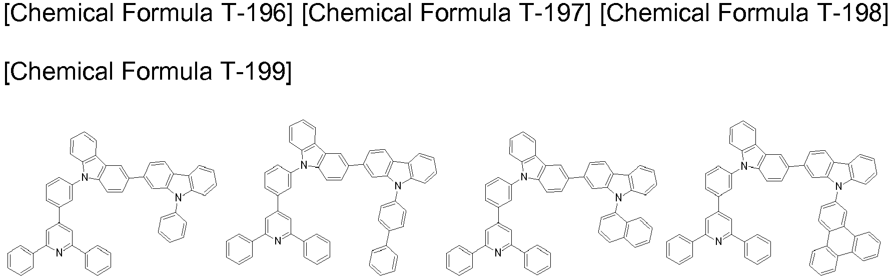

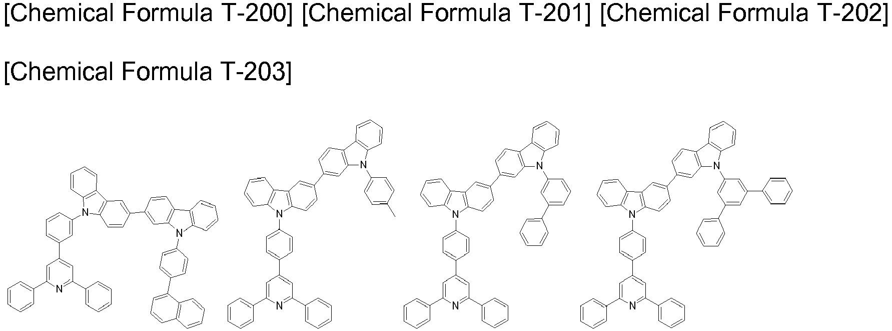

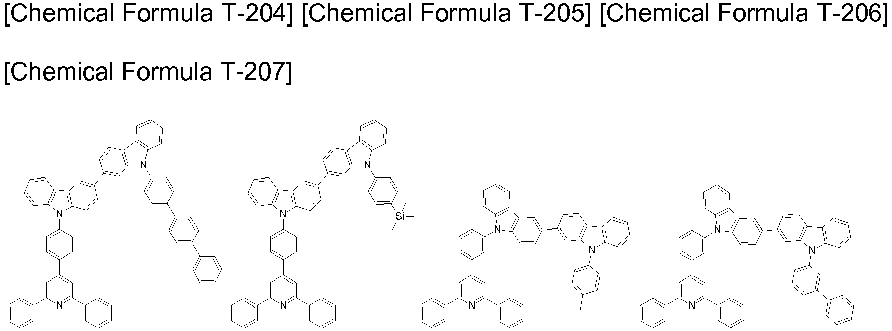

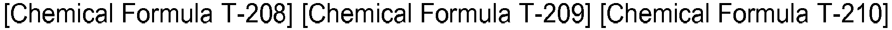

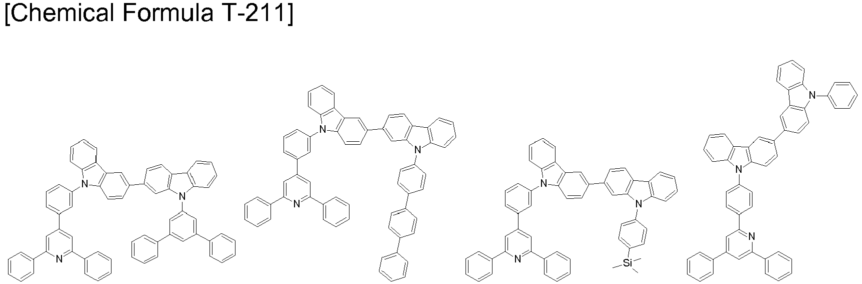

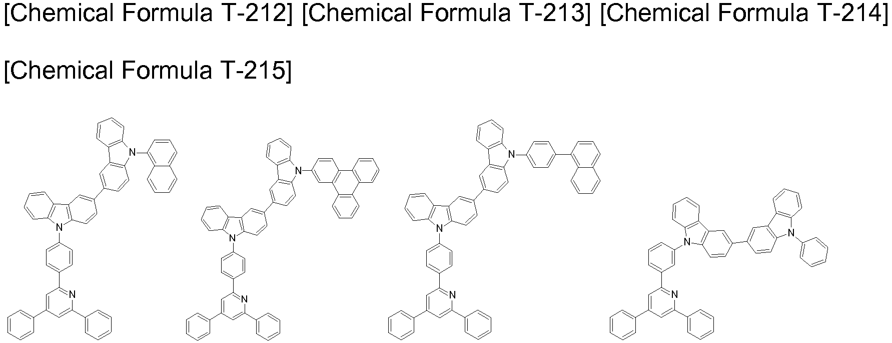

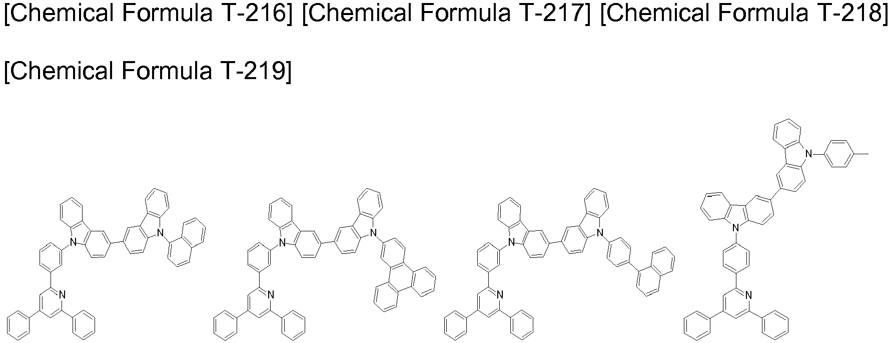

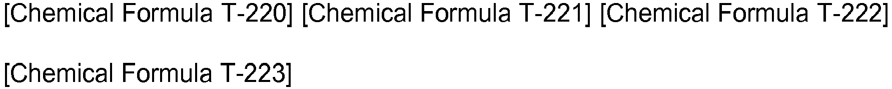

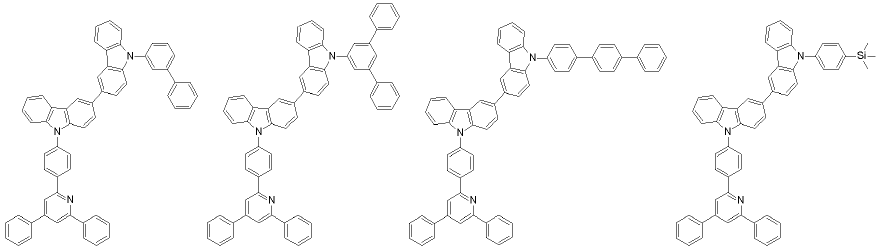

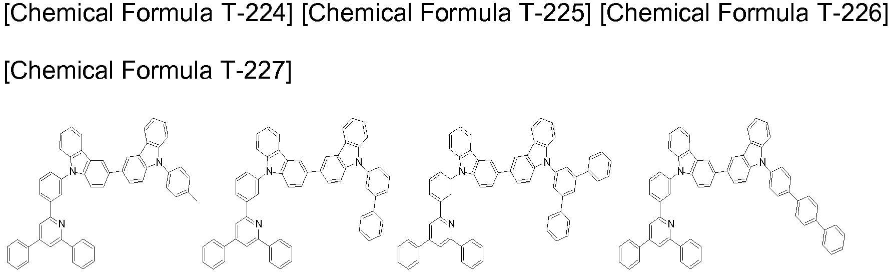

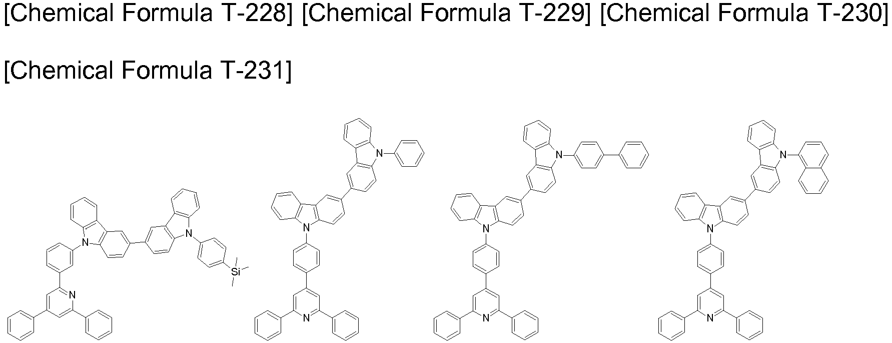

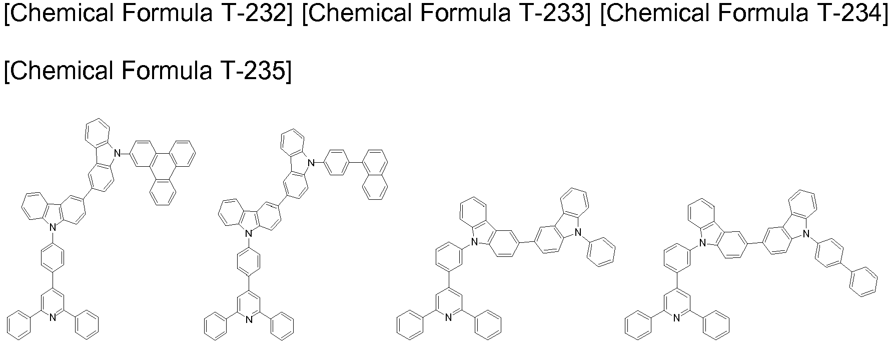

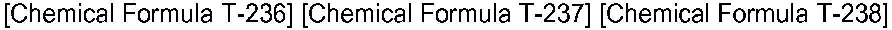

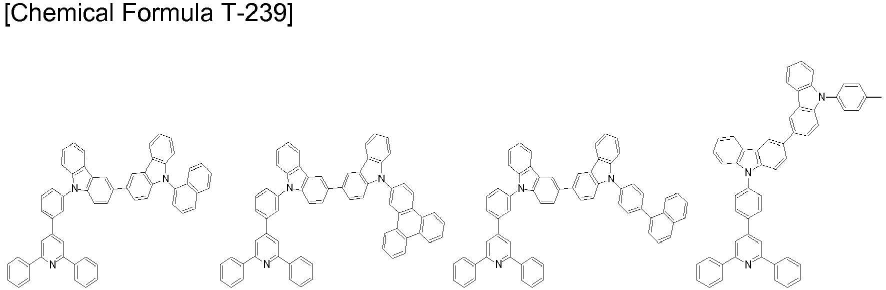

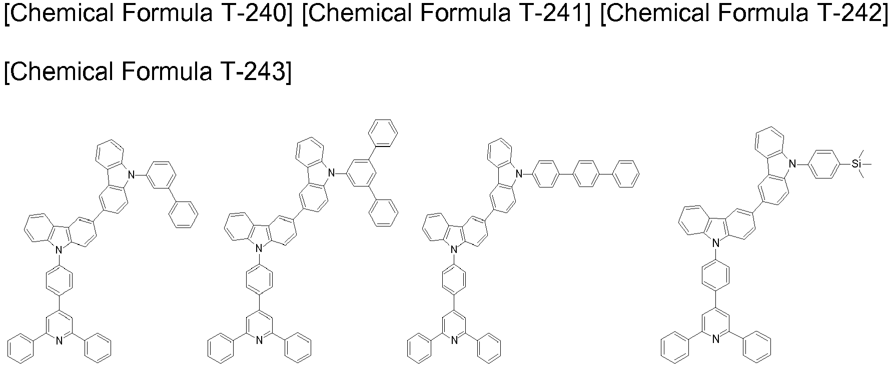

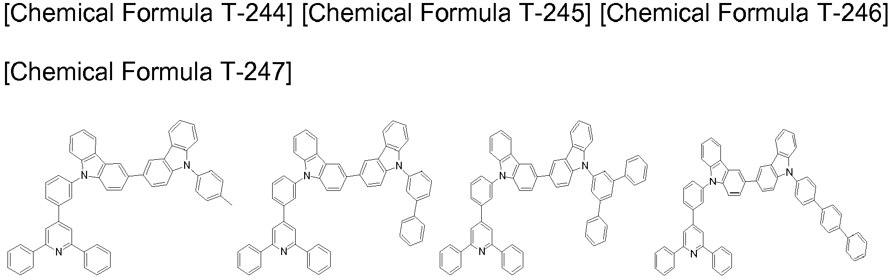

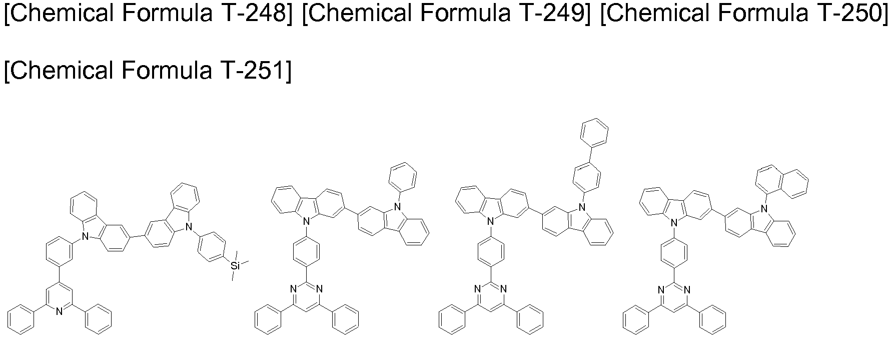

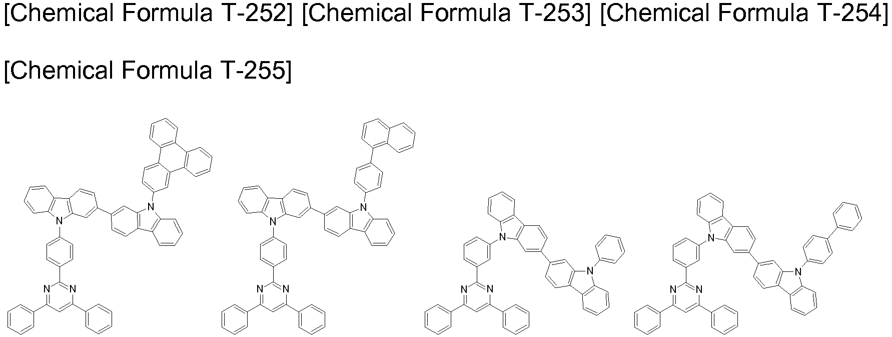

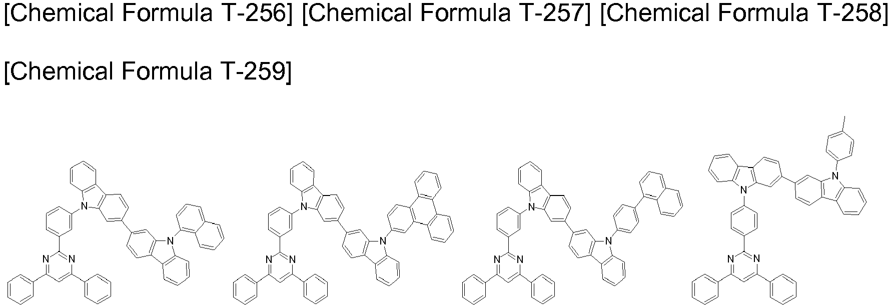

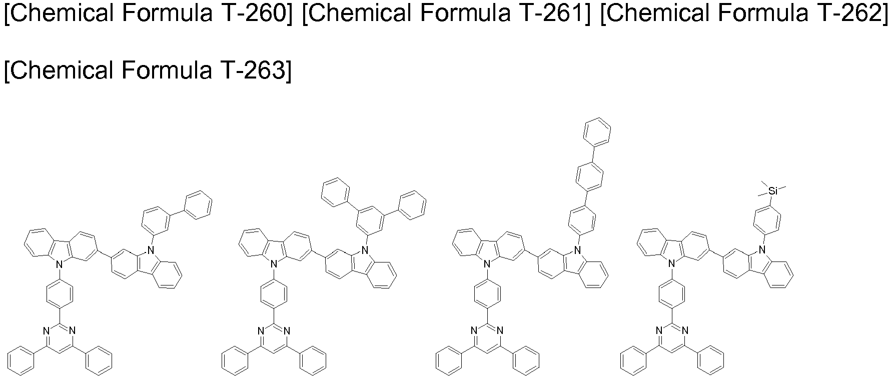

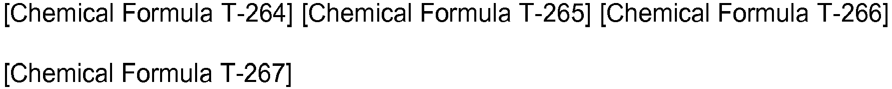

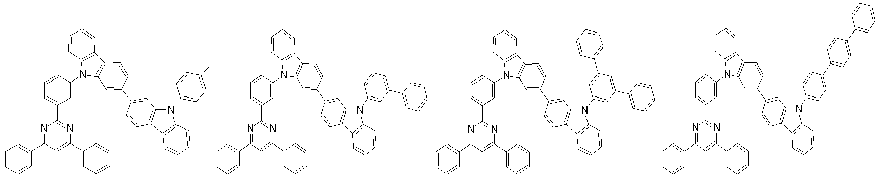

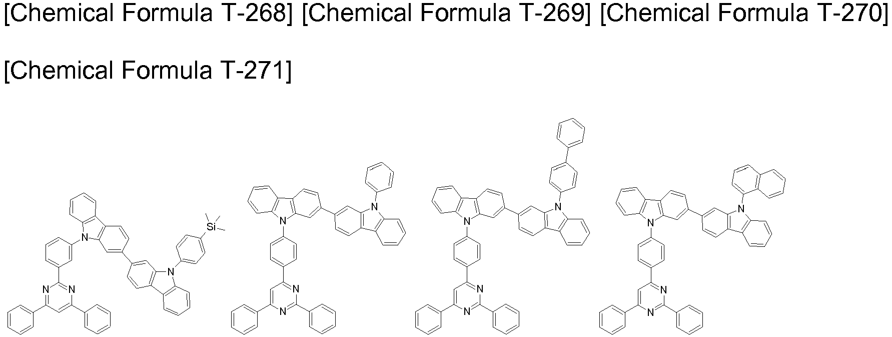

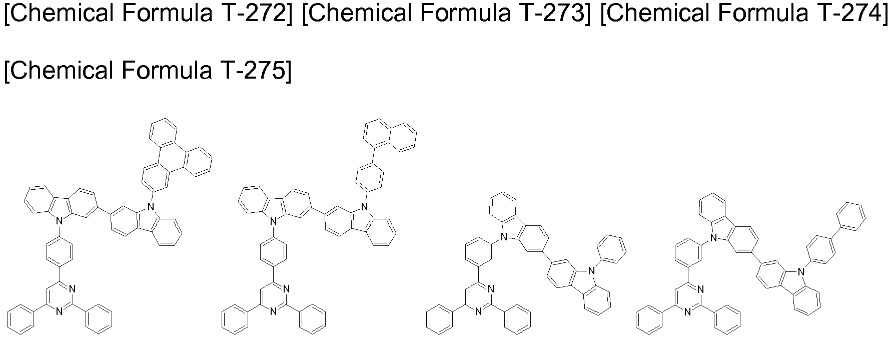

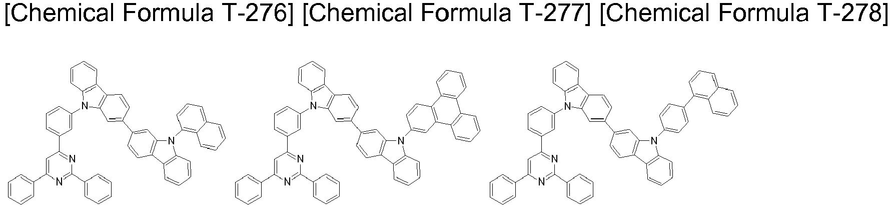

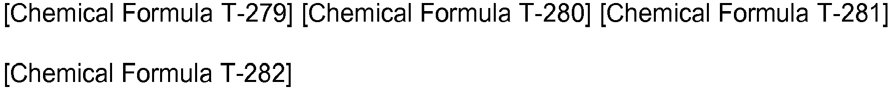

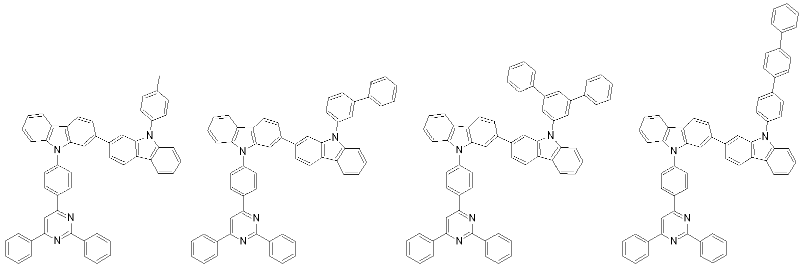

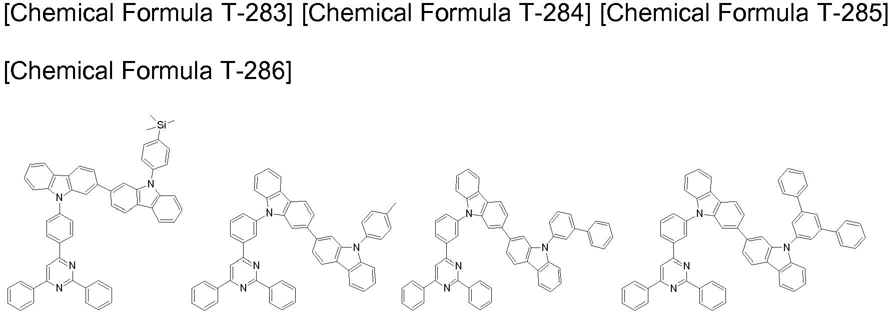

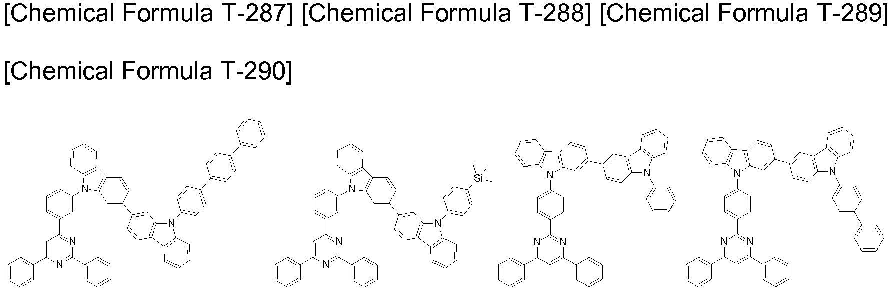

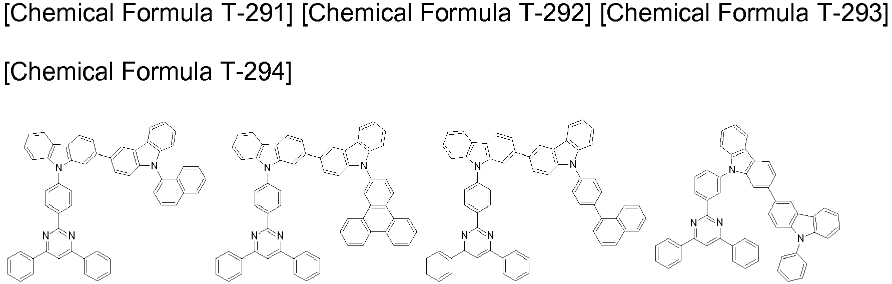

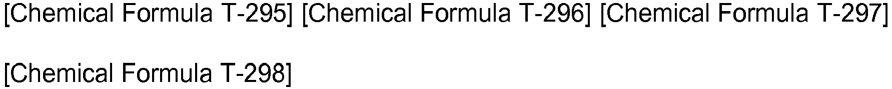

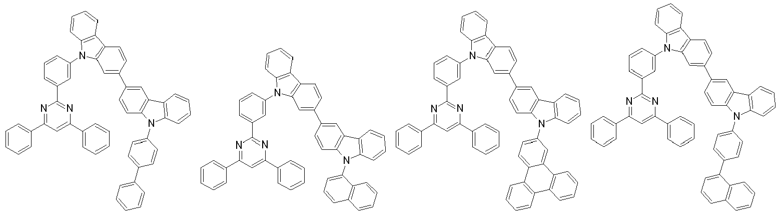

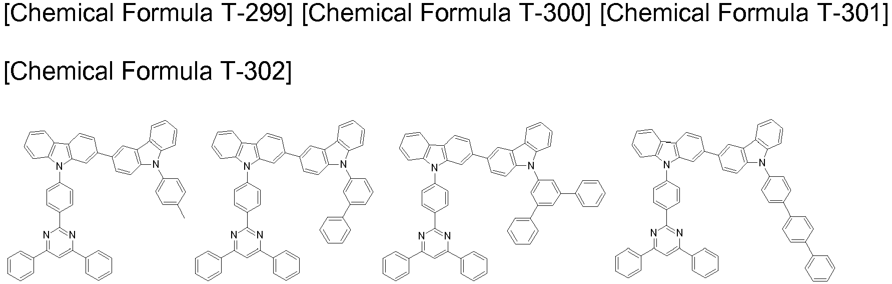

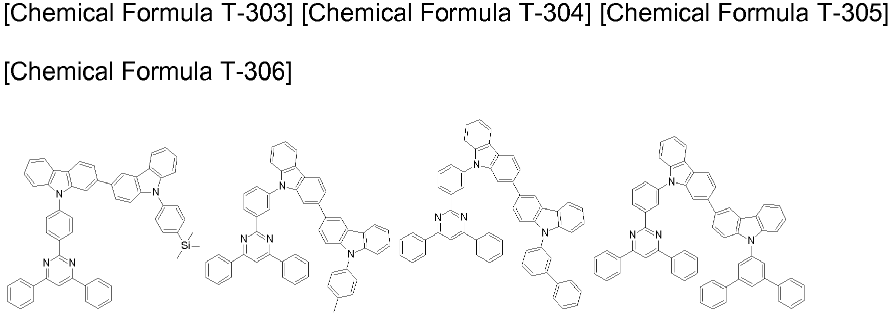

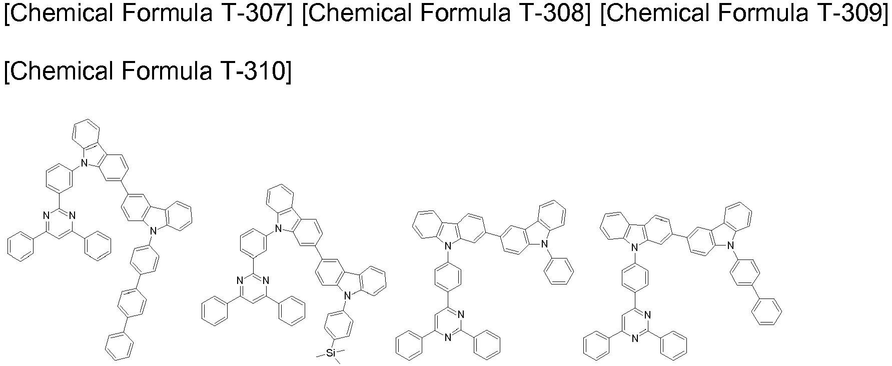

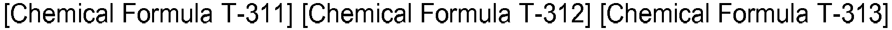

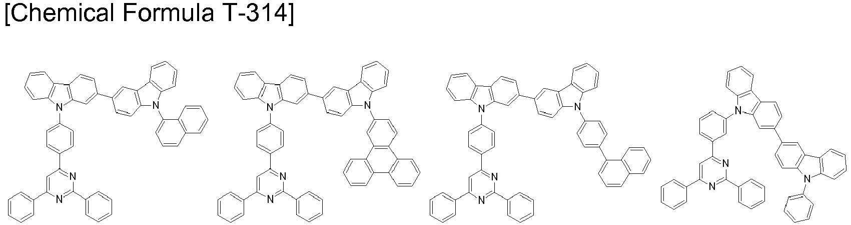

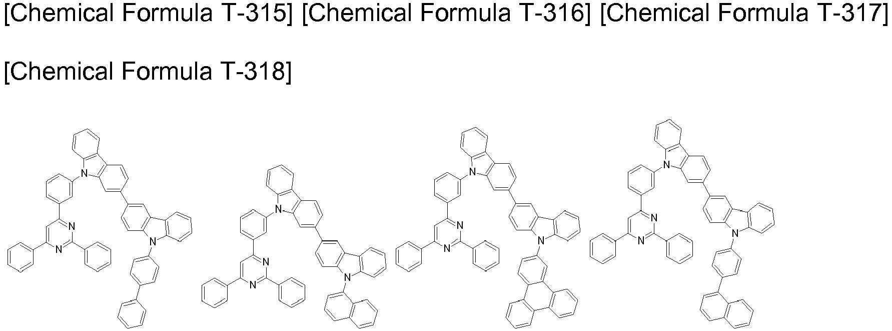

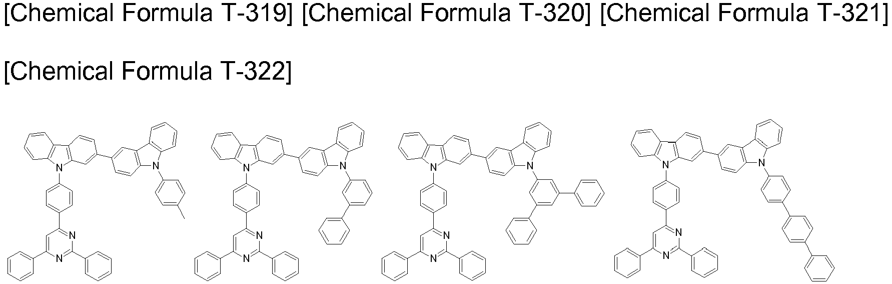

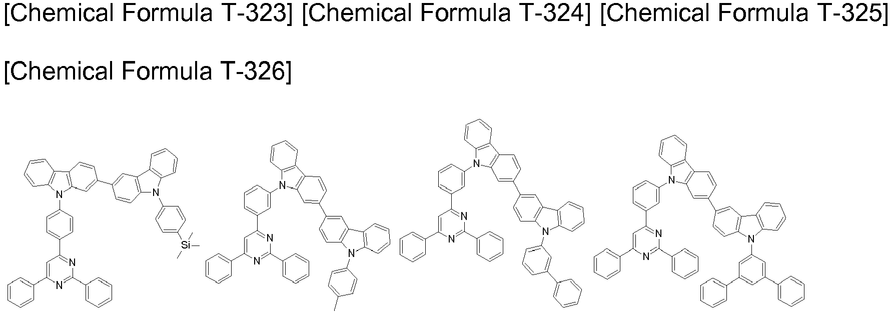

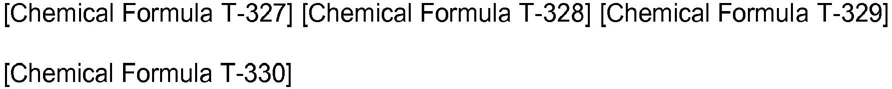

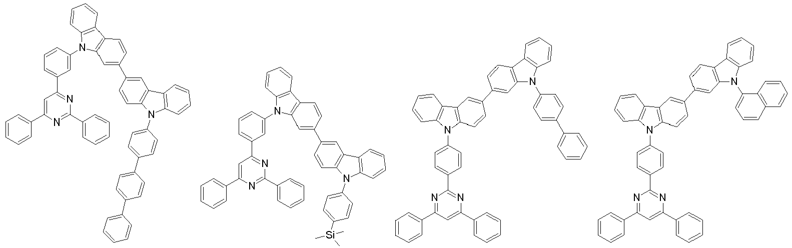

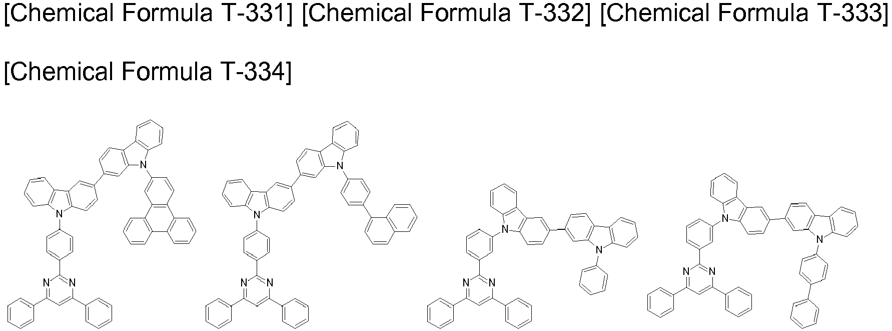

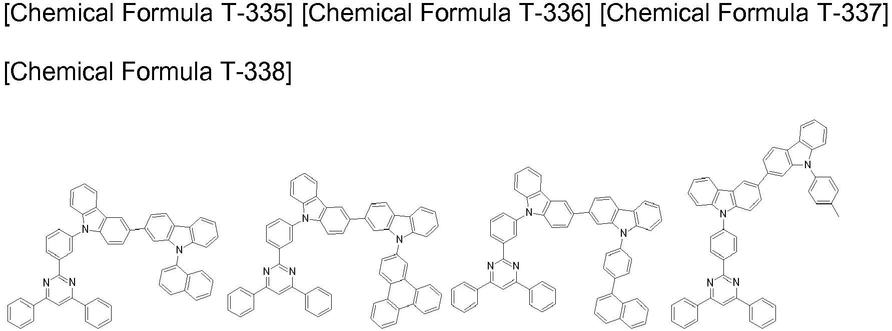

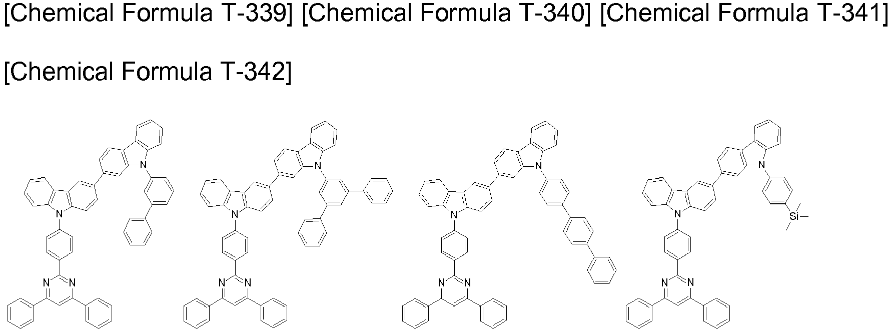

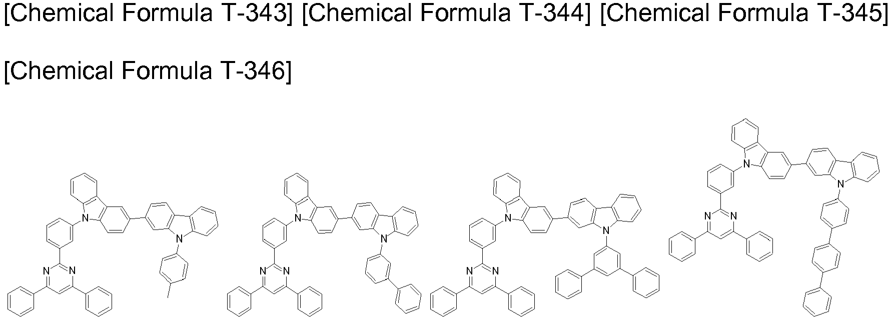

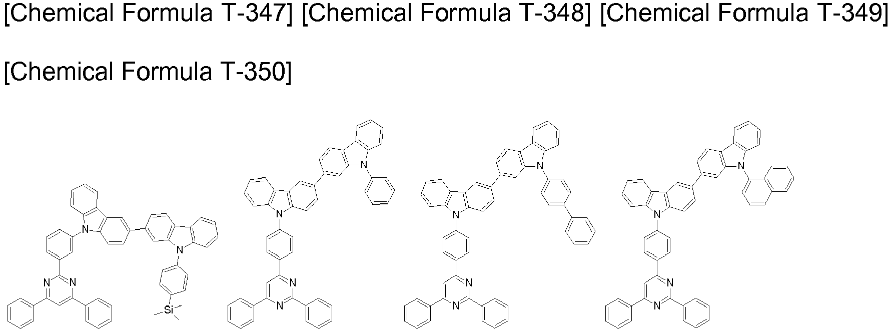

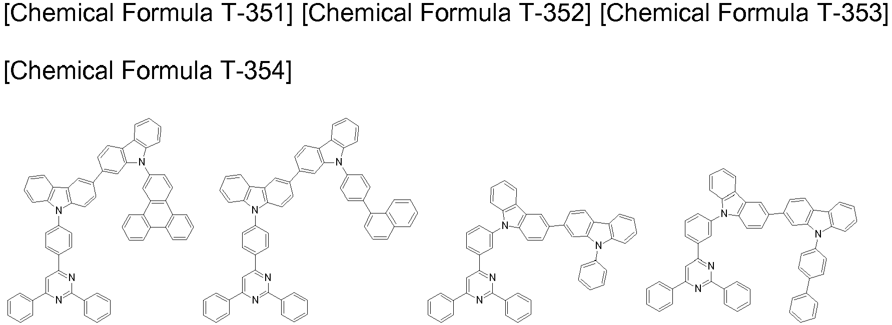

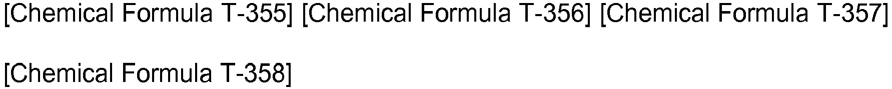

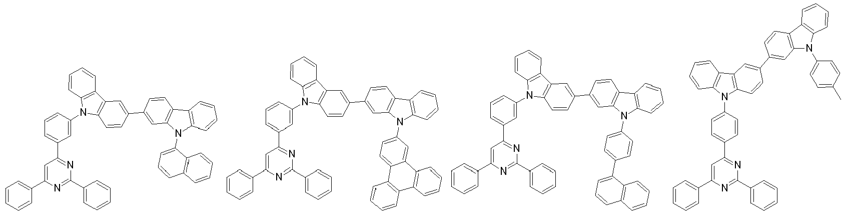

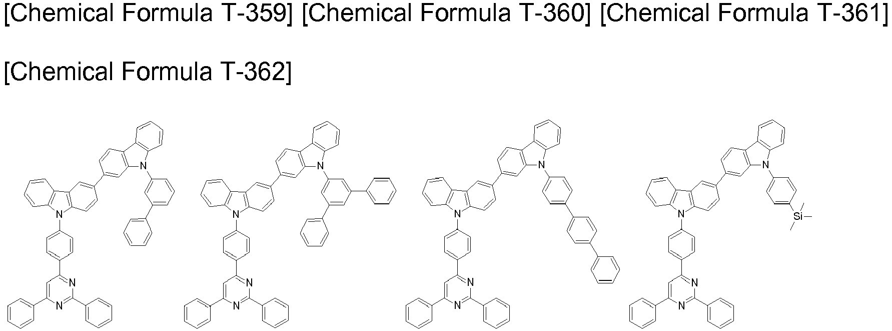

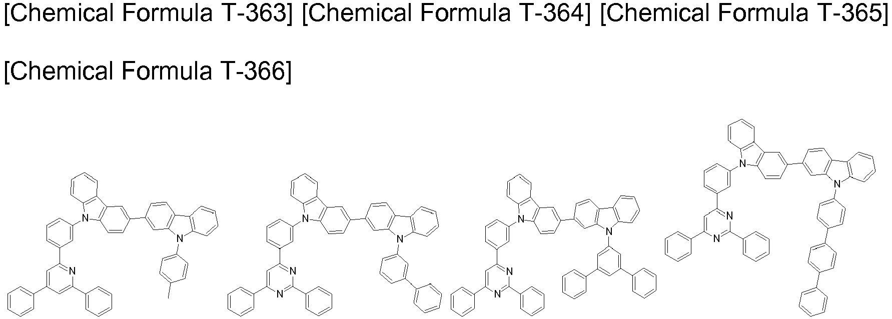

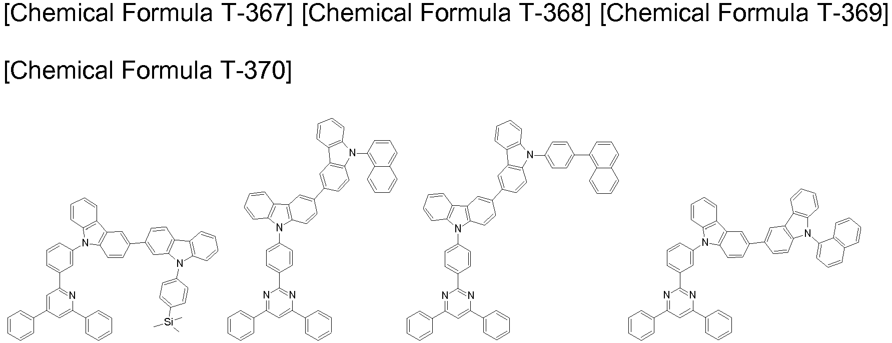

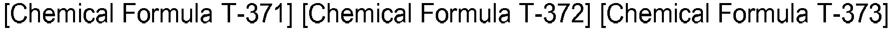

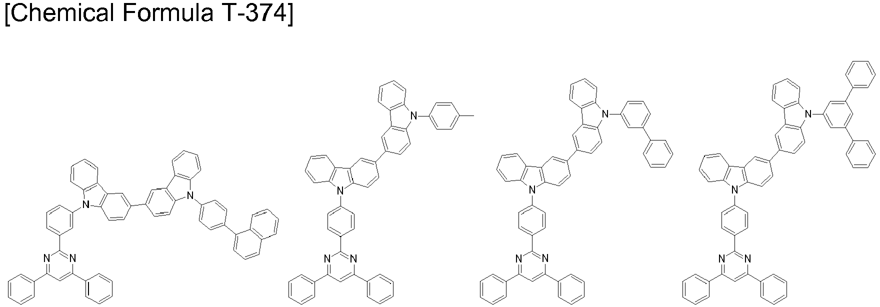

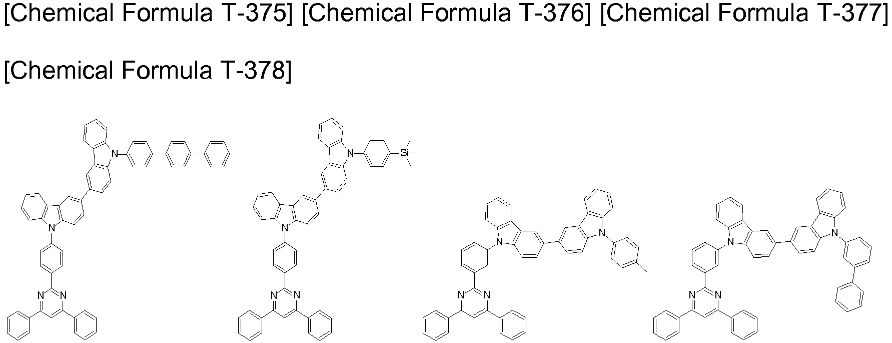

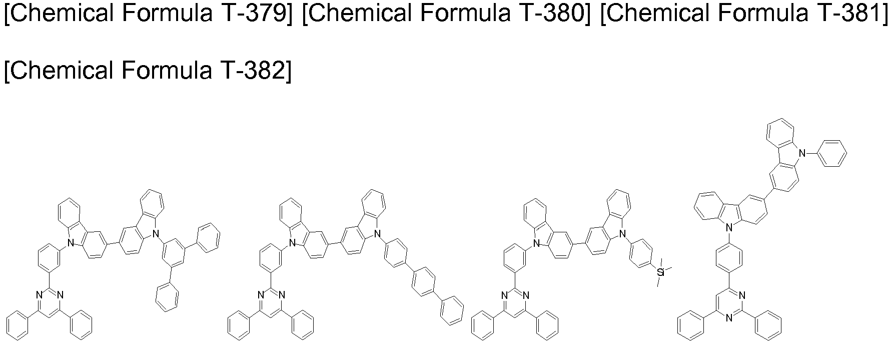

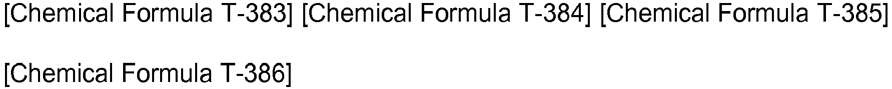

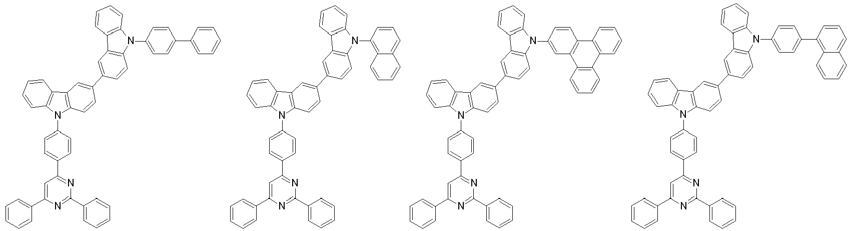

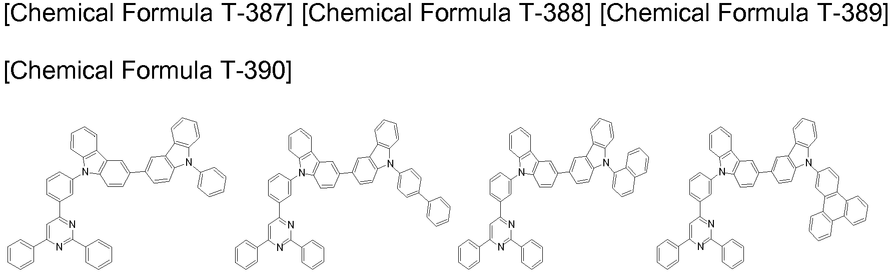

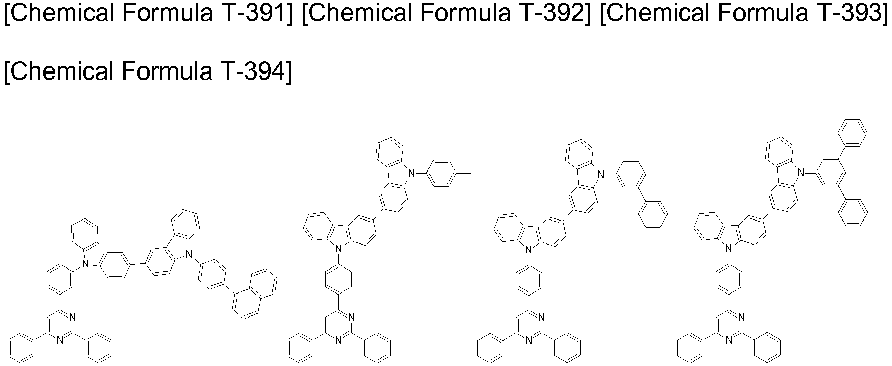

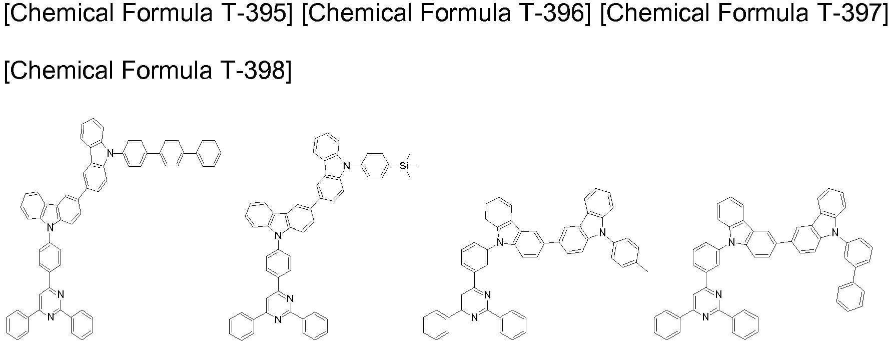

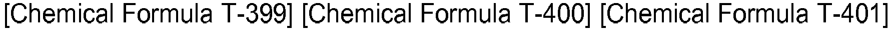

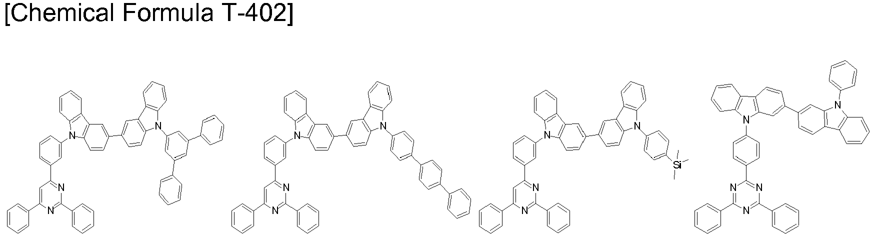

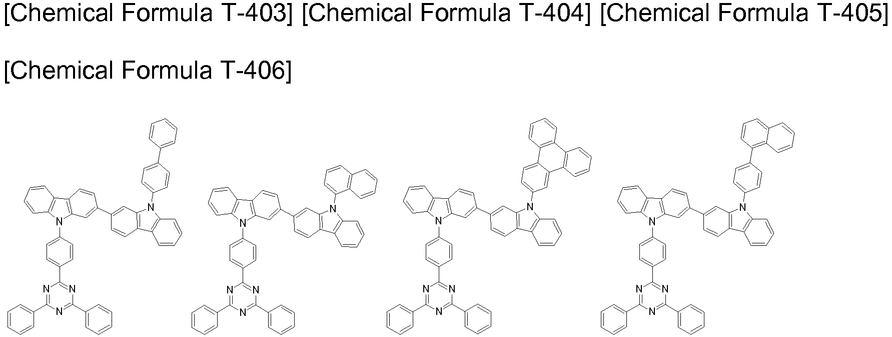

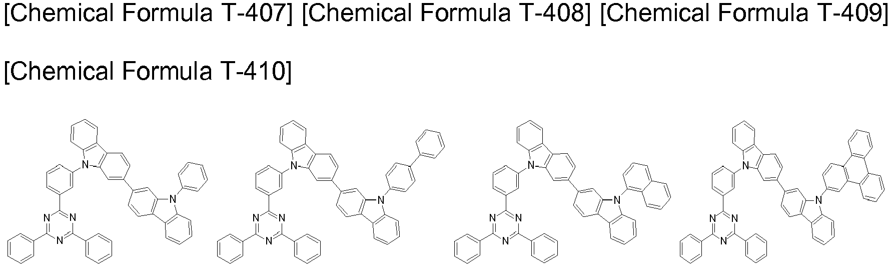

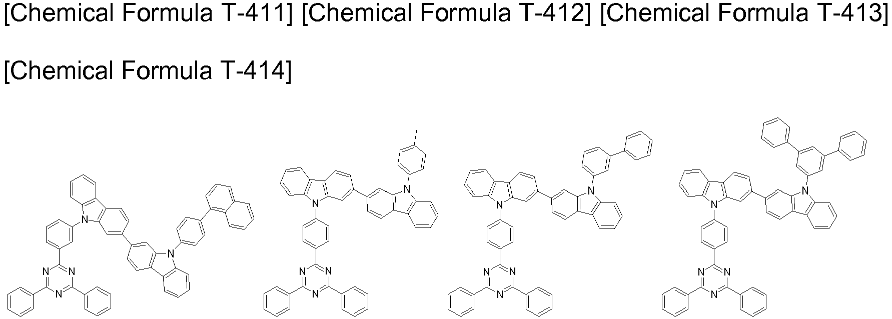

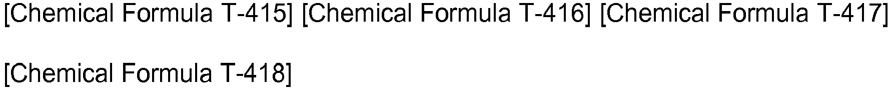

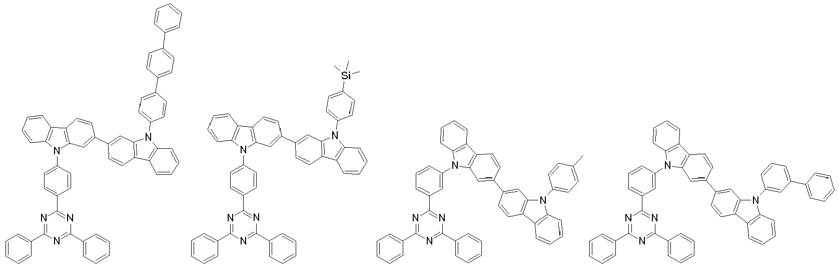

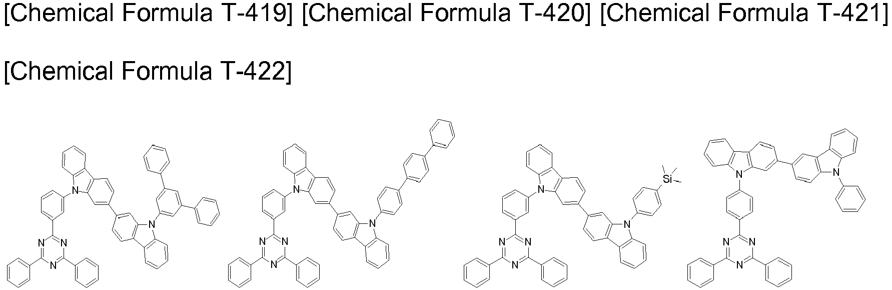

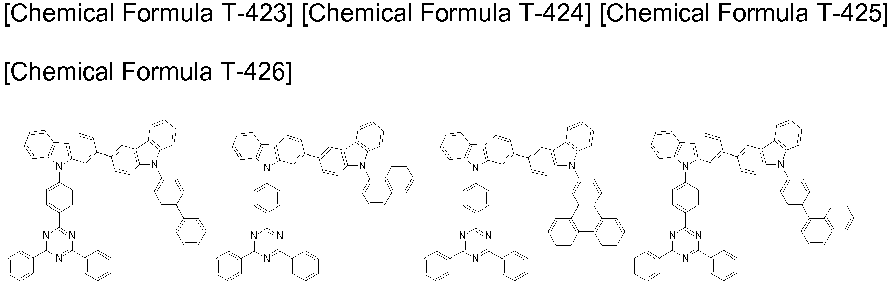

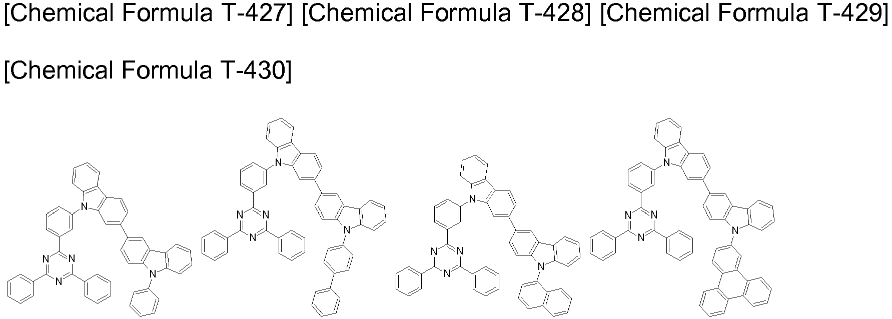

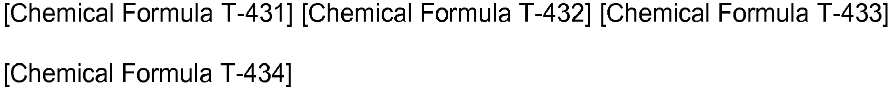

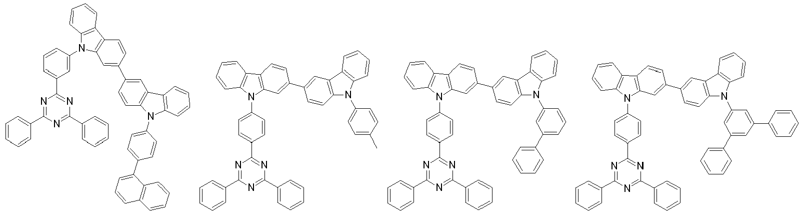

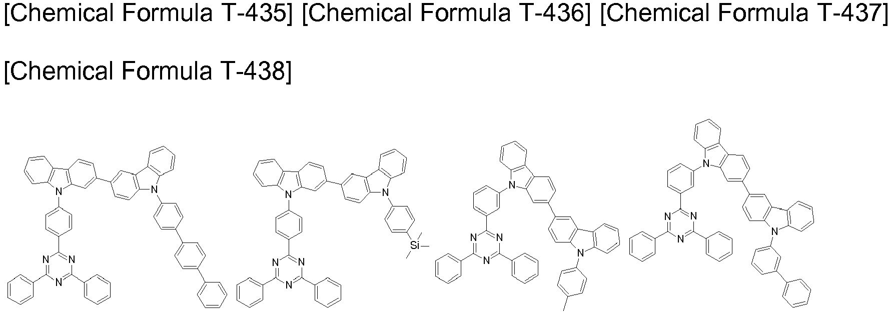

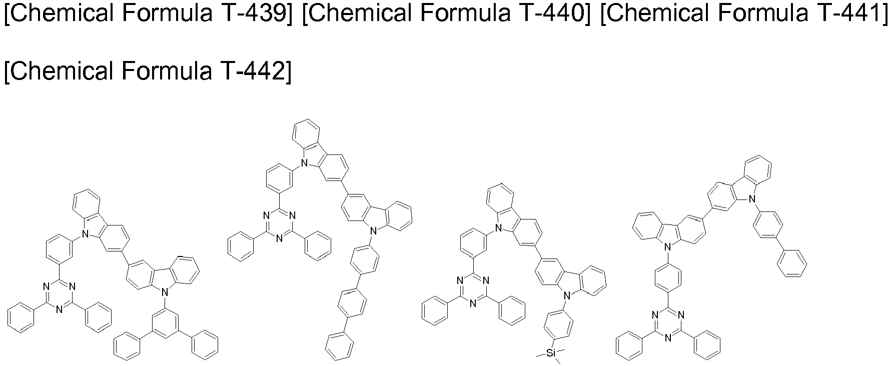

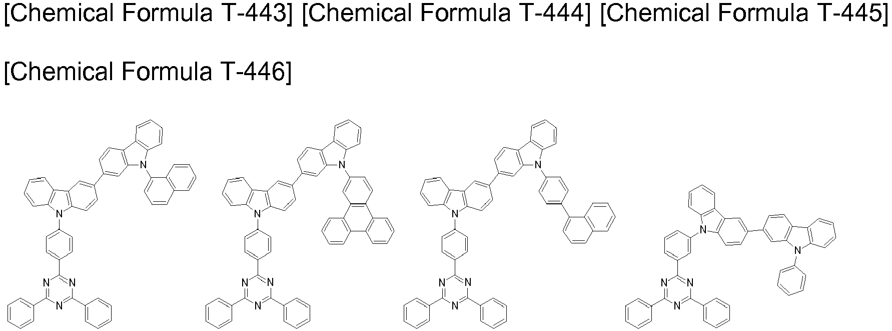

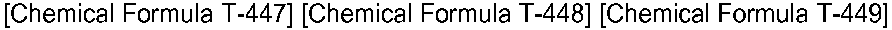

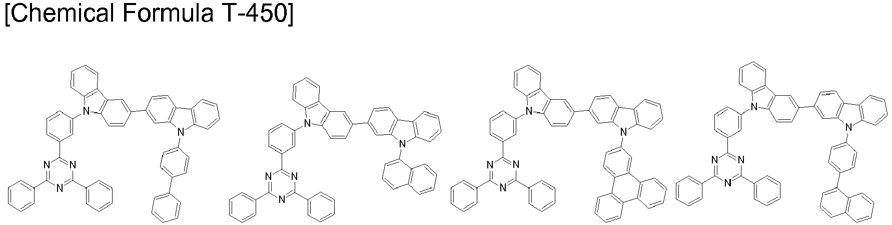

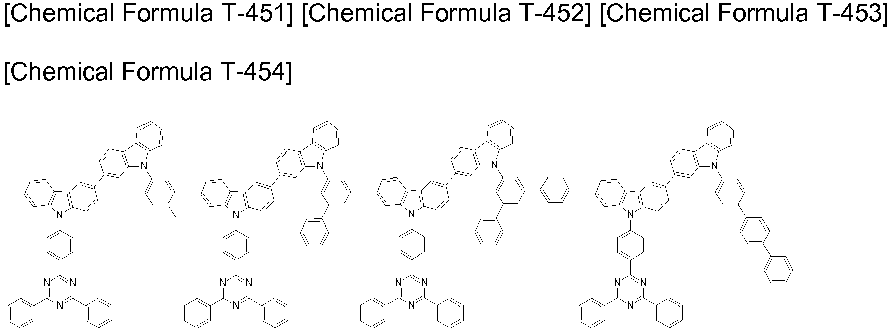

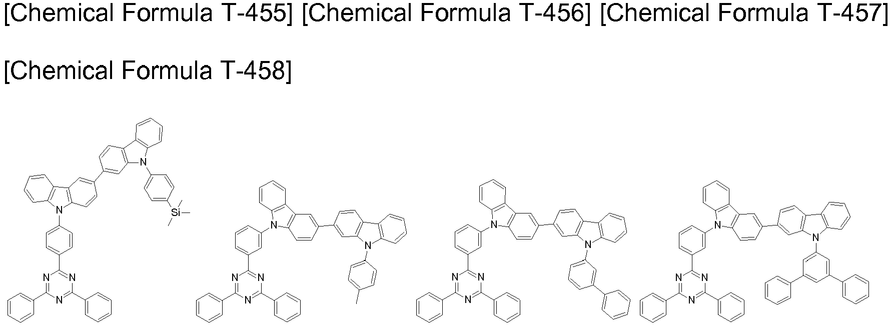

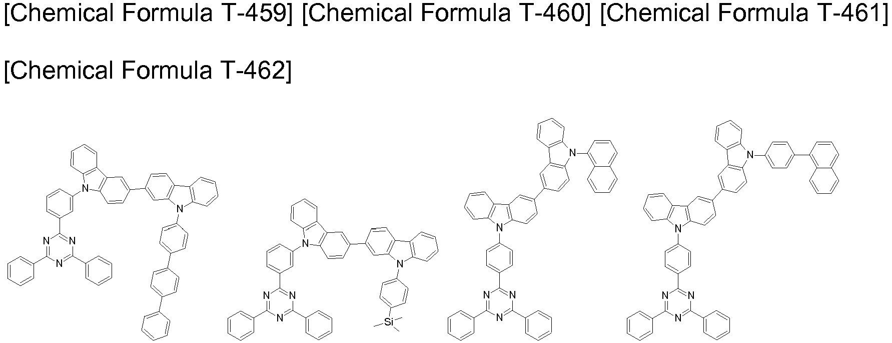

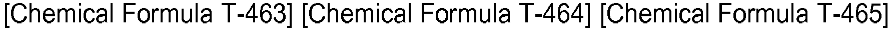

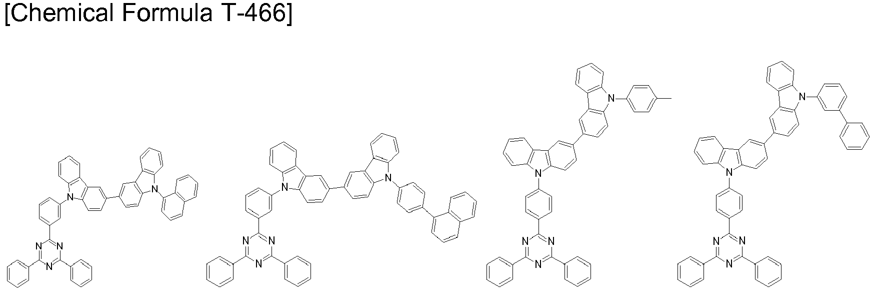

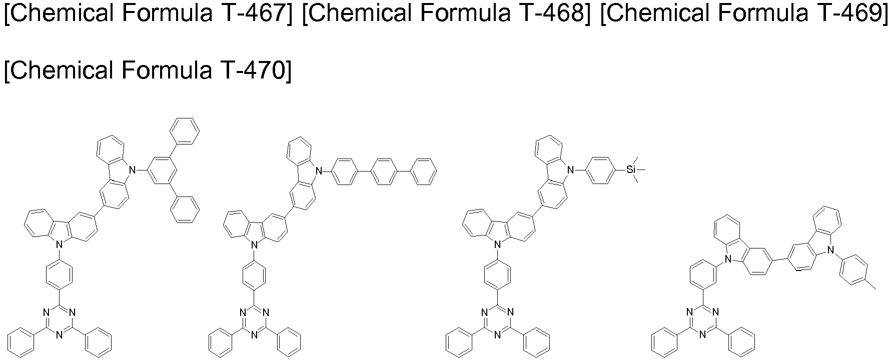

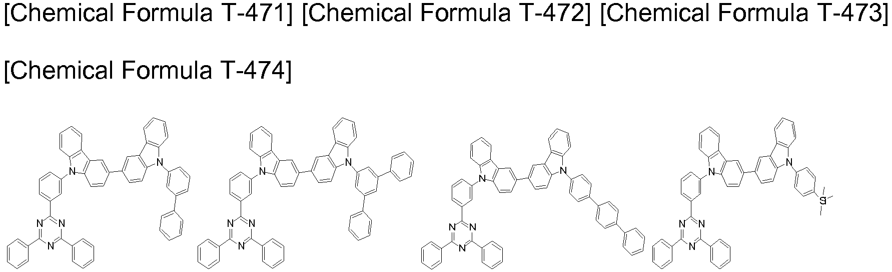

The compound for an organic optoelectric device represented by the above Chemical Formula S-1 of he present invention may be one of Chemical Formula A-19, Chemical Formula A-20, Chemical Formula A-22, Chemical FormulaA-23, Chemical Formula T-35, Chemical Formula T-36, Chemical Formula T-40, Chemical Formula T-41, Chemical Formula T-77, Chemical Formula T-81, Chemical Formula T-82, Chemical Formula T-96, Chemical Formula 4, Chemical Formula 5, Chemical Formula 53 or Chemical Formula 54, wherein the compound represented by the above Chemical Formula X-1 may be a composition for an organic light emitting diode of Chemical Formula M-1, P-2, P-3, C-1, C-6 or B-18.

On the other hand, a weight ratio of the compound for an organic optoelectric device represented by the above Chemical Formula S-1 and the compound for an organic optoelectric device represented by the above Chemical Formula X-1 may be 1:99 to 99:1.

In another embodiment of the present invention, an organic thin layer including the composition for an organic light emitting diode is provided.

The organic thin layer may be specifically an emission layer.

In another embodiment of the present invention, an organic optoelectric device includes an anode, a cathode, and at least one or more organic thin layer between the anode and the cathode, and at least one of the organic thin layers may include the compound for an organic optoelectric device.

The compound for an organic optoelectric device is used in an organic thin layer and thus improves life-span characteristics, efficiency characteristics, electrochemical stability, and thermal stability of an organic optoelectric device, and lowers a driving voltage.

The organic optoelectric device may be an organic light emitting diode, an organic photoelectric device, an organic solar cell, an organic transistor, an organic photo-conductor drum, or an organic memory device.

More specifically, the organic optoelectric device may be an organic light emitting diode. FIGS. 1 to 5 are cross-sectional views showing organic light emitting diodes including the compound for an organic optoelectric device according to one embodiment of the present invention.

Referring to FIGS. 1 and 2, organic light emitting diodes 100 and 200 according to one embodiment of the present invention includes an anode 120, a cathode 110, and at least one organic thin layer 105 between the anode and the cathode.

The anode 120 includes an anode material having a large work function to help hole injection into an organic thin layer. The anode material includes: a metal such as nickel, platinum, vanadium, chromium, copper, zinc, and gold, or alloys thereof; a metal oxide such as zinc oxide, indium oxide, indium tin oxide (ITO), and indium zinc oxide (IZO); a bonded metal and oxide such as ZnO:Al or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including indium tin oxide (ITO) as an anode.

The cathode 110 includes a cathode material having a small work function to help electron injection into an organic thin layer. The cathode material includes: a metal such as magnesium, calcium, sodium, potassium, titanium, indium, yttrium, lithium, gadolinium, aluminum, silver, tin, and lead, or alloys thereof; or a multi-layered material such as LiF/Al, Liq/Al, LiO₂/Al, LiF/Ca, LiF/Al, and BaF₂/Ca, but is not limited thereto. It is preferable to include a metal electrode including aluminum as a cathode.

Referring to FIG. 1, the organic light emitting diode 100 includes an organic thin layer 105 including only an emission layer 130.

Referring to FIG. 2, a double-layered organic light emitting diode 200 includes an organic thin layer 105 including an emission layer 230 including an electron transport layer (ETL), and a hole transport layer (HTL) 140. As shown in FIG. 2, the organic thin layer 105 includes a double layer of the emission layer 230 and hole transport layer (HTL) 140. The emission layer 130 also functions as an electron transport layer (ETL), and the hole transport layer (HTL) 140 layer has an excellent binding property with a transparent electrode such as ITO or an excellent hole transport capability. In one embodiment of the present invention, an organic light emitting diode may further include an electron transport layer (ETL), an electron injection layer (EIL), a hole injection layer, and the like, as an organic thin layer 105 in FIG. 1 or FIG. 2.

In FIG. 1 or FIG. 2, the emission layers 130 and 230, the hole transport layer (HTL) 140 or even though not drawn in the drawings, one selected from the group consisting of the electron transport layer (ETL), the electron injection layer (EIL), the hole injection layer (HIL) and a combination thereof which constitute the organic thin layer 105 may include the compound for an organic optoelectric device.

Particularly the compound for an organic optoelectric device may be used in the emission layers 130 and 230, and may be used as a green phosphorescent dopant material in the emission layers.

The organic light emitting diode may be manufactured by: forming an anode on a substrate; forming an organic thin layer in accordance with a dry coating method such as evaporation, sputtering, plasma plating, and ion plating or a wet coating method such as spin coating, dipping, and flow coating; and providing a cathode thereon.

In another embodiment of the present invention, a display device including the organic optoelectric device is provided.

Hereinafter, the embodiments are illustrated in more detail with reference to examples. These examples, however, should not in any sense be interpreted as limiting the scope of the present invention.

### (Preparation of Compound for Organic Optoelectric Device)

### Example 1: Synthesis of Compound Represented by Chemical Formula 4

A compound represented by the above Chemical Formula 4 as specific examples of a compound for an organic optoelectric device according to the present invention was synthesized through a method provided in the following Reaction Scheme 1.

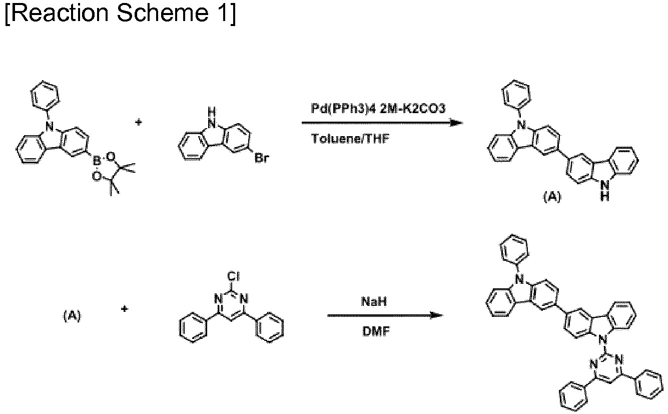

### First Step: Synthesis of Compound A

5 g (20 mmol) of 3-bromo-carbazole, 9 g (24 mmol) of N-phenyl-carbazole boronic acid pinacolate (X-02004, Alchem pharmtech, Inc.) and 100 mL of tetrahydrofuran and a 2 M-potassium carbonate aqueous solution were mixed in a 250 mL round-bottomed flask equipped with an agitator having a nitrogen atmosphere and then, heated and refluxed for 12 hours under a nitrogen stream. When the reaction was terminated, a solid produced by pouring hexane to the reactant was filtered and then, dissolved in a mixed solution of toluene and tetrahydrofuran (a volume ratio of 50:50), activated carbon and anhydrous magnesium sulfate were added thereto, and the mixture was agitated. The solution was filtered and recrystallized by using dichloromethane and hexane, obtaining 7.8 g of a compound A (a yield of 60 %).

### Second Step: Synthesis of Compound Represented by Chemical Formula 4

3.5 g (8.55 mmol) of an intermediate product represented by the compound A, 2.74 g (10.26 mmol) of 2-chloro-4,6-diphenyl-pyrimidine, NaH and dimethylformamide were put in a 100 mL round flask and agitated at room temperature under a nitrogen stream. Then, an organic solvent was removed from the resultant under reduced pressure distillation, and 3.823 g (a yield: 70 %) of a compound represented by Chemical Formula 4 was separated therefrom through column chromatography (Elemental analysis result of the compound represented by Chemical Formula 4: calcd. C₄₆H₃₀N₄: C, 86.49; H, 4.73; N, 8.77; found: C, 86.24; H, 4.89; N, 8.55).

### Example 2: Synthesis of Compound Represente by Chemical Formula 5

A compound represented by the above Chemical Formula 5 as specific examples of a compound for an organic optoelectric device according to the present invention was synthesized through a method provided in the following Reaction Scheme 2.

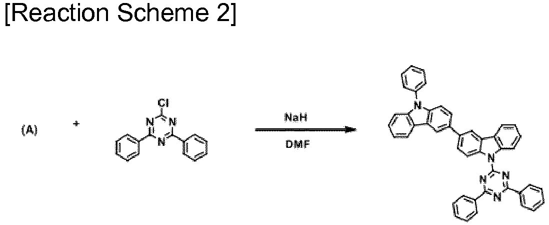

### Synthesis of Compound Represented by Chemical Formula 5

3.5 g (8.55 mmol) of an intermediate product represented by thecompound A, 2.74 g (10.26 mmol) of 2-chloro-4,6-dibiphenyl-pyrimidine, NaH and dimethylformamide were put in a 100 mL round flask and then, agitated at room temperature under a nitrogen stream. Then, an organic solvent was removed from the resultant under reduced pressure distillation, and 4.1 g (a yield: 75 %) of a compound represented by Chemical Formula 5 was separated therefrom through column chromatography. The elemental analysis result of the obtained compound represented by Chemical Formula 5 was as follows. calcd. C₄₅H₂₉N₅: C, 84.48; H, 4.57; N, 10.95; found: C, 84.24; H, 4.65; N, 10.55

### Example 3: Synthesis of Compound Represente by Chemical Formula 14

A compound represented by the above Chemical Formula 14 as specific examples of a compound for an organic optoelectric device according to the present invention was synthesized through a method provided in the following Reaction Scheme 3.

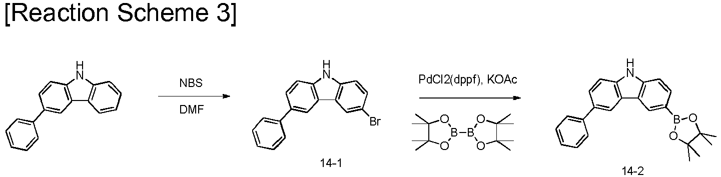

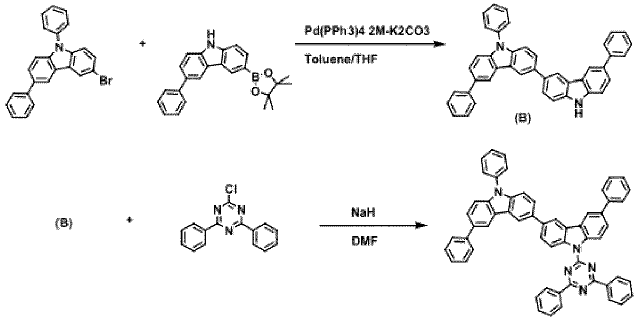

### First Step: Synthesis of Compound 14-1

25 g (0.103 mol) of 3-phenyl-9H-carbazole (EP 10940631A1 Page 15) was dissolved in 250 mL of DMF in a 500 mL round flask, and the solution was agitated therein. Another solution obtained by dissolving 20.5 g (0.113 mol) of N-bromosuccinimide in 100 mL of N,N-dimethyl formamide was slowly added thereto in a dropwise fashion for 8 hours, and the mixture was agitated. The reaction was terminated by pouring the reactant to water, a solid was recrystallized by using dichloromethane and methanol, obtaining 25 g of a compound 14-1 (a yield of 75 %).

### Second Step: Synthesis of Compound 14-2

21.8 g (67.7 mmol) of the compound 14-1, 24.1 g (94.78 mmol) of bispinacolatodiboron, 13.3 g (135.4 mmol) of potassium acetate, and 2.764 g (3.39 mmol) of palladium diphenyl phosphinoferrocene dichloride were dissolved in 300 mL of toluene in a 500 mL round flask, and the solution was heated and refluxed for 12 hours. The reaction was terminated by pouring the reactant to water, an organic layer was separated, twice washed with water, and then, concentrated. The product was separated through column chromatography, obtaining 16 g of a compound 14-2 (6-phenylcarbazol-3-yl boronic acid pinacolate) (a yield: 64 %).

### Third Step: Synthesis of Compound B

5 g (12.6 mmol) of 3-bromo-N-phenyl-6-phenylcarbazole, 5.56 g (15 mmol) of 6-phenylcarbazol-3-yl boronic acid pinacolate, 100 mL of tetrahydrofuran, and a 2 M-potassium carbonate aqueous solution were mixed in a 250 mL round-bottomed flask equipped with an agitator having a nitrogen atmosphere and then, heated and refluxed under a nitrogen stream for 12 hours. When the reaction was terminated, a solid produced by pouring the reactant to hexane was filtered and dissolved in a mixed solution of toluene and tetrahydrofuran (a volume ratio of 50:50), activated carbon and anhydrous magnesium sulfate were added thereto, and the mixture was agitated. The solution was filtered and then, recrystallized by using dichloromethane and hexane, obtaining 6.5 g of a compound B (a yield of 65 %).

### Fourth Step: Synthesis of Compound Represented by Chemical Formula 14

6 g (10.5 mmol) of an intermediate product represented by the compound B, 3.44 g (12.84 mmol) of 2-chloro-4,6-diphenyl-triazine, NaH and dimethylformamide were put in a 250 mL round flask and then, agitated at room temperature under a nitrogen stream. Then, an organic solvent was removed therefrom under a reduced pressure distillation, and column chromatography was performed, obtaining 3.825 g of a compound represented by Chemical Formula 14 (a yield: 70 %).

The elemental analysis result of obtained comound represented by Chemical Formula 14 was as follows. calcd. C₅₇H₃₇N₅: C, 86.45; H, 4.71; N, 8.84; found: C, 86.15; H, 4.57; N, 8.57

### Example 4: Synthesis of Compound Represented by Chemical Formula A-2

A compound represented by the above Chemical Formula A-2 as specific examples of a compound for an organic optoelectric device according to the present invention was synthesized through a method provided in the following Reaction Scheme 4.

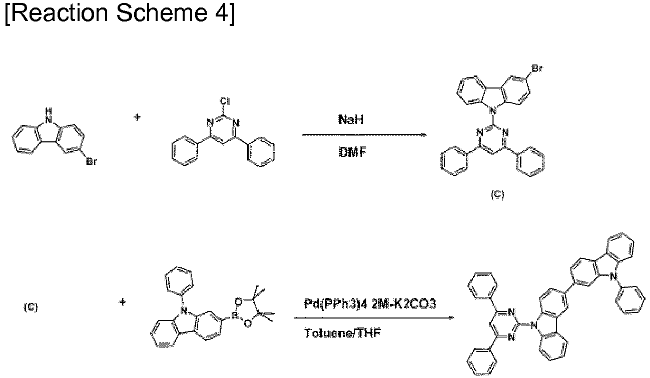

### First Step: Synthesis of Compound C

28.4 g (115.46 mmol) of 3-bromocarbazole, 36.95 g (138.55 mmol) of 2-chloro-4,6-diphenyl-pyrimidine, and 6.93 g of NaH were added to dimethylformamide in a 1000 mL round flask, and the mixture was agitated at room temperature for 12 hours under a nitrogen stream. The reactant was added to distilled water to perform crystallization. The crystallized solid was filtered and recrystallized by using monochlorobenzene and hexane, obtaining 53 g of a compound represented by an intermediate C (a yield: 96 %).

### Second Step: Synthesis of Compound Represented by Chemical Formula A-2

22.26 g (46.7 mmol) of the compound C and 20.71 g (56.1 mmol) of N-phenyl-carbazole boronic acid pinacolate were mixed with 200 mL of tetrahydrofuran, 200ml of toluene and 200ml of a 2M-potassium carbonate aqueous solution in a 1,000 mL round-bottomed flask equipped with an agitator having a nitrogen atmosphere, and the mixture was heated and refluxed for 12 hours under a nitrogen stream. When the reaction was terminated, a solid produced by pouring the reactant to hexane was filtered and dissolved again in a mixed solution of toluene and tetrahydrofuran (a volume ratio of 50:50), activated carbon and anhydrous magnesium sulfate were added thereto, and the mixture was agitated. The solution was filtered and then, recrystallized by using chlorobenzene and methanol, obtaining 20 g of a compound A-2 (a yield: 70 %). (calcd. C₄₆H₃₀N₄: C, 86.49; H, 4.73; N, 8.77; found: C, 86.44; H, 4.74; N, 8.75)

### Example 5: Synthesis of Compound Represented by Chemical Formula A-10

A compound represented by the above Chemical Formula A-10 as specific examples of a compound for an organic optoelectric device according to the present invention was synthesized in a method of the following Reaction Scheme 5.

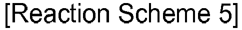

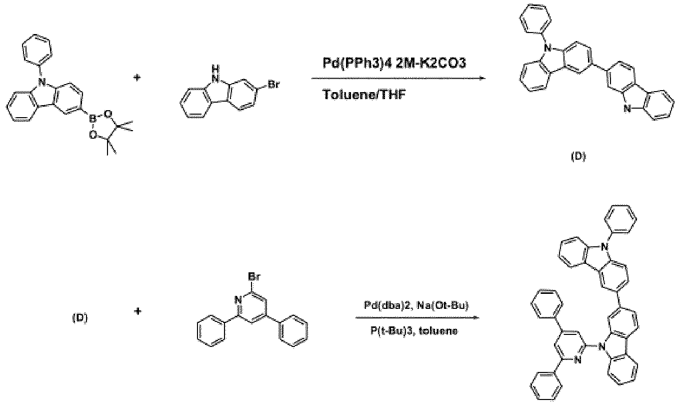

### First Step: Synthesis of Compound Represented by Chemical Formula D

17.66 g (71.7 mmol) of 2-bromo-carbazole, 22.08 g (59.8 mmol) of N-phenyl-carbazole boronic acid pinacolate, 100 mL of tetrahydrofuran and 100 ml of a 2 M-potassium carbonate aqueous solution were mixed in a 500 mL round-bottomed flask equipped with an agitator having a nitrogen atmosphere, and the mixture was heated and refluxed under a nitrogen stream for 12 hours. When the reaction was terminated, a solid produced by pouring hexane to the reactant was filtered and then, dissolved again in a mixed solution of toluene and tetrahydrofuran (a volume ratio of 50:50), activated carbon and anhydrous magnesium sulfate were added thereto, and the mixture was agitated. The solution was filtered and recrystalized by using dichloromethane and hexane, obtaining 19 g of a compound D (a yield: 65 %).

### Second Step: Synthesis of Compound Represented by Chemical Formula A-1 0

8.3 g (20.53 mmol) of the compound D, 7.64 g (24.64 mmol) of 2-bromo-4,6-diphenylpyridine and 3.35 g (34.9 mmol) of tertiarybutoxysodium were dissolved in 200 ml of toluene in a 500 mL round-bottomed flask equipped with an agitator having a nitrogen atmosphere, and 0.47 g (0.51 mmol) of palladium dibenzylideneamine and 0.77ml (1.54 mmol) of tri-tert-butylphosphine were added thereto in a dropwise fashion. The reaction solution was heated at 110 °C and agitated under a nitrogen stream for 12 hours. When the reaction was terminated, a solid produced by pouring methanol to the reactant was filtered and then, dissolved again in chlorobenzene, activated carbon and anhydrous magnesium sulfate were added thereto, and the mixture was agitated. The solution was filtered and recrystallized by using chlorobenzene and methanol, obtaining 11 g of a compound A-10 (a yield: 84 %). (calcd. C₄₇H₃₁N₃: C, 88.51; H, 4.90; N, 6.59; found: C, 88.49; H, 4.91; N, 6.61)

### Example 6: Synthesis of Compound Represented by Chemical Formula A-12

A compound represented by the above Chemical Formula A-12 as specific examples of a compound for an organic optoelectric device according to the present invention was synthesized in a method of the following Reaction Scheme 3.

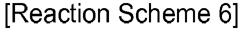

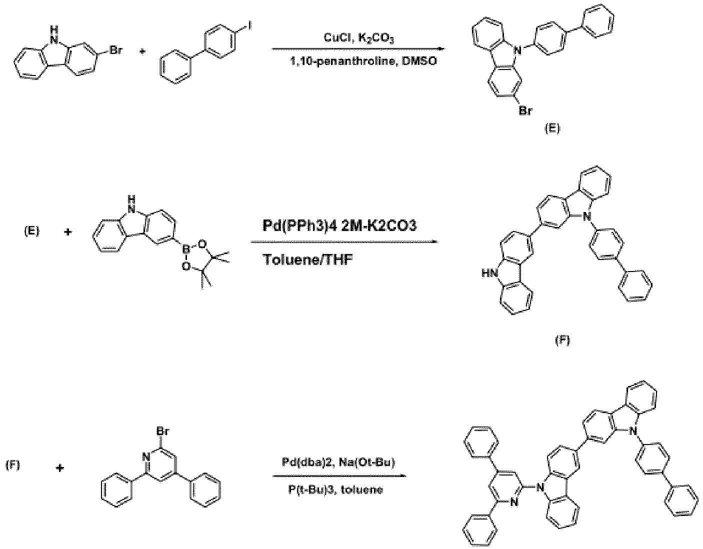

### First step: Synthesis of Compound E

22.22 g (90.3 mmol) of 2-bromocarbazole, 37.94 g (135.5 mmol) of 4-iodobiphenyl and 18.72 g (135.5 mmol) of potassium carbonate were dissolved in 400 ml of dimethylsulfoxide in a 1,000 mL round-bottomed flask equipped with an agitator having a nitrogen atmosphere, and 3.26 g (135.47 mmol) of 1,10-phenanthroline and 1.79 g (18.06 mmol) of copper chloride (I) were added thereto in a dropwise fashion. The reaction solution was heated at 150 °C and agitated under a nitrogen stream for 12 hours. When the reaction was terminated, a solid produced by pouring distilled water to the reactant was filtered and dissolved again in chlorobenzene, activated carbon and anhydrous magnesium sulfate were added thereto, and the mixture was agitated. The solution was filtered and then, recrystallized by using chlorobenzene and methanol, obtaining 25 g of a compound E (a yield: 70 %).

### Second Step: Synthesis of Compound Represented by Chemical Formula F

18.2 g (46.7 mmol) of the compound E and 16.4 g (56.1 mmol) of 3-carbazole boronic acid pinacolate were mixed with 200 mL of tetrahydrofuran, 200 ml of toluene and 200 ml of a 2M-potassium carbonate aqueous solution in a 1,000 mL round-bottomed flask equipped with an agitator having a nitrogen atmosphere, and the mixture was heated and refluxed under a nitrogen stream for 12 hours. When the reaction was terminated, a solid produced by pouring hexane to the reactant was filtered and dissolved in chlorobenzene again, activated carbon and anhydrous magnesium sulfate were added thereto, and the mixture was agitated. The solution was filtered and recrystallized by using chlorobenzene and methanol, obtaining 19.0 g of a compound F (a yield: 64 %).

### Third Step: Synthesis of Compound Represented by Chemical Formula A-12

9.73 g (20.1 mmol) of the compound F, 7.47 g (24.10 mmol) of 2-bromo-4,6-diphenylpyridine and 3.28 g (34.1 mmol) of tertiarybutoxysodium were dissolved in 180 ml of toluene in a 500 mL round-bottomed flask equipped with an agitator having a nitrogen atmosphere, and 0.46 g (0.5 mmol) of palladium dibenzylideneamine and 0.75 ml (1.51 mmol) of tri-tert-butylphosphine were added thereto in a dropwise fashion. The reaction solution was heated and agitated at 110°C for 12 hours under a nitrogen stream. When the reaction was terminated, a solid produced by pouring methanol to the reactant was filtered and dissolved in chlorobenzene again, activated carbon and anhydrous magnesium sulfate were added thereto, and the mixture was agitated. The solution was filtered and then, recrystallized by using chlorobenzene and methanol, obtaining 9.9 g of a compound A-12 (a yield: 70 %). (calcd. C₅₃H₃₅N₃: C, 89.17; H, 4.94; N, 5.89; found: C, 89.29; H, 4.96; N, 5.82.)

### Example 7: Synthesis of Compound Represente by Chemical Formula 3

A compound represented by the above Chemical Formula 3 as specific examples of a compound for an organic optoelectric device according to the present invention was synthesized in a method of the following Reaction Scheme 7.

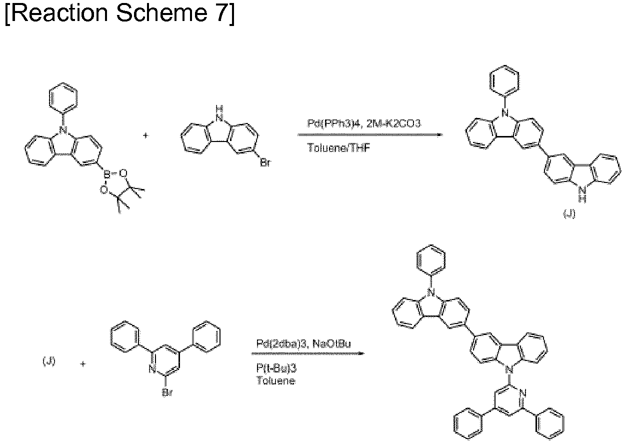

### First Step: Synthesis of Compound J

26.96 g (81.4 mmol) of N-phenyl carbazole-3-boronic acid pinacolate, 23.96 g (97.36 mmol) of carbazole-3-boronic acid, 230 mL of tetrahydrofuran and 100 ml of a 2 M-potassium carbonate aqueous solution were mixed in a 500 mL round-bottomed flask equipped with an agitator having a nitrogen atmosphere and then, heated and refluxed under a nitrogen stream for 12 hours. When the reaction was terminated, a solid produced by pouring methanol to the reactant was filtered and then, dissolved again in chlorobenzene, activated carbon and anhydrous magnesium sulfate were added thereto, and the mixture was agitated. The solution was filtered and recrystallized by using chlorobenzene and methanol, obtaining 22.6 g of a compound J (a yield: 68 %).

### Second Step: Synthesis of Compound Represented by Chemical Formula 3

22.42 g (54.88 mmol) of the compound J, 20.43 g (65.85 mmol) of 2-bromo-4,6-diphenylpyridine and 7.92 g (82.32 mmol) of tertiarybutoxysodium were dissolved in 400 ml of toluene in a 500 mL round-bottomed flask equipped with an agitator having a nitrogen atmosphere, and 1.65 g (1.65 mmol) of palladium dibenzylideneamine and 1.78 g (4.39 mmol) of tri-tert-butylphosphine were added thereto in a dropwise fashion. The reaction solution was heated and agitated at 110 °C for 12 hours under a nitrogen stream. When the reaction was terminated, a solid produced by pouring methanol to the reactant was filtered and dissolved again in chlorobenzene, activated carbon and anhydrous magnesium sulfate were added thereto, and the mixture was agitated. The solution was filtered and then, recrystallized by using chlorobenzene and methanol, obtaining 28.10 g of a compound represented by Chemical Formula 3 (a yield: 80 %). (calcd. C₄₇H₃₁N₃: C, 88.51; H, 4.90; N, 6.59; found: C, 88.62; H, 4.80; N, 6.47)

### Example 8: Synthesis of Compound Represented by Chemical Formula 54

A compound represented by the above Chemical Formula 54 as specific examples of a compound for an organic optoelectric device according to the present invention was synthesized in a method of the following Reaction Scheme 8.

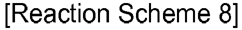

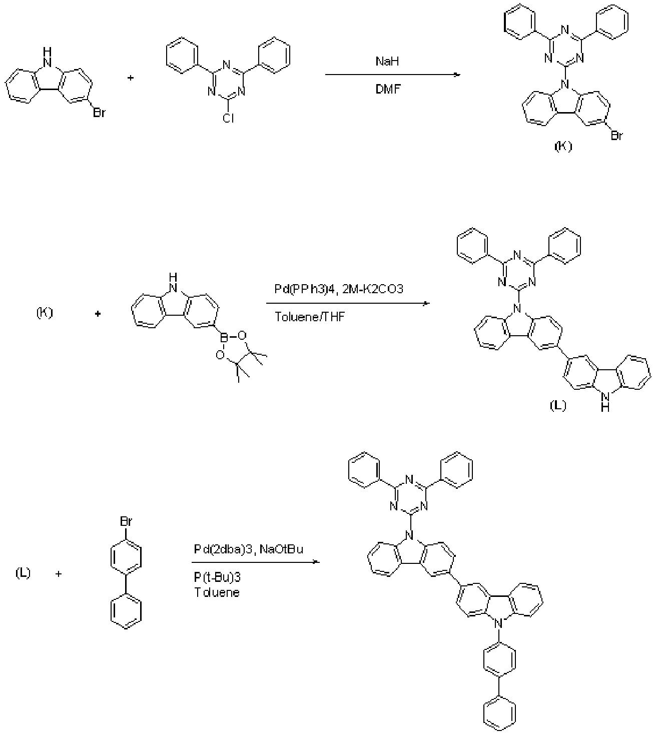

### First Step: Synthesis of Compound K

42.97 g (174.57 mmol) of 3-bromocarbazole, 56.1 g (209.5 mmol) of 2-chloro-4,6-diphenyl-triazine, and 10.48 g (261.86 mmol) of NaH were added to dimethylformamide in a 1000 mL round flask, and the mixture was agitated at room temperature for 12 hours under a nitrogen stream. The reactant was added to distilled water to perform crystallization. The crystallized solid was filtered and then, recrystallized by using monochlorobenzene and hexane, obtaining 82 g of a compound represented by an intermediate K (a yield: 98 %).

### Second Step: Synthesis of Compound L

70.57 g (147.85 mmol) of the compound K, 52.01 g (177.42 mmol) of carbazole-3-boronic acid pinacolate, 800 mL of a mixed solution of tetrahydrofuran and toluene (a volume ratio=1:1) and 400 mL of a 2 M-potassium carbonate aqueous solution were mixed in a 2 L round-bottomed flask equipped with an agitator having a nitrogen atmosphere and then, heated and refluxed under a nitrogen stream for 12 hours. When the reaction was terminated, a solid produced by pouring methanol to the reactant was filtered and dissolved again in chlorobenzene, activated carbon and anhydrous magnesium sulfate were added thereto, and the mixture was agitated. The solution was filtered and then, recrystallized by using chlorobenzene and methanol, obtaining 66 g of a compound L (a yield: 79 %).

### Third Step: Synthesis of Compound Represented by Chemical Formula 54

10.1 g (17.88 mmol) of the compound L, 5 g (21.46 mmol) of 2-bromobiphenyl and 3.44 g (35.76 mmol) of tertiarybutoxysodium were dissolved in 400 ml of toluene in a 1 L round-bottomed flask equipped with an agitator having a nitrogen atmosphere, and 1.03 g (1.79 mmol) of palladium dibenzylideneamine and 2.17 g (5.36 mmol) of tri-tert-butylphosphine were added thereto in a dropwise fashion. The reaction solution was heated and agitated at 110 °C for 12 hours under a nitrogen stream. When the reaction was terminated, a solid produced by pouring methanol to the reactant was filtered and then, dissolved again in chlorobenzene, activated carbon and anhydrous magnesium sulfate were added thereto, and the mixture was agitated. The solution was filtered and recrystallized by using chlorobenzene and methanol, obtaining 9.40 g of a compound represented by Chemical Formula 54 (a yield: 73 %). (calcd. C₅₂H₃₄N₄: C, 87.37; H, 4.79; N, 7.84; found: C, 87.47; H, 4.80; N, 7.78)

### Example 6: Synthesis of Compound Represented by Chemical Formula O-13

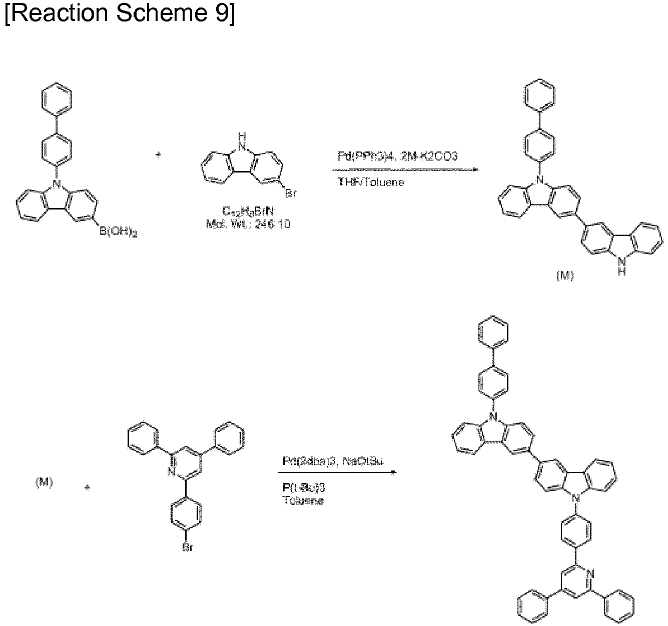

### First Step: Synthesis of Compound M

19.3 g (53.06 mmol) of N-biphenyl-3-carbazole boronic acid and 10.9 g (44.22 mmol) of 3-bromo carbazole were mixed with 140 mL of a mixed solution of tetrahydrofuran and toluene (a volume ratio=1:1) and 80 mL of a 2 M-potassium carbonate aqueous solution in a 500 mL round-bottomed flask equipped with an agitator having a nitrogen atmosphere, and the mixture was heated and refluxed under a nitrogen stream for 12 hours. When the reaction was terminated, a solid produced by pouring methanol to the reactant was filtered and then, dissolved again in chlorobenzene, activated carbon and anhydrous magnesium sulfate were added thereto, and the mixture was agitated. The solution was filtered and recrystallized by using chlorobenzene and methanol, obtaining 13.7 g of a compound M (a yield: 64 %).

### Second Step: Synthesis of Compound Represented by Chemical Formula 0-13

9.6 g (19.82 mmol) of the compound M, 9.2 g (23.8 mmol) of 2-(4-bromophenyl)-4,6-diphenylpyridine (WO2011-081290, Page 36) and 3.2 g (33.7 mmol) of tertiarybutoxysodium were dissolved in 160 mL of toluene in a 500 mL round-bottomed flask equipped with an agitator having a nitrogen atmosphere, and 0.454 g (0.5 mmol) of palladium dibenzylideneamine and 0.6 g (1.49 mmol) of tri-tert-butylphosphine were added thereto in a dropwise fashion. The reaction solution was heated and agitated at 110 °C for 12 hours under a nitrogen stream. When the reaction was terminated, a solid produced by pouring methanol to the reactant was filtered and dissolved again in chlorobenzene, activated carbon and anhydrous magnesium sulfate were added thereto, and the mixture was agitated. The solution was filtered and recrystallized by using chlorobenzene and methanol, obtaining 14 g of a compound 0-13 (a yield: 89 %). (calcd. C₅₉H₃₉N₃: C, 89.70; H, 4.98; N, 5.32; found: C, 89.57; H, 4.83; N, 5.65)

### Example 10: Synthesis of Compound Represente by Chemical Formula T-36

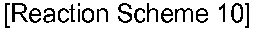

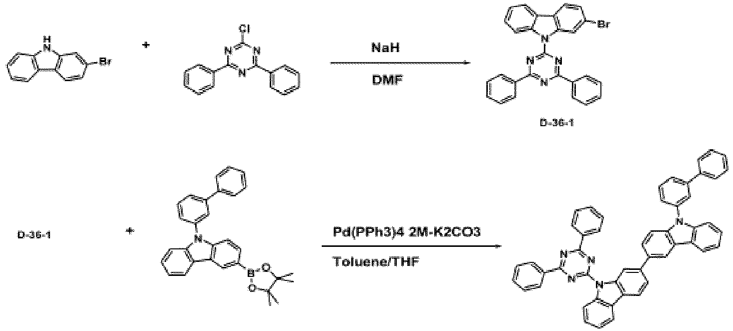

### First Step: Synthesis of Compound Represented by Chemical Formula T-36-1

85.0 g (350.0 mmol) of 2-bromocarbazole, 110.95 g (860.0 mmol) of 2-chloro-4,6-diphenyl-triazine, and 20.72 g of NaH were added to dimethylformamide in a 2000 mL round flask, and the mixture was agitated at room temperature for 12 hours under a nitrogen stream. The reactant was added to distilled water to perform crystallization. The crystallized solid was filtered and then, recrystallized by using monochlorobenzene and hexane, obtaining 138 g of an intermediate compound represented by Chemical Formula T-36-1 (a yield: 84 %).

### Second Step: Synthesis of Compound Represented by Chemical Formula T-36

23.34 g (48.89 mmol) of the compound represented by Chemical Formula D-36-1, 19.53 g (53.78 mmol) of N-(3-biphenyl)-carbazole boronic acid pinacolate, 100 mL of tetrahydrofuran, 100 ml of toluene and 100 ml of a 2 M-potassium carbonate aqueous solution were mixed in a 1,000 mL round-bottomed flask equipped with an agitator having a nitrogen atmosphere and then, heated and refluxed under a nitrogen stream for 12 hours. When the reaction was terminated, a solid produced by pouring hexane to the reactant was filtered and dissolved in a mixed solution of toluene and tetrahydrofuran (a volume ratio of 50:50), activated carbon and anhydrous magnesium sulfate were added thereto, and the mixture was agitated. The solution was filtered and recrystallized by using chlorobenzene and methanol, obtaining 21 g of a compound represented by Chemical Formula T-36 (a yield: 60 %). (calcd. C₅₁H₃₃N₅: C, 85.57; H, 4.65; N,1 9.78 ; found: C, 85.88; H, 4.74; N, 9.71)

### Example 11: Preparation of M-1

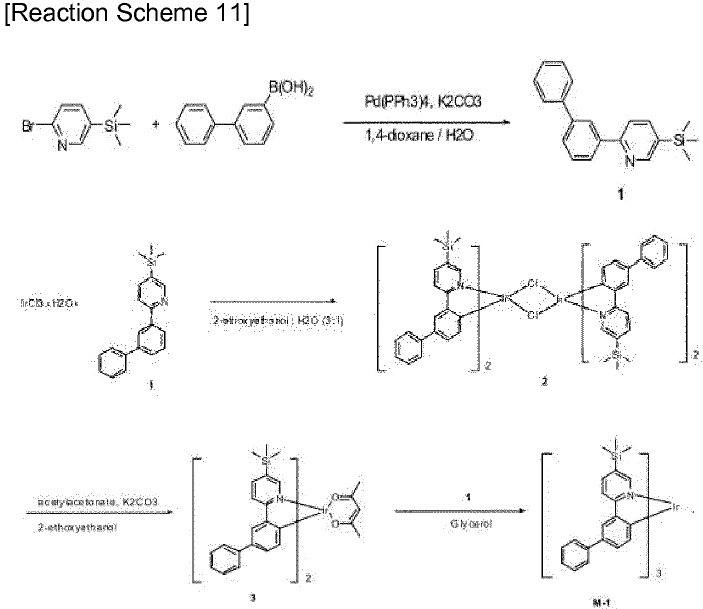

### Preparation of Compound 1

87 g (377.97 mmol) of 5-trimethylsilyl-2-bromopyridine (Organic Electrinics 10 (2009) P.1066-1073), 89.82 g (453.56 mmol) of 3-biphenylboronic acid, 630 mL of 1,4-dioxane, and 378 mL of a 2 M-potassium carbonate aqueous solution were mixed in a 2 L round-bottomed flask equipped with an agitator having a nitrogen atmosphere, 13.1 g (11.34 mmol) of tetrakistriphenyl phosphine palladium (0) was added thereto, and the mixture was heated and refluxed for 12 hours under a nitrogen stream. When the reaction was terminated, an organic layer was separated, and the solvent therein was all removed. The resultant was treated through column chromatography, obtaining 53.34 g of a compound 1 (a yield: 47 %).

### Preparation of Compound 2

22.36 g (74 mmol) of the compound 1, 8.8 g (29 mmol) of iridium chloride, 123 mL of 2-ethoxyethanol, and 41 mL of distilled water were put in a 500 mL round-bottomed flask and then, heated and refluxed for 24 hours. When the reaction was terminated, the resultant was cooled down to room temperature, and then, a solid produced during the reaction was filtered and washed with water and methanol. The solid was dried in a vacuum oven, obtaining 15.8 g of a compound 2 (a yield: 64 %).

### Preparation of Compound 3

23 g (13.95 mmol) of the compound 2, 3.072 g (30.68 mmol) of 2,4-pentanedione, and 14.78 g (139.47 mmol) of sodium carbonate were put in a 500 mL round-bottomed flask and dissolved in 140 mL of 2-ethoxyethanol, and then, the solution was heated and refluxed for 5 hours. When the reaction was terminated, the resultant was cooled down to room temperature, and a solid produced therein was filtered. The solid was treated through column chromatography, obtaining 13 g of a compound 3 (a yield: 52 %).

### Preparation of Compound M-1

13.584 g (15.16 mmol) of the compound 3 and 13.8 g (45.47 mmol) of the compound 1 were dissolved in 150 mL of glycerol in a 250 mL round-bottomed flask, and the solution was heated and refluxed at 220 °C for 12 hours. The reaction was terminated by pouring water to the reactant, and a solid produced therein was filterd. The solid was washed with water and methanol and then, dissolved in dichloromethane, separated through column chromatography, and recrystalized, obtaining 9 g of a compound M-1 (a yield: 27 %). (calcd. C₆₀H₆₀IrN₃Si₃: C, 65.54; H, 5.50; Ir, 17.48; N, 3.82; Si, 7.66; found: C, 65.62; H, 5.53; N, 3.91;)

### Example 12: Preparation of P-2

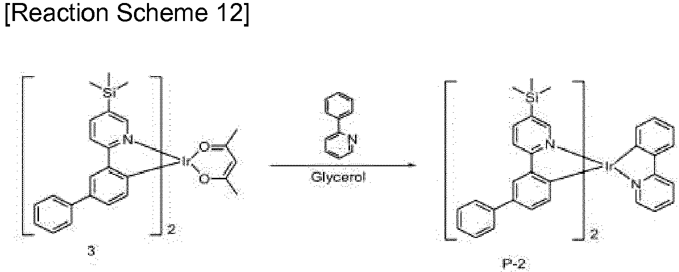

### Preparation of Compound P-2

30.0 g (33.48 mmol) of the compound 3 of Example 11 and 15.58 g (100.44 mmol) of 2-phenylpyridine were dissolved in a 300 mL of glycerol in a 250 mL round-bottomed flask, and the solution was heated and refluxed at 220 °C for 12 hours. The reaction was terminated by pouring water to the reactant, and a solid produced therein was filtered. The solid was washed with water and methanol and then, dissolved in dichloromethane, separated through column chromatography, and recrystallized, obtaining 9.54 g of a compound P-2 (a yield: 30 %).
calcd. C₅₁H₄₈IrN₃Si₂: C, 64.39; H, 5.09; Ir, 20.20; N, 4.42; Si, 5.90; found: C, 64.28; H, 5.04; N, 4.44;

### Example 13: Preparation of P-3

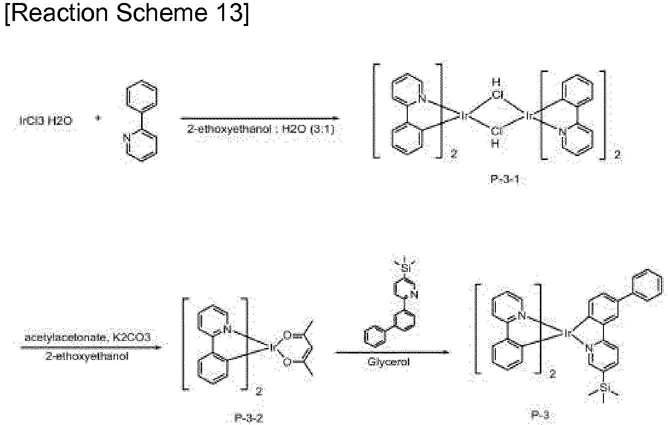

### Preparation of Compound P-3-1

79.32 g (511.10 mmol) of 2-phenylpyridine, 61.04 g (204.44 mmol) of iridium chloride, 852 mL of 2-ethoxyethanol, and 283 mL of distilled water were put in a 100 mL round-bottomed flask and then, heated and refluxed for 24 hours. When the reaction was terminated, the resultant was cooled down to room temperature, and a solid produced during the reaction was filtered and then, washed with water and methanol. The solid was dried in a vacuum oven, obtaining 80 g of a compound P-3-1 (a yield: 73 %).

### Preparation of Compound P-3-2

80 g (74.62 mmol) of the compound P-3-1, 16.42 g (164.04 mmol) of 2,4-pentanedione, and 79.06 g (746.20 mmol) of sodium carbonate were dissolved in 800 mL of 2-ethoxyethanol in a 2000 mL round-bottomed flask, and the solution was heated and refluxed for 5 hours. When the reaction was terminated, the resultant was cooled down to room temperature, and a solid produced therein was filtered. The solid was treated through column chromatography, obtaining 25.04 g of a compound P-3-2 (a yield: 56 %).

### Preparation of Compound P-3

25.0 g (41.68 mmol) of the compound P-3-2 and 1 37.94 g (125.04 mmol) of the comound according to Example 11 were dissolved in 450 mL of glycerol in a 250 mL round-bottomed flask, and the solution was heated and refluxed at 220 °C for 12 hours. The reaction was terminated by pouring water to the reactant, and a solid produced therein was filtered. The solid was washed with water and methanol, dissolved in dichloromethane, then, separated through column chromatography, and recrystallized, obtaining 10.71 g of a compound P-3 (a yield: 32 %).
calcd. C₄₂H₃₆IrN₃Si: C, 62.82; H, 4.52; Ir, 23.94; N, 5.23; Si, 3.50; found: C, 62.79; H, 4.50; N, 5.20;

### Example 14: Preparation of Compound P-11

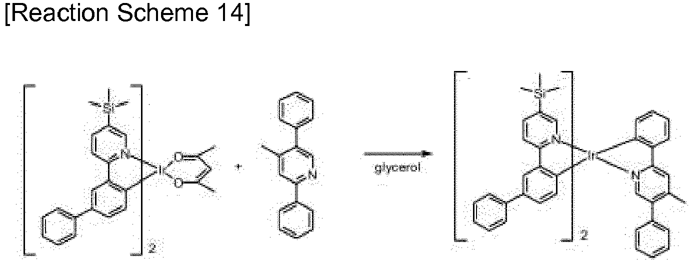

5 g of a compound P-11 (a yield: 31 %) was synthesized by using 13.001 g (14.51 mmol) of the compound 3 according to Example 11 and 10.679 g (43.53 mmol) of a compound K-1-1 (KR2011-0065496A, P. 87) in a 250 mL round-bottomed flask according to the same method as the method of manufacturing the compound M-1.
calcd. C₅₈H₅₄IrN₃Si₂: C, 66.89; H, 5.23; Ir, 18.46; N, 4.03; Si, 5.39; found: C, 66.92; H, 5.24; N, 4.09;

### Example 15: Preparation of Compound P-12

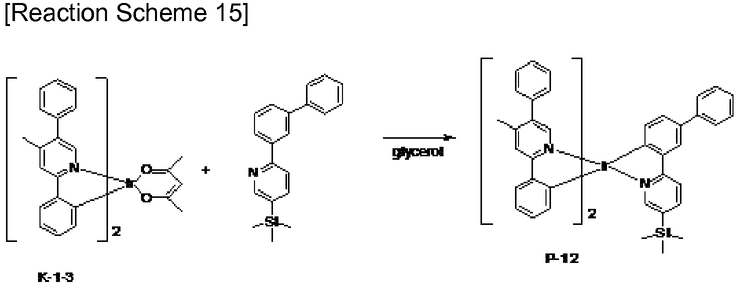

4.8 g of a compound P-12 (a yield: 30 %) was synthesized by using 16.2 g (37.67 mmol) of a compound K-1-3 and 34.3 g (113.02 mmol) of the compound 1 according to Example 11 in a 250 mL round-bottomed flask according to the same method as the method of manufacturing the compound M-1.
calcd. C₅₆H₄₈IrN₃Si: C, 68.40; H, 4.92; Ir, 19.55; N, 4.27; Si, 2.86; found: C, 68.50; H, 4.90; N, 4.29;

### Example 16: Preparation of Compound P-10

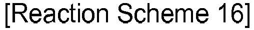

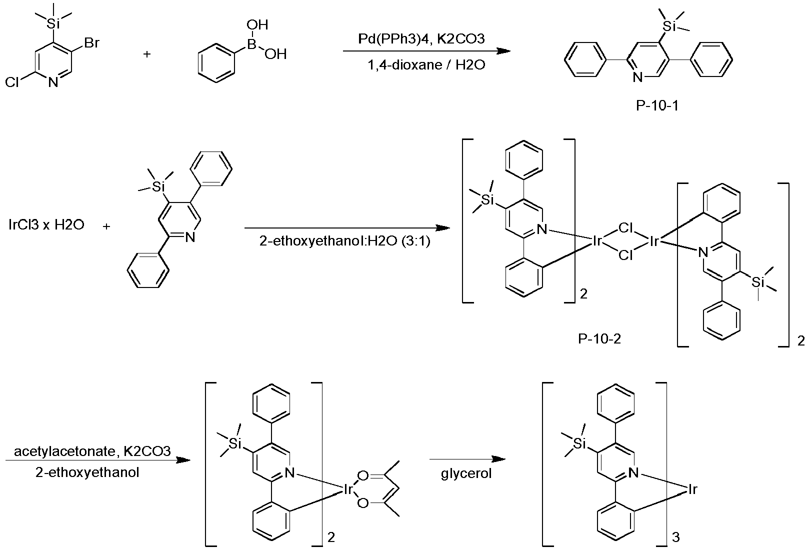

### Preparation of Compound P-10-1

130.11 g (491.27 mmol) of 5-bromo-2-chloro-4-trimethylsilylpyridine (AC2A0F7FP, AINNOS, ABI Chem,), 118.06 g (968.24 mmol) of phenylboronic acid, 560 mL of THF, 560 mL of toluene, and 560 mL of a 2.5 M-potassium carbonate aqueous solution were mixed in a round-bottomed flask equipped with an agitator having anitrogen atmosphere, 24.32 g (21.05 mmol) of tetrakistriphenylphosphinepalladium (0) was added thereto, and the mixture was heated and refluxed for 12 hours under a nitrogen stream. When the reaction was terminated, an organic layer was separated, and a solvent remaining there was all removed. The product was treated through column chromatography, obtaining 83.04 g of a compound P-10-1 (a yield: 65 %).

### Preparation of Compound P-10-2

35.57 g (117.22 mmol) of the compound P-10-1, 14.01 g (46.89 mmol) of iridium chloride, 195 mL of 2-ethoxyethanol, and 65 mL of distilled water were put in a 500 mL round-bottomed flask and then, heated and refluxed for 24 hours. When the reaction was terminated, the resultant was cooled down to room temperature, and a solid produced during the reaction was filtered and washed with water and methanol. The product was dried in a vacuum oven, obtaining 27.5 g of a compound P-10-2 (a yield: 70 %).

### Preparation of Compound P-10-3

23 g (13.95 mmol) of the compound P-10-2, 3.072 g (30.68 mmol) of 2,4-pentanedione, and 14.78 g (139.47 mmol) of sodium carbonate were dissolved in 140 mL of 2-ethoxyethanol in a 500 mL round-bottomed flask, and the solution was heated and refluxed for 5 hours. When the reaction was terminated, the resultant was cooled down to room temperature, and a solid produced therein was filtered. The solid was treated through column chromatography, obtaining 13 g of a compound P-10-3 (a yield: 52 %).

### Preparation of Compound P-10

6.37 g of a compound P-10 (a yield: 40 %) was synthesized by using 13 g (14.49 mmol) of the compound P-10-3 and 13.19 g (43.48 mmol) of the compound P-10-1 in a 500 mL round-bottomed flask according to the same method as the method of manufacturing the compound M-1.
calcd. C₆₀H₆₀IrN₃Si₃: C, 65.54; H, 5.50; Ir, 17.48; N, 3.82; Si, 7.66; found: C, 65.62; H, 5.60; N, 3.90;

### Example 17: Preparation of P-13

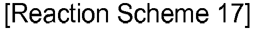

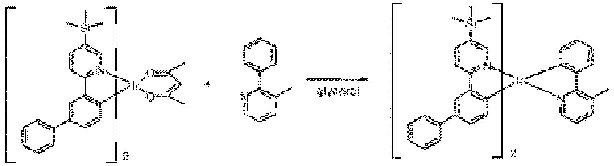

6.13 g of a compound P-13 (a yield: 38 %) was synthesized by using 3 15 g (16.72 mmol) of the compound according to Example 11 and 8.49 g (50.17 mmol) of 3-methyl-2-phenylpyridine (TCI M0932) in a 250 mL round-bottomed flask according to the same method as the method of manufacturing the compound M-1.
calcd. C₅₂H₅₀IrN₃Si₂: C, 64.70; H, 5.22; Ir, 19.91; N, 4.35; Si, 5.82; found: C, 64.80; H, 5.27; N, 4.45;

### Example 18: Preparation of Compound P-14

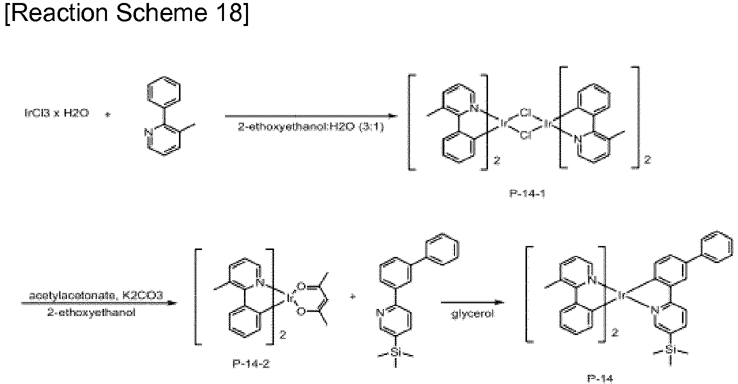

### Preparation of Compound P-14-1

99.12 g (586.11 mmol) of 3-methyl-2-phenylpyridine, 70.0 g (234.44 mmol) of iridium chloride, 976 mL of 2-ethoxyethanol, and 326 mL of distilled water were put in a 2 L round-bottomed flask and then, heated and refluxed for 24 hours. When the reaction was terminated, the resultant was cooled down to room temperature, and a solid produced therein during the reaction was filtered and washed with water and methanol. The solid was dried in a vacuum oven, obtaining 90.5 g of a compound P-14-1 (a yield: 68 %).

### Preparation of Compound P-14-2

90.5 g (80.22 mmol) of the compound P-14-1, 17.67 g (176.48 mmol) of 2,4-pentanedione, and 110.87 g (802.18 mmol) of sodium carbonate were dissolved in 850 mL of 2-ethoxyethanol in a 2 L round-bottomed flask, and the solution was heated and refluxed for 5 hours. When the reaction was terminated, the resultant was cooled down to room temperature, and a solid produced therein was filtered. The solid was treated through column chromatography, obtaining 39.57 g of a compound P-14-2 (a yield: 51 %).

### Preparation of Compound P-14

24.13 g of a compound P-14 (a yield: 36 %) was synthesized by using 39 g (80.64 mmol) of the compound P-14-2 and 73.42 g (241.92 mmol) of the compound 1 according to Example 11 in a 1 L round-bottomed flask according to the same method as the method of preparing the compound M-1.
calcd. C₄₄H₄₀IrN₃Si: C, 63.59; H, 4.85; Ir, 23.13; N, 5.06; Si, 3.38; found: C, 63.68; H, 4.93; N, 5.13;

### Example 19: Preparation of Compound C-1

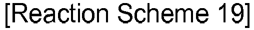

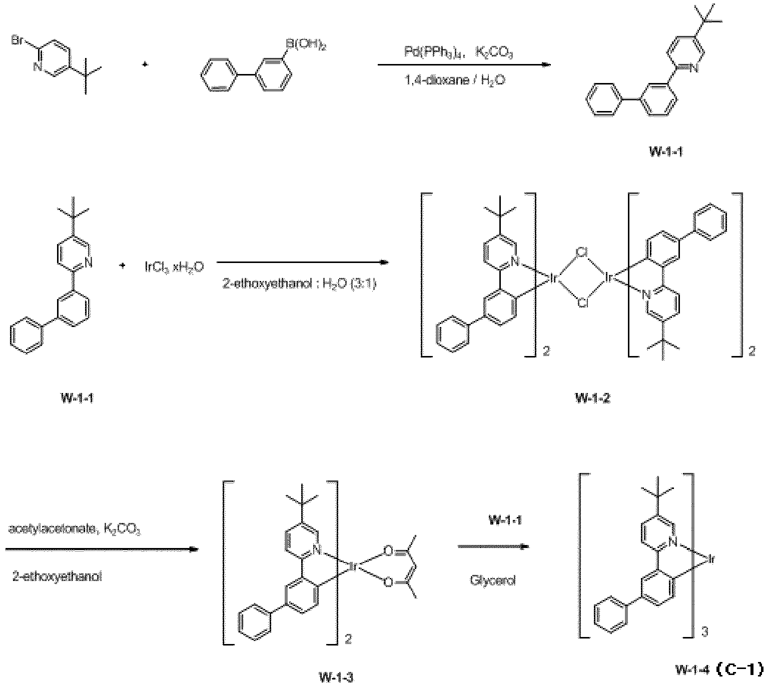

(The compound W-1-4 is represented by Chemical Formula C-1 in the specification.)

### Preparation of Compound W-1-1

88.99 g (415.77 mmol) of 2-bromo-5-tert-butylpyridine (P10255, Afferchem Inc.), 98.80 g (498.92 mmol) of 3-biphenylboronic acid, 693 mL of 1,4-dioxane, and 416 mL of a 2 M-potassium carbonate aqueous solution were mixed in a 2 L round-bottomed flask equipped with an agitator having a nitrogen atmosphere, 14.41 g (12.47 mmol) of tetrakistriphenylphosphinepalladium (0) was added thereto, and the mixture was heated and refluxed for 12 hours under a nitrogen stream. When the reaction was terminated, an organic layer was separated, and a solvent therein was all removed. The obtained solid was treated through column chromatography, obtaining 52.58 g of a compound W-1-1 (a yield: 44 %).

### Preparation of Compound W-1-2

32.75 g (113.96 mmol) of the compound W-1-1, 13.55 g (44.66 mmol) of iridium chloride, 190 mL of 2-ethoxyethanol, and 63 mL of distilled water were put in a 500 mL round-bottomed flask and then, heated and refluxed for 24 hours. When the reaction was terminated, the resultant was cooled down to room temperature, and a solid produced during the reaction was filtered and washed with water and methanol. The solid was drined in a vacuum oven, obtaining 27.3 g of a compound W-1-2 (a yield: 60 %).

### Preparation of Compound W-1-3

24.57 g (15.35 mmol) of the compound W-1-2, 3.38 g (33.75 mmol) of 2,4-pentanedione, and 16.26 g (153.42 mmol) of sodium carbonate were dissolved in 154 mL of 2-ethoxyethanol in a 500 mL round-bottomed flask, and the solution was heated and refluxed for 5 hours. When the reaction was terminated, the resultant was cooled down to room temperature, and a solid produced therein was filtered. The solid was treated through column chromatography, obtaining 14.41 g of a compound W-1-3 (a yield: 54 %).

### Preparation of Compound W-1-4

14.41 g (16.68 mmol) of the compound W-1-3 and 14.37 g (50.02 mmol) of the compound W-1 were dissolved in 165 mL of glycerol in a 250 mL round-bottomed flask, and the solution was heated and refluxed at 220 °C for 12 hours. The reaction was terminated by pouring water to the reactant, and a solid produced therein was filtered. The solid was washed with water and methanol, dissolved in dichloromethane, separated through column chromatography, and then, recrystalized, obtaining 6.84 g of a compound W-1-4 (Chemical Formula C-1) (a yield: 39 %). (calcd. C₆₃H₆₀IrN₃: C, 71.97; H, 5.75; Ir, 18.28; N, 4.00; found: C, 71.99; H, 5.53; N, 3.95;)

### Example 20: Preparation of C-13

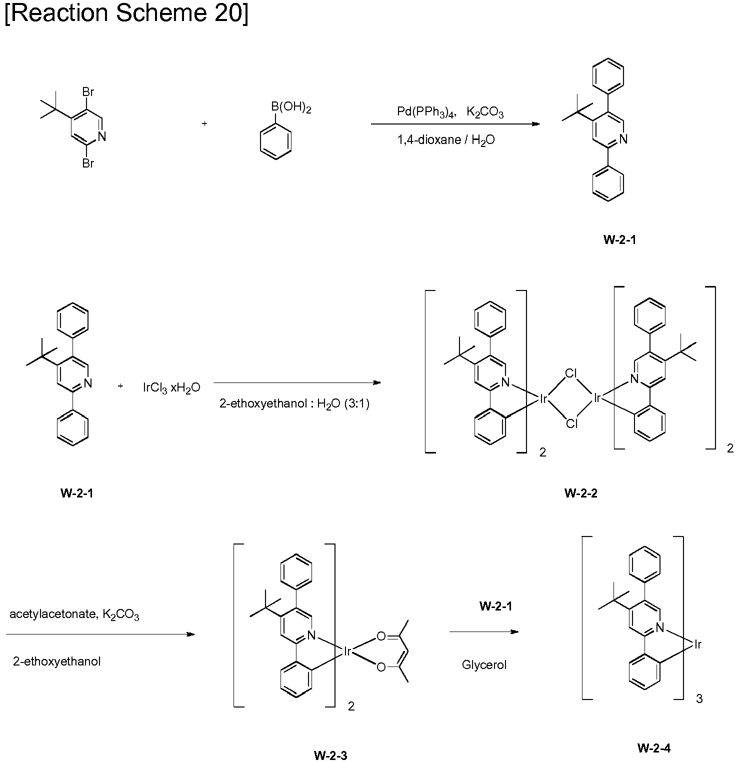

(The compound W-2-4 is represented by Chemical Formula C-13 in the specification.)

### Preparation of Compound W-2-1

214.98 g (733.73 mmol) of 2,5-dibromo-3-tert-butylpyridine (P23033, Afferchem, Inc.), 205.77 g (1687.59 mmol) of boronic acid, 1222 mL of 1,4-dioxane, and 734 mL of a 2 M-potassium carbonate aqueous solution were mixed in a 4 L round-bottomed flask equipped with an agitator having a nitrogen atmosphere, 42.39 g (36.68 mmol) of tetrakistriphenylphosphinepalladium (0) was added thereto, and the mixture was heated and refluxed under a nitrogen stream for 12 hours. When the reaction was terminated, an organic layer was separated, and a solvent therein was all removed. The resultant was treated through column chromatography, obtaining 126.65 g of a compound W-2-1 (a yield: 60 %).

### Preparation of Compound W-2-2

126.65 g (440.67 mmol) of the compound W-2-1, 52.63 g (176.26 mmol) of iridium chloride, 734 mL of 2-ethoxyethanol, and 245 mL of distilled water were heated and refluxed for 24 hours in a 2 L round-bottomed flask. When the reaction was terminated, the resultant was cooled down to room temperature, and a solid produced during the reaction was filtered and washed with water and methanol. The solid was dried in a vacuum oven, obtaining 104.23 g of a compound W-2-2 (a yield: 59 %).

### Preparation of Compound W-2-3

104.23 g (65.12 mmol) of the compound W-2-2, 14.34 g (143.26 mmol) of 2,4-pentanedione, and 90.00 g (651.22 mmol) of sodium carbonate were dissolved in 703 mL of 2-ethoxyethanol in a 2 L round-bottomed flask, and the solution was heated and refluxed for 5 hours. When the reaction was terminated, the resultant was cooled down to room temperature, and a solid produced therein was filtered. The solid was treated through column chromatography, obtaining 39.06 g of a compound W-2-3 (a yield: 35 %).

### Preparation of Compound W-2-4

14.26 g of the compound W-2-4 (Chemical Formula C-13) (a yield: 30 %) was synthesized by using 39.06 g (45.20 mmol) of the compound W-2-3 and 38.98 g (135.62 mmol) of the compound W-2-1 in a 500 mL round-bottomed flask according to the same method as the method of preparing the compound W-1-4.
calcd. C₆₃H₆₀IrN₃: C, 71.97; H, 5.75; Ir, 18.28; N, 4.00; found: C, 72.01; H, 5.80; N, 3.91;

### Example 21: Preparation of Chemical Formula D-1

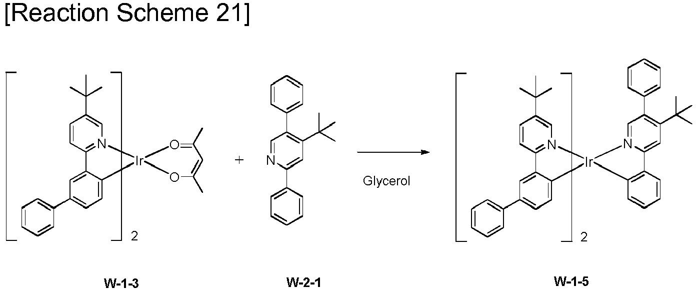

(The compound W-1-5 is represented by Chemical Formula D-1 in the specification.)

7.6 g of a compound W-1-5 (a yield: 31 %) was synthesized by using 18.92 g (21.9 mmol) of compound W-1-3 according to Example 19 and 18.89 g (65.71 mmol) of the compound W-2-1 in a 1000 mL round-bottomed flask according to the same method as the method of preparing the compound W-1-4.
calcd. C₆₃H₆₀IrN₃: C, 71.97; H, 5.75; Ir, 18.28; N, 4.00, found: C, 72.03; H, 5.80; N, 4.02;

### Example 22: Preparation of Compound C-6

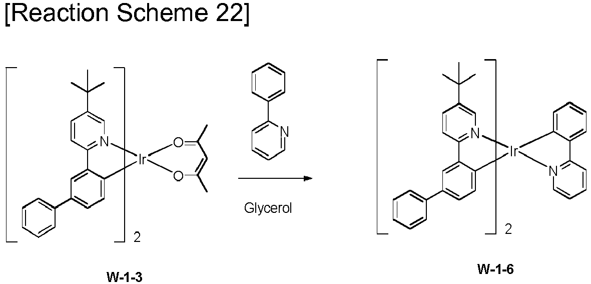

(The compound W-1-6 is represented by Chemical Formula C-6 in the specification.)

### Preparation of Compound W-1-6

10.5 g of a compound W-1-6 (Chemical Formula C-6) (a yield: 35 %) was synthesized by using 28.2 g (32.64 mmol) of the compound W-1-3 and 2-15.2 g (97.92 mmol) of phenylpyridine in a 500 mL round-bottomed flask according to the same method as the method of preparing the compound W-1-4.
calcd. C₅₃H₄₈IrN₃: C, 69.25; H, 5.26; Ir, 20.91; N, 4.57, found: C, 69.30; H, 5.12; N, 4.60;

### Example 23: Preparation of Chemical Formula D-2

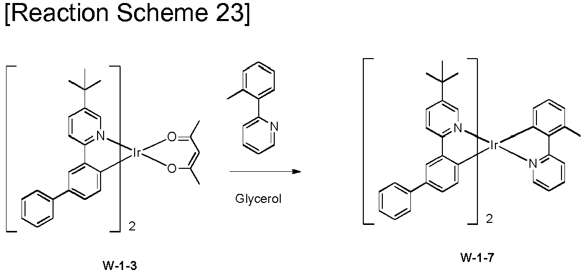

(The compound W-1-7 is represented by Chemical Formula D-2 in the specification.)

### Preparation of Compound W-1-7

9.88 g of a compound W-1-7 (Chemical Formula D-2) (a yield: 32 %) was synthesized according to the same method as the method of preparing the compound W-1-4 by using 28.6 g (33.08 mmol) of the compound W-1-3 and 16.8 g (99.25 mmol) of 2-2'-toluylpyridine in a 500 mL round-bottomed flask.
calcd. C₅₄H₅₀IrN₃C, 69.50; H, 5.40; Ir, 20.60; N, 4.50, found: C, 69.55; H, 5.43; N, 4.61;

### Example 24: Preparation of Chemical Formula D-3

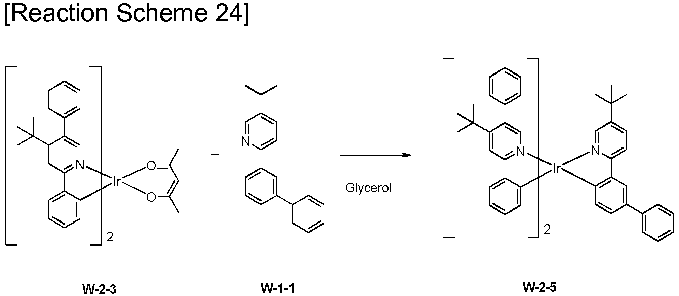

(The compound W-2-5 is represented by Chemical Formula D-3 in the specification.)

6.1 g of a compound W-2-5 (Chemical Formula D-3) (a yield: 31 %) was synthesized by using 16.17 g (18.71 mmol) of the compound W-2-3 and 16.13 g (56.14 mmol) of the compound W-1-1 in a 1000 mL round-bottomed flask according to the same method as the method of preparing the compound W-1-4.
calcd. C₆₃H₆₀IrN₃: C, 71.97; H, 5.75; Ir, 18.28; N, 4.00 found: C, 71.90; H, 5.83; N, 4.12;

### Example 25: Preparation of Compound C-11

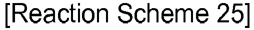

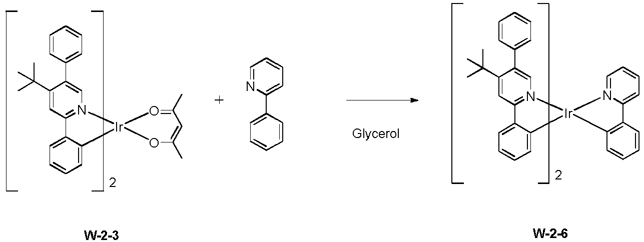

(The compound W-2-6 is represented by Chemical Formula C-11 in the specification.)

### Preparation of Compound W-2-6

9.72 g of a compound W-2-6 (Chemical Formula C-11) (a yield: 36 %) was synthesized by using 25.92 g (29.38 mmol) of the compound W-2-3 and 13.68 g (88.13 mmol) of 2-phenylpyridine in a 500 mL round-bottomed flask according to the same method as the method of preparing the compound W-1-4.
calcd. C₅₃H₄₈IrN₃: C, 69.25; H, 5.26; Ir, 20.91; N, 4.57 found: C, 69.33; H, 5.28; N, 4.63;

### Example 26: Preparation of Chemical Formula D-4

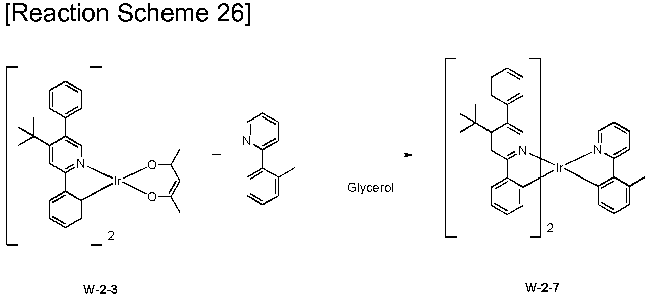

(The compound W-2-7 is represented by Chemical Formula D-4 in the specification.)

### Preparation of Compound W-2-7

8.62 g of a compound W-2-7 (Chemical Formula D-4) (a yield: 32 %) was synthesized by using 25.74 g (29.77 mmol) of the compound W-2-3 and 15.12 g (89.33 mmol) of 2-2'-toluylpyridine in a 500 mL round-bottomed flask according to the same method as the method of preparing the compound W-1-4.
calcd. C₅₄H₅₀IrN₃: C, 69.50; H, 5.40; Ir, 20.60; N, 4.50, found : C, 69.65; H, 5.38; N, 4.62;

### Example 27: Preparation of Compound B-18

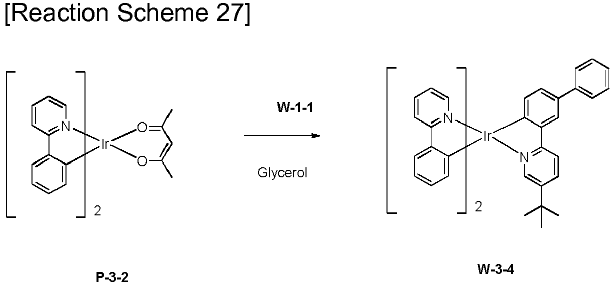

(The compound W-3-4 is represented by Chemical Formula B-18 in the specification.)

### Preparation of Compound W-3-4

11.16 g of a compound W-3-4 (Chemical Formula C-17) (a yield: 36 %) was synthesized by using 23.62 g (39.39 mmol) of the compound P-3-2 and 33.96 g (118.16 mmol) of the compound W-1-1 in a 1000 mL round-bottomed flask according to the same method as the method of preparing the compound W-1-4.
calcd. C₄₃H₃₆IrN₃: C, 65.63; H, 4.61; Ir, 24.42; N, 5.34 found: C, 65.65; H, 4.58; N, 5.42;

### Example 28: Preparation of Compound C-12

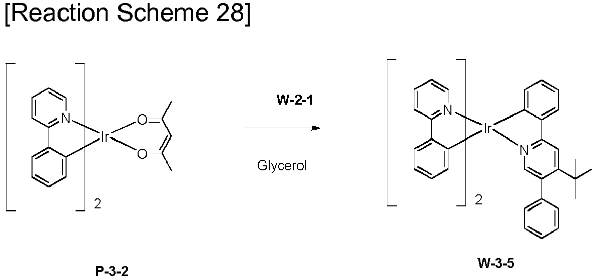

(The compound W-3-5 was represented by Chemical Formula C-12 in the specification.)

### Preparation of Compound W-3-5

9.21 g of a compound W-3-5 (Chemical Formula C-12) (a yield: 33 %) was synthesized by using 21.26 g (35.45 mmol) of the compound P-3-2 and 30.56 g (106.34 mmol) of the compound W-2-1 in a 1000 mL round-bottomed flask according to the same method as the method of preparing the compound W-1-4.
calcd. C₄₃H₃₆IrN₃: C, 65.63; H, 4.61; Ir, 24.42; N, 5.34, found : C, 65.67; H, 4.68; N, 5.32;

### Example 29: Preparation of Chemical Formula D-5

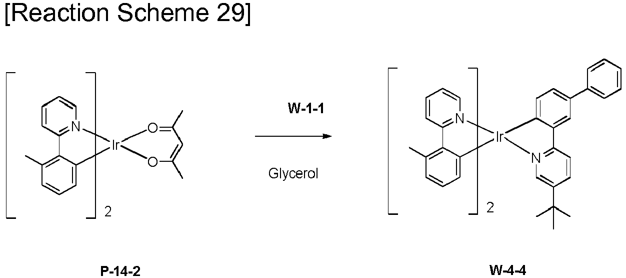

(The compound W-4-4 is represented by Chemical Formula D-5 in the specification.)

### Preparation of Compound W-4-4

9.20 g of a compound W-3-4 (Chemical Formula D-5) (a yield: 29 %) was synthesized by using 24.44 g (38.93 mmol) of the compound P-14-2 and 33.57 g (116.80 mmol) of the compound W-1-1 in a 1000 mL round-bottomed flask according to the same method as the method of preparing the compound W-1-4.
calcd. C₄₆H₄₀IrN₃: C, 66.31; H, 4.95; Ir, 23.58; N, 5.16, found: C, 66.27; H, 4.98; N, 5.12;

### Example 30: Preparation of Chemical Formula D-6

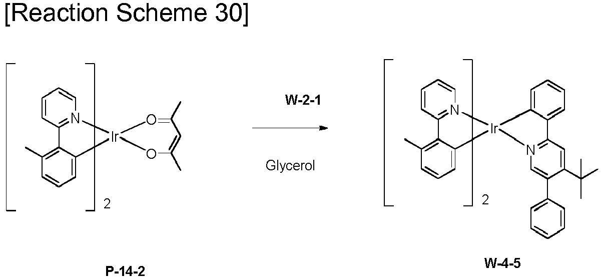

(The compound W-4-5 is represented by Chemical Formula D-6 in the specification.)

### Preparation of Compound W-4-5

8.57 g of a compound W-4-5 (Chemical Formula D-6) (a yield: 30 %) was synthesized by using 22.00 g (35.04 mmol) of the compound P-14-2 and 30.21 g (105.12 mmol) of the compound W-2-1 in a 1000 mL round-bottomed flask according to the same method as the method of preparing the compound W-1-4.
calcd. C₄₅H₄₀IrN₃: C, 66.31; H, 4.95; Ir, 23.58; N, 5.16, found: C, 66.30; H, 4.99; N, 5.22;

### (Manufacture of Organic Light Emitting Diode)

### ComparisonPreparation Example 1

A glass substrate coated with a ITO (Indium tin oxide) to be1500 A-thick was washed with a distilled water ultrasonic wave. When the washing with distilled water was terminated, the coated glass substrate was ultrasonic wave-washed with a solvent such as isopropyl alcohol, acetone, methanol and the like, dried, delivered to a plasma cleaner, washed for 5 minutes by using an oxygen plasma, and then, delivered to a vacuum depositor. The ITO transparent electrode was used as an anode, and HTM (N-(biphenyl-4-yl)-9,9-diphenyl-N-(4-(9-phenyl-9H-carbazole)-3-yl)phenyl)9H-fluorene-2-amine) represented by the following Chemical Formula Z-1 was deposited on the ITO substrate to form a 1200 A-thick hole injection layer (HIL).

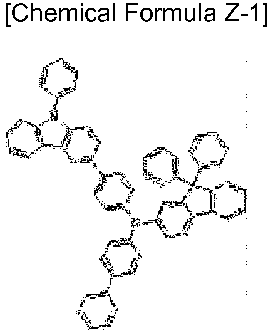

On the hole transport layer (HTL), CBP as a host doped with 7 wt% of PhGD (tris(3-methyl-2-pyridine)iridium) represented by the following Chemical Formula Z-2 as a green phosphorescent dopant was vacuum-deposited to form a 300 A-thick emission layer.

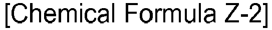

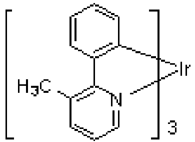

Then, on the emission layer upper, 50 A-thick BAlq (bis(2-methyl-8-quinolinolato-N1,O8)-(1,1'-biphenyl-4-olato)aluminum)) represented by the following Chemical Formula Z-3 and 250 A-thick Alq3 (tris(8-hydroxyquinolinato)aluminium) represented by and the following Chemical Formula Z-4 were sequentially stacked, forming an electron transport layer (ETL). On the electron transport layer (ETL), 5 A-thick LiF and 1000 A-thick Al were sequentially vacuum-deposited to form a cathode, manufacturing an organic light emitting diode.

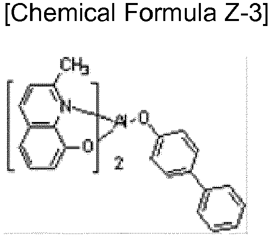

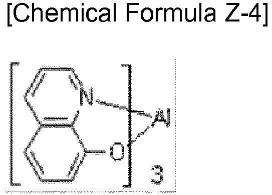

### Preparation Example 1

An organic light emitting diode was manufactured according to the same method as Comparative Example 1 except for using the compound synthesized in Example 10 instead of the compound according to Comparison Preparation Example 1 as a host for an emission layer and the compound synthesized in Example 11 instead of the dopant used in Comparative Example 1.

### Preparation Example 2

An organic light emitting diode was manufactured according to the same method as Preparation Example 1 except for using the compound synthesized in Example 12 instead of the compound synthesized in Example 11 as a dopant for an emission layer.

### Preparation Example 3

An organic light emitting diode was manufactured according to the same method as Preparation Example 1 except for using the compound synthesized in Example 13 instead of the compound synthesized in Example 11 as a dopant for an emission layer.

### Preparation Example 4

An organic light emitting diode was manufactured according to the same method as Preparation Example 1 except for using the compound synthesized in Example 14 instead of the compound synthesized in Example 11 as a dopant for an emission layer.

### Preparation Example 5

An organic light emitting diode was manufactured according to the same method as Preparation Example 1 except for using the compound synthesized in Example 15 instead of the compound synthesized in Example 11 as a dopant for an emission layer.

### Preparation Example 6

An organic light emitting diode was manufactured according to the same method as Preparation Example 1 except for using the compound synthesized in Example 12 instead of the compound synthesized in Example 11 as a dopant for an emission layer and the compound synthesized in Example 2 instead of the compound used in Preparation Example 1 as a host for an emission layer.

### Preparation Example 7

An organic light emitting diode was manufactured according to the same method as Preparation Example 1 except for using the compound synthesized in Example 13 instead of the compound synthesized in Example 12 as a dopant for an emission layer.

### Preparation Example 8

An organic light emitting diode was manufactured according to the same method as Preparation Example 1 except for using the compound synthesized in Example 12 instead of the compound synthesized in Example 11 as a dopant for an emission layer and the compound synthesized in Example 1 instead of the compound used in Preparation Example 1 as a host for an emission layer.

### Preparation Example 9

An organic light emitting diode was manufactured according to the same method as Preparation Example 8 except for using the compound synthesized in Example 13 instead of the compound synthesized in Example 12 as a dopant for an emission layer.

### (Performance Measurement of Organic Light Emitting Diode)

### Experimental Example 1

Current density change, luminance change, and luminous efficiency of each organic light emitting diode according to the Preparation Examples 1 to 9 and Comparison Preparation Example 1 depending on a voltage were measured. Specific measurement methods are as follows, and the results are shown in the following Table 1.

### (1) Measurement of Current Density Change Depending on Voltage Change

The obtained organic light emitting diodes were measured for current value flowing in the unit device while increasing the voltage from 0 V to 10 V using a current-voltage meter (Keithley 2400), and the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Luminous Efficiency

The luminance, current density, and voltage obtained from the (1) and (2) were used to calculate current efficiency (cd/A) at the same luminance (9000 cd/m²).

### (4) Measurement of Life-span

A decreasing time of a current efficiency (cd/A) was measured maintaining luminance (cd/m²) at 6000 cd/m².

**[Table 1]**

| | Host material of emission layer | Dopant material of emission layer | Driving voltage (V) | 6000 cd/m² | |
|---|---|---|---|---|---|
| | | | | Luminous efficiency (cd/A) | Life-span (h,T97%) |
| Comparative Example 1 | CBP | Z-2 | 8 | 46 | 1 |
| Preparation Example 1 | Example 10 | Example 11 | 4.39 | 55 | 60 |
| Preparation Example 2 | Example 10 | Example 12 | 4.43 | 49.8 | 55 |
| Preparation Example 3 | Example 10 | Example 13 | 4.36 | 48.4 | 58 |
| Preparation Example 4 | Example 10 | Example 14 | 4.61 | 47.8 | 50 |
| Preparation Example 5 | Example 10 | Example 15 | 4.62 | 46.1 | 55 |
| Preparation Example 6 | Example 2 | Example 12 | 4.26 | 50.2 | 63 |
| Preparation Example 7 | Example 2 | Example 13 | 4.25 | 50.0 | 57 |
| Preparation Example 8 | Example 1 | Example 12 | 4.24 | 50.2 | 59 |
| Preparation Example 9 | Example 1 | Example 13 | 4.13 | 51.5 | 55 |

Referring to Table 1, the organic light emitting diodes manufactured by using a material provided in the present invention showed much excellent driving voltage and efficiency compared with an organic light emitting diodes manufactured by using CBP as a reference material in terms of luminous efficiency. In addition, when a life-span was evaluated by measuring how much time it took until luminous efficiency decreased by 3 %, the organic light emitting diodes manufactured by using a compound provided in the present invention showed life-span ranging from 30 hours to 63 hours at most, while the organic light emitting diode manufactured by using CBP showed sharply-decreased life-span of less than one hour. As shown in the aforementioned device characteristics, the compound manufactured in the present invention may be used as a satisfactory material for an organic light emitting diode.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims. Therefore, the aforementioned embodiments should be understood to be exemplary but not limiting the present invention in any way.

**<Description of Symbols>**

| | | | |
|---|---|---|---|
| 100 : | organic light emitting diode | 110 : | cathode |
| 120 : | anode | 105 : | organic thin layer |
| 130 : | emission layer | 140 : | hole transport layer (HTL) |
| 230 : | emission layer + electron transport layer (ETL) | | |

## Claims

1. A composition for an organic light emitting diode, comprising:
a compound for an organic optoelectric device represented by the following Chemical Formula S-1 and a compound for an organic optoelectric device represented by the following Chemical Formula X-1: 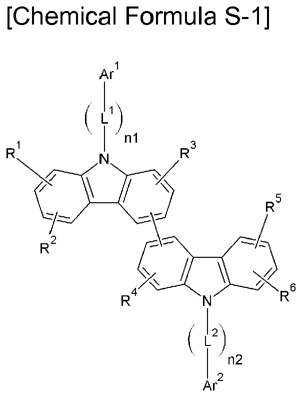
wherein, in the above Chemical Formula S-1,
Ar¹ and Ar² are independently a substituted or unsubstituted C6 to C30 aryl group or a substituted or unsubstituted C2 to C30 heteroaryl group,
at least one of the Ar¹ or Ar² is a substituted or unsubstituted C2 to C30 heteroaryl group having electron characteristics,
L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 and n2 are independently integers of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, 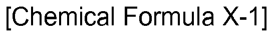 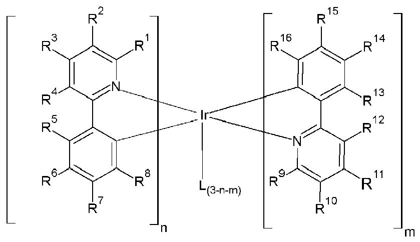
wherein, in the above Chemical Formula X-1,
R¹ to R¹⁶ are independently hydrogen, deuterium, a substituted or unsubstituted C1 to C10 alkyl group, a substituted or unsubstituted C6 to C20 aryl group, or -SiR¹⁷R¹⁸R¹⁹,
the R¹⁷ to R¹⁹ are independently a C1 to C6 alkyl group,
at least one of the R¹ to R⁸ is a functional group represented by the following Chemical Formula X-2,
at least one of the R⁹ to R¹⁶ is a functional group represented by the following Chemical Formula X-2,
L is a bidentate ligand of a monovalent anion, and is a ligand coordination-bonding with iridium through unshared electron pair of carbon or heteroatom, and
n and m are independently integers of 0 to 3, and n + m is one of integers of 1 to 3, 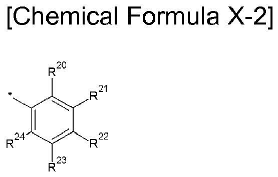
wherein, in the above Chemical Formula X-2,
R²⁰ to R²⁴ are independently hydrogen, deuterium, a substituted or unsubstituted C1 to C10 alkyl group, a substituted or unsubstituted C6 to C20 aryl group, or -SiR¹⁷R¹⁸R¹⁹, and
* is a portion where it linked to a carbon atom,
wherein, in the above Chemical Formulae X-1 and X-2,
one of the R¹ to R¹⁶ and R²⁰ to R²⁴ is -SiR¹⁷R¹⁸R¹⁹ or a tert-butyl group.

2. The composition for an organic light emitting diode of claim 1, wherein in the above Chemical Formula X-1,
n is an integer of 1 to 3
one of the R¹ to R⁴ is -SiR¹⁷R¹⁸R¹⁹ or a tert-butyl group, and the rest of the R¹ to R⁴ is independently hydrogen, deuterium, or a substituted or unsubstituted C1 to C10 alkyl group, and
one of the R⁵ to R⁸ is the the functional group represented by the above Chemical Formula 2, and the rest is independently hydrogen, deuterium, or a substituted or unsubstituted C1 to C10 alkyl group.

3. The composition for an organic light emitting diode of claim 1, wherein in the above Chemical Formula X-1,
m is an integer of 1 to 3,
one of the R⁹ to R¹² is the the functional group represented by the above Chemical Formula 2,
the rest of the R⁹ to R¹² is -SiR¹⁷R¹⁸R¹⁹ or a tert-butyl group, and
the rest of the R⁹ to R¹² and R¹³ to R¹⁶ are independently hydrogen, deuterium, or a substituted or unsubstituted C1 to C10 alkyl group.

4. The composition for an organic light emitting diode of claim 1, wherein in the above Chemical Formula X-1,
n is an integer of 1 to 3,
one of the R¹ to R⁴ is the functional group represented by the above Chemical Formula 2, and the rest of the R¹ to R⁴ is -SiR¹⁷R¹⁸R¹⁹ or a tert-butyl group, and
the rest of the R¹ to R⁴ and R⁵ to R⁸ are independently hydrogen, deuterium, or a substituted or unsubstituted C1 to C10 alkyl group.

5. The composition for an organic light emitting diode of claim 1, wherein in the above Chemical Formula X-1,
one of the R¹ to R⁸ is a functional group represented by the following Chemical Formula 2, and one of the R⁹ to R¹⁶ is a functional group represented by the following Chemical Formula 2,
in the above Chemical Formula 2, one of the R²⁰ to R²⁴ is -SiR¹⁷R¹⁸R¹⁹ or a tert-butyl group, and
the rest of the R¹ to R¹⁶ that is not substituted with the functional group represented by the above Chemical Formula 2 is independently hydrogen, deuterium, or a substituted or unsubstituted C1 to C10 alkyl group.

6. The composition for an organic light emitting diode of claim 1, wherein in the above Chemical Formulae X-1 and X-2, R¹⁷ to R¹⁹ are independently a methyl group.

7. The composition for an organic light emitting diode of claim 1, wherein in the above Chemical Formula X-1,
n is an integer of 1 to 3
R² is -SiR¹⁷R¹⁸R¹⁹ or a tert-butyl group,
R⁶ is a phenyl group, and
R¹, R³ to R⁵, R⁷ and R⁸ are independently hydrogen, deuterium, or a substituted or unsubstituted C1 to C10 alkyl group.

8. The composition for an organic light emitting diode of claim 1, wherein in the above Chemical Formula X-1
n is an integer of 1 to 3
R² is a phenyl group,
R³ is -SiR¹⁷R¹⁸R¹⁹ or a tert-butyl group, and
R¹, R⁴ to R⁸ are independently hydrogen, deuterium, or a substituted or unsubstituted C1 to C10 alkyl group.

9. The composition for an organic light emitting diode of claim 1, wherein in the above Chemical Formula X-1
n is an integer of 1 to 3, and
at least one of the R¹ to R⁸ is a substituted or unsubstituted C1 to C20 alkyl group.

10. The composition for an organic light emitting diode of claim 1, wherein in the above Chemical Formula X-1, n + m is 3.

11. The composition for an organic light emitting diode of claim 1, wherein in the above Chemical Formula X-1, n + m is 1 or 2.

12. The composition for an organic light emitting diode of claim 1, wherein in the above Chemical Formula X-1,
L is one of the following Chemical Formulae L-1 to L-14: 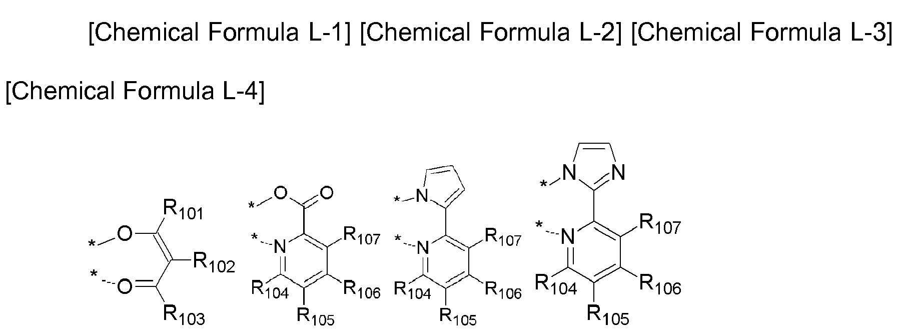 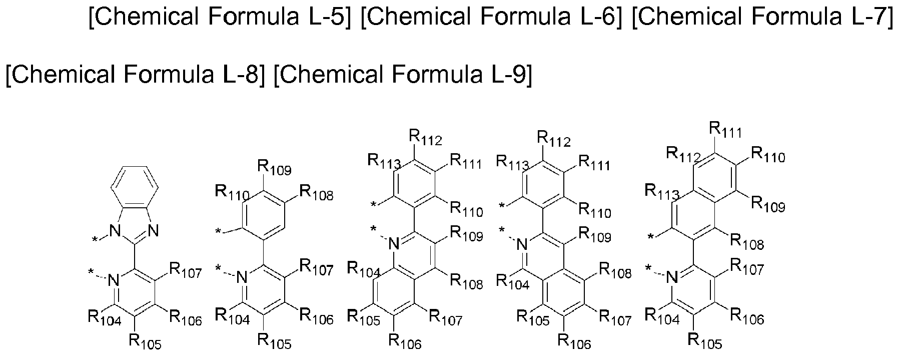 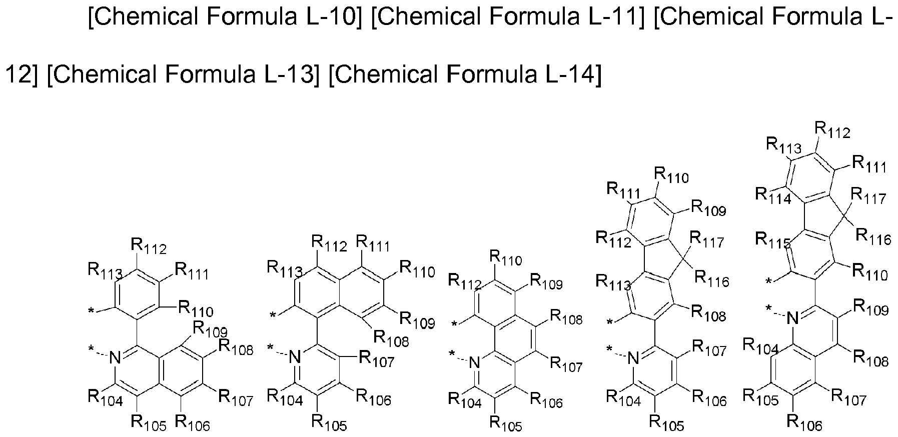 wherein, in the above Chemical Formulae L-1 to L-14,
the asterisk (*) denotes a position bonding with iridium (Ir),
R₁₀₁ to R₁₀₃ are independently hydrogen, deuterium, a C1 to C30 alkyl group substituted or unsubstituted with a halogen, a C6 to C30 aryl group substituted or unsubstituted with a C1 to C30 alkyl, or a halogen,
R₁₀₄ to R₁₁₅ are independently hydrogen, deuterium, a halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and a C6 to C30 aryl group, or a triarylsilyl group having a substituted or unsubstituted C6 to C30 aryl group, and
R₁₁₆ to R₁₁₇ are independently hydrogen, deuterium, a C1 to C30 alkyl group substituted or unsubstituted with a halogen, or a C6 to C30 aryl group substituted or unsubstituted with a C1 to C30 alkyl.

13. The composition for an organic light emitting diode of claim 1, wherein the above Chemical Formula X-1 is one of the following Chemical Formulae M-1 to M-55, Chemical Formulae P-1 to P-26, or Chemical Formulae Q-1 to Q-11:

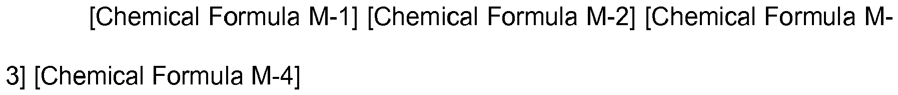

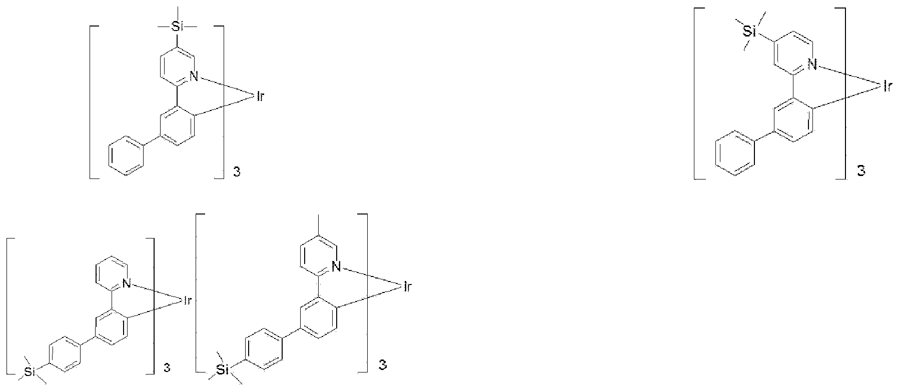

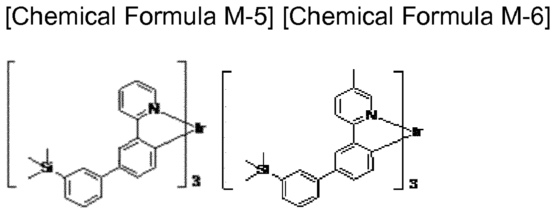

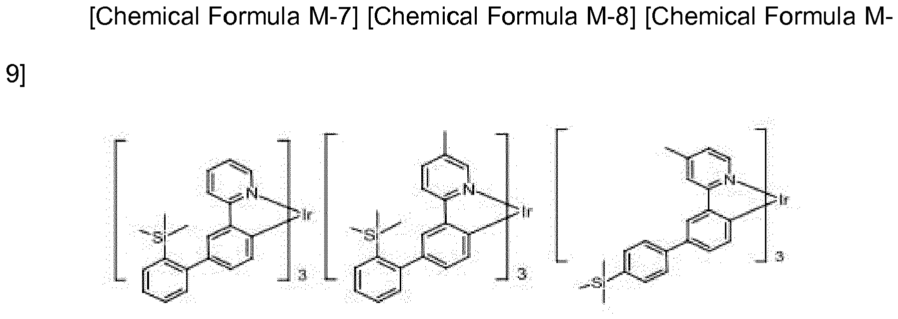

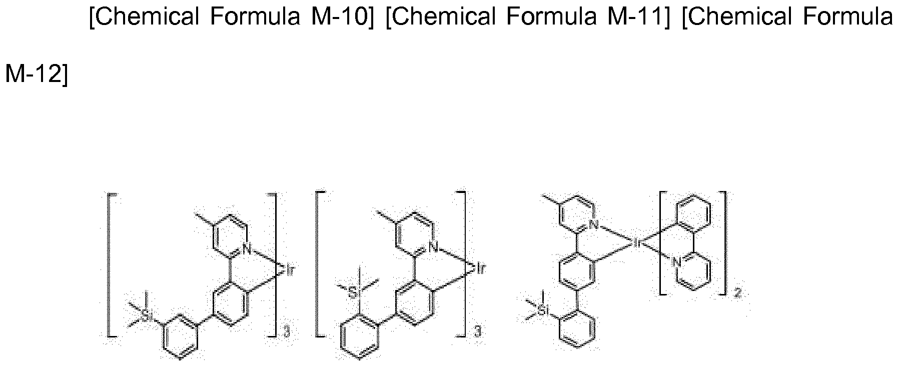

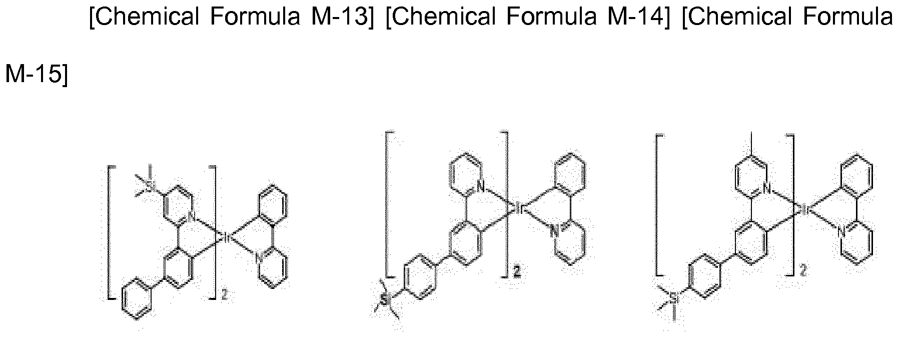

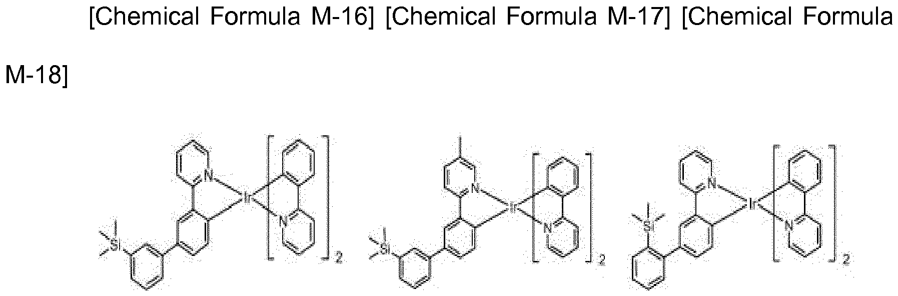

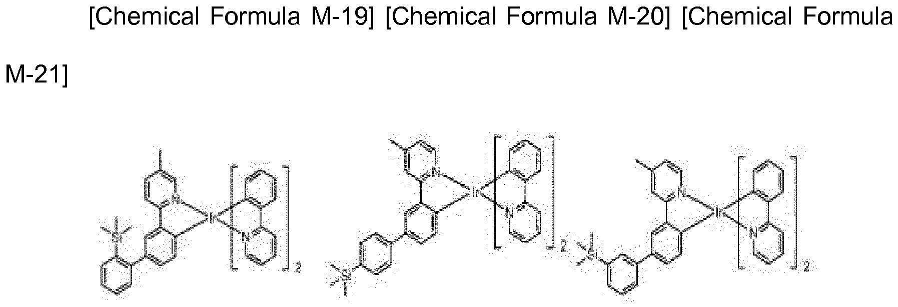

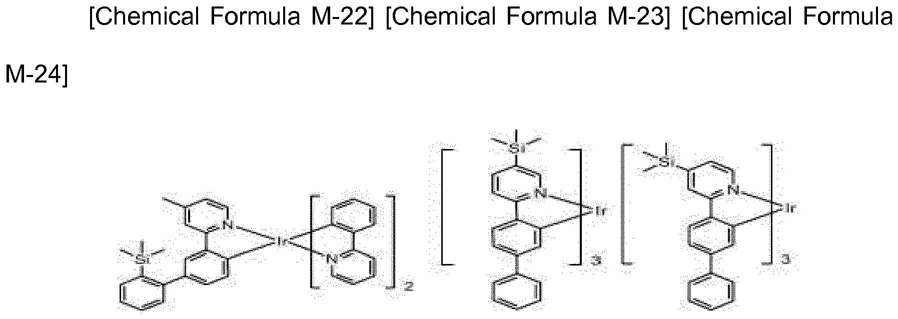

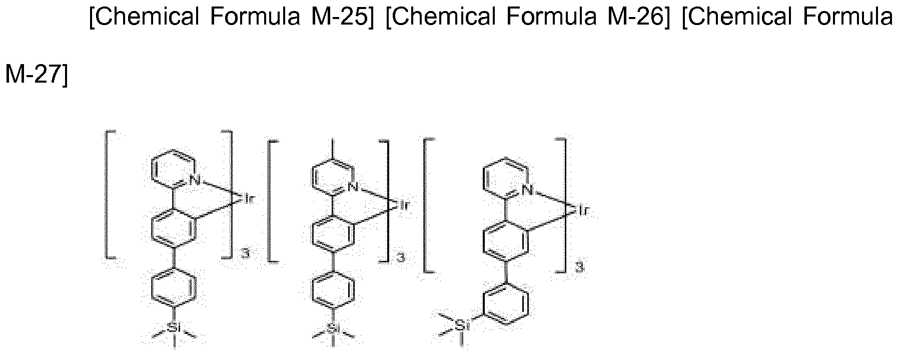

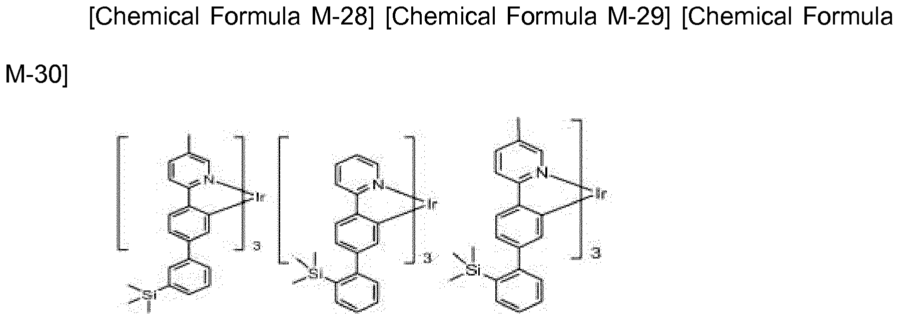

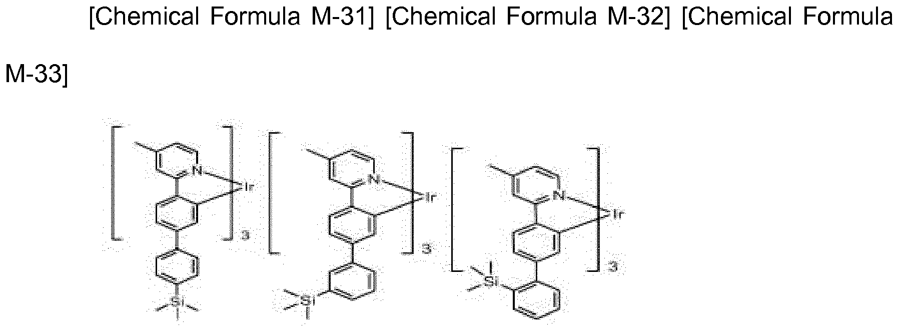

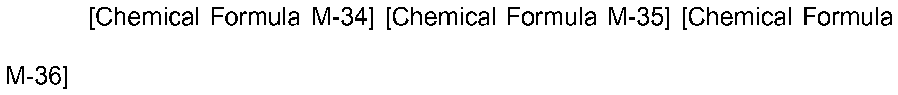

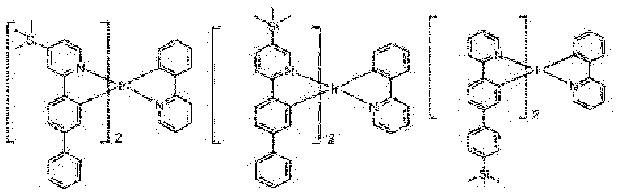

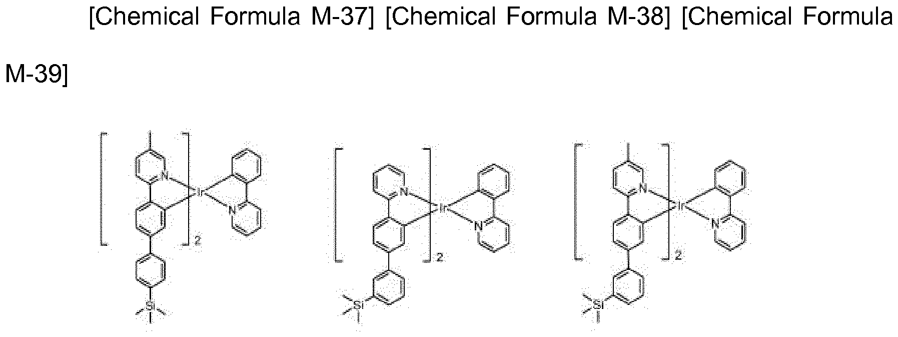

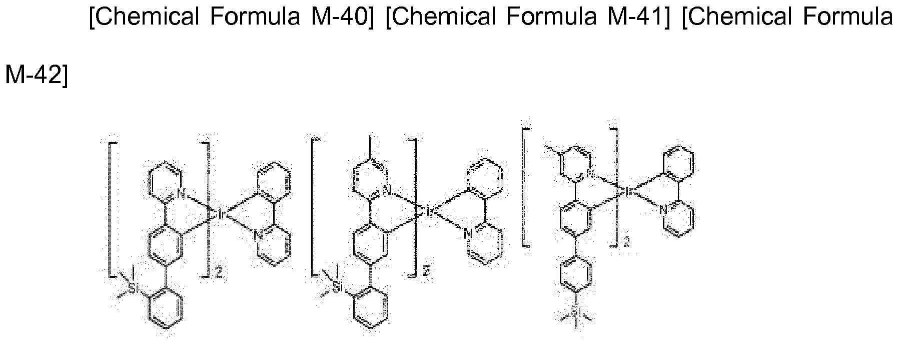

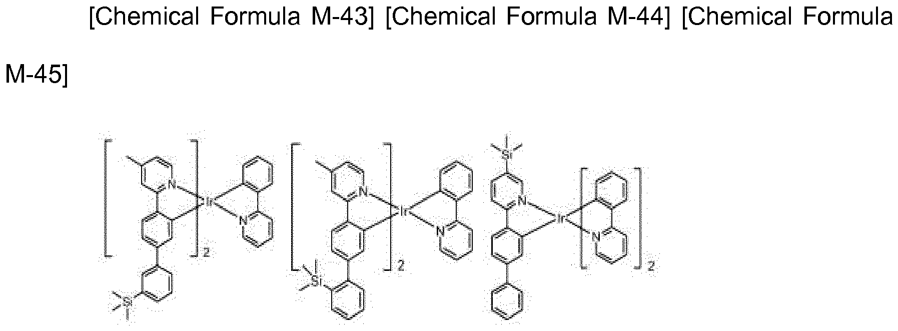

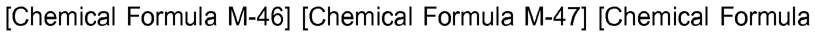

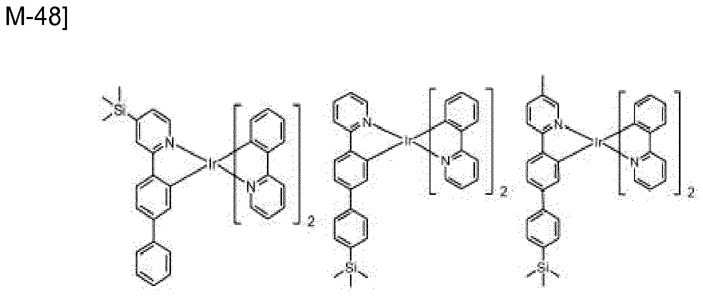

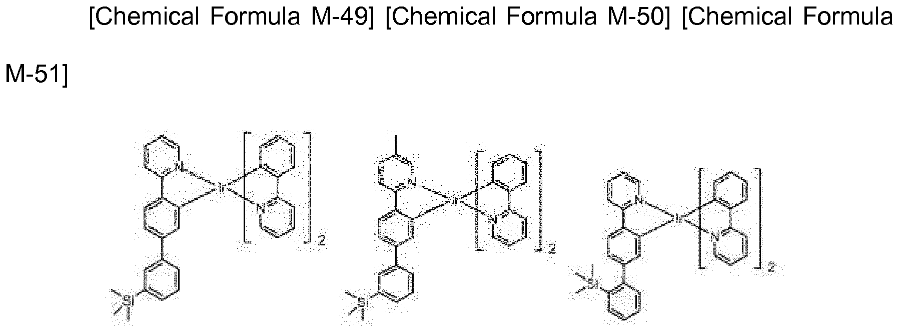

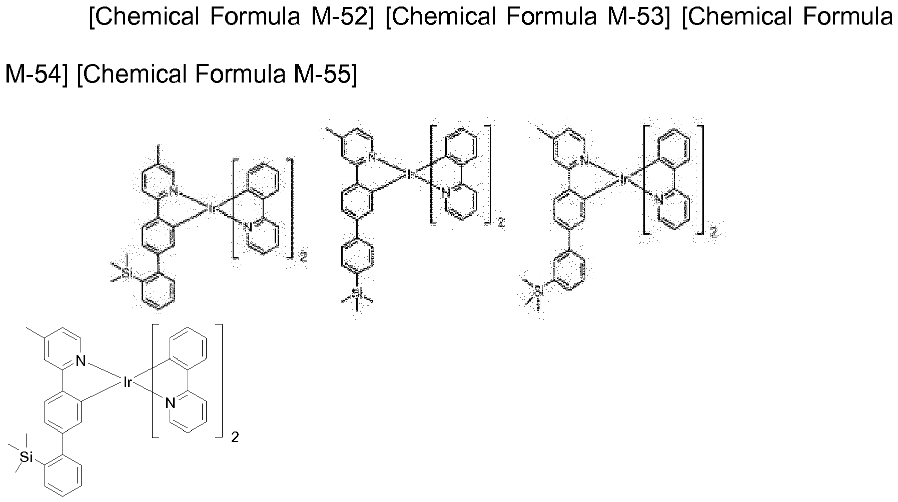

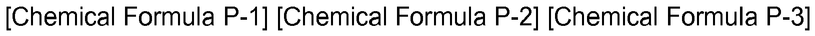

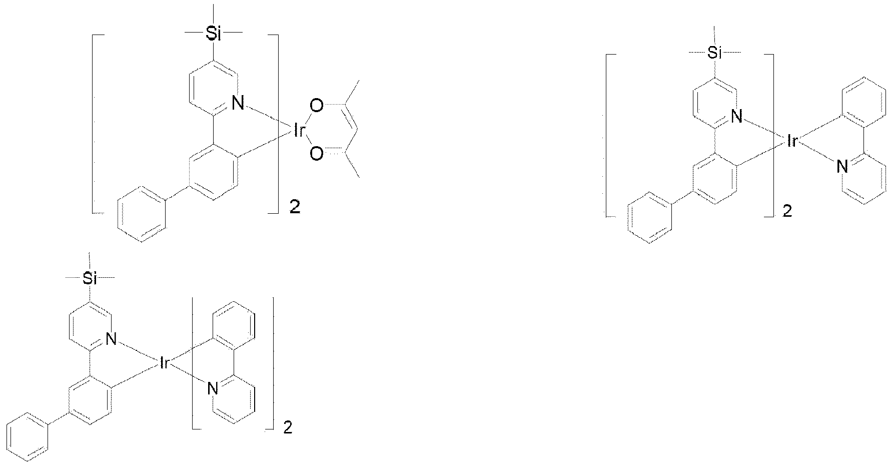

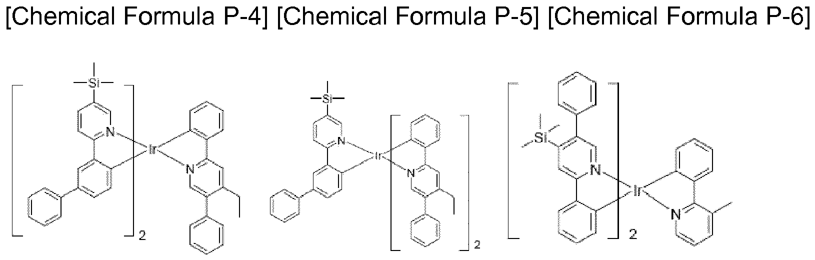

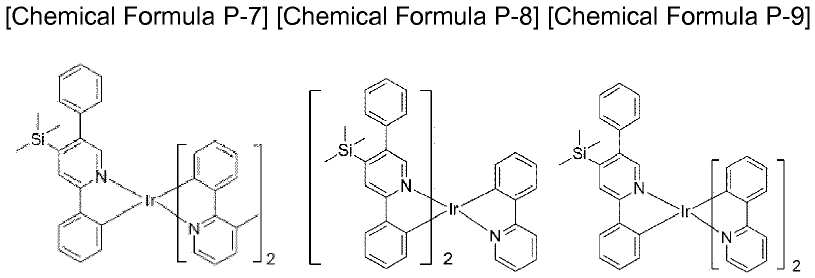

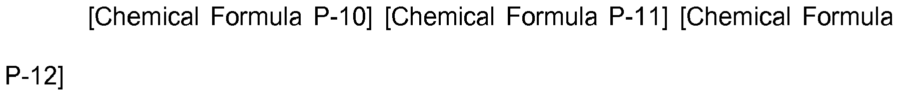

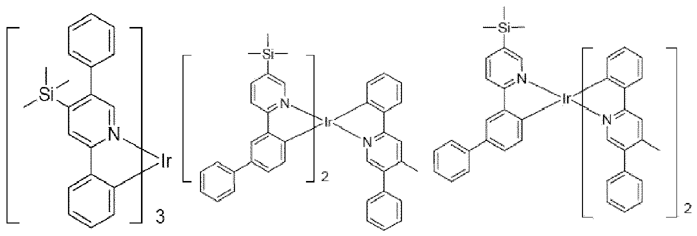

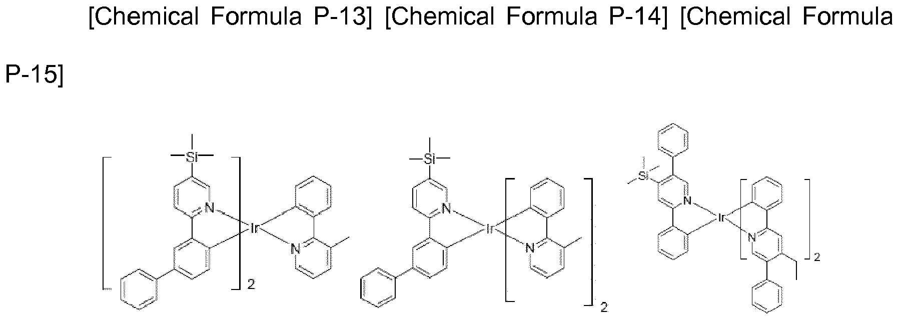

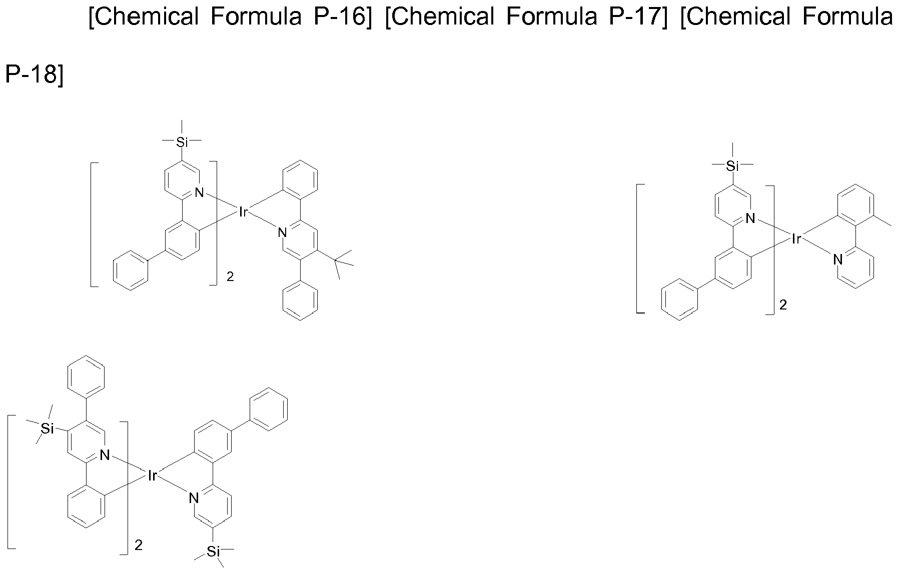

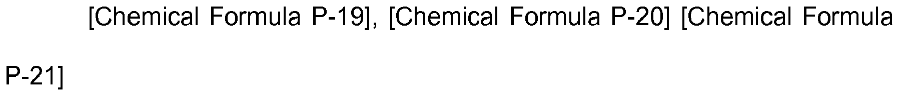

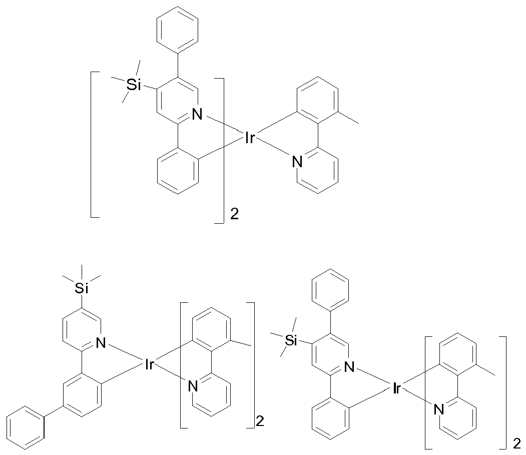

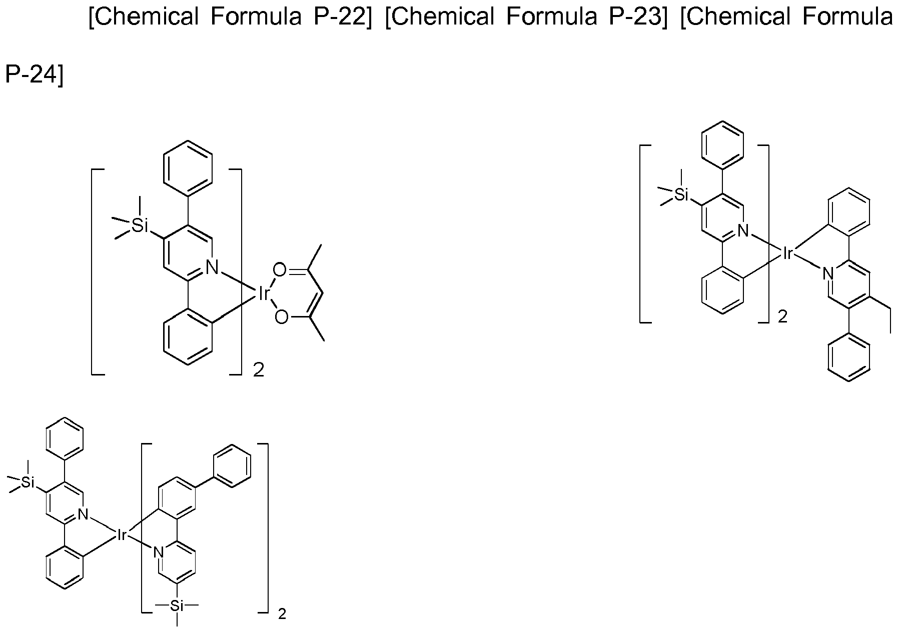

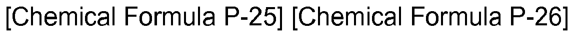

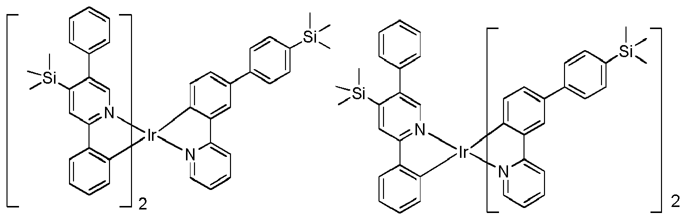

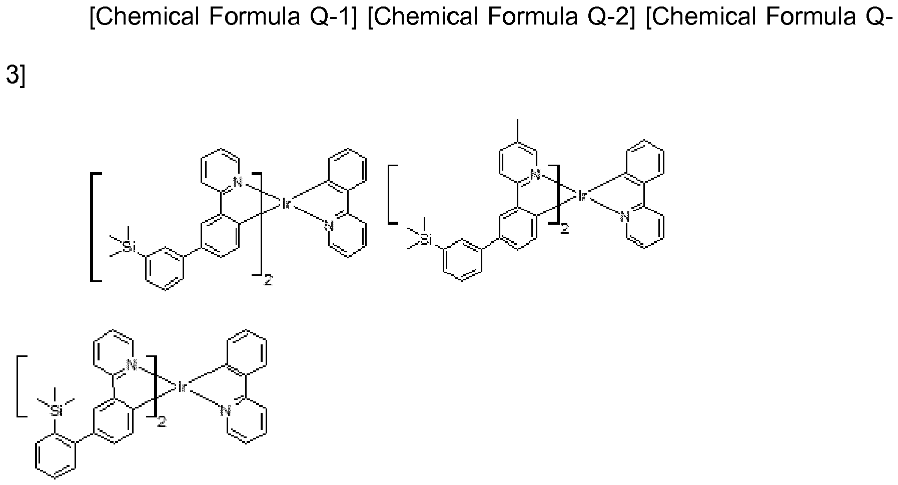

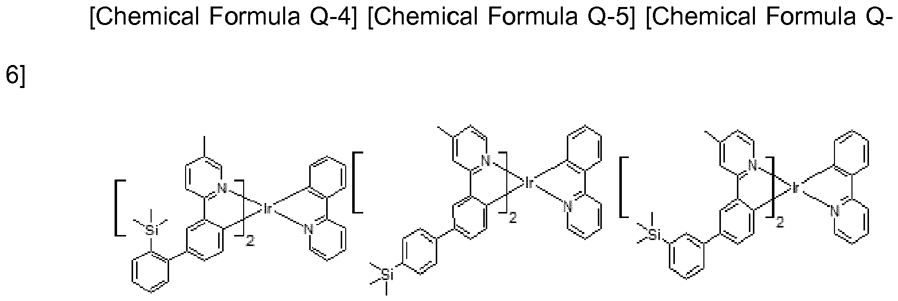

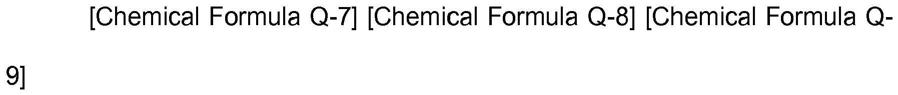

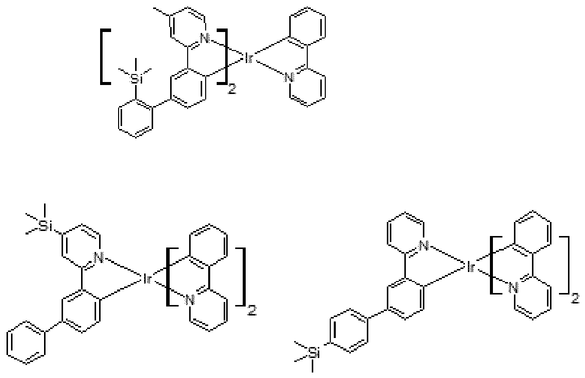

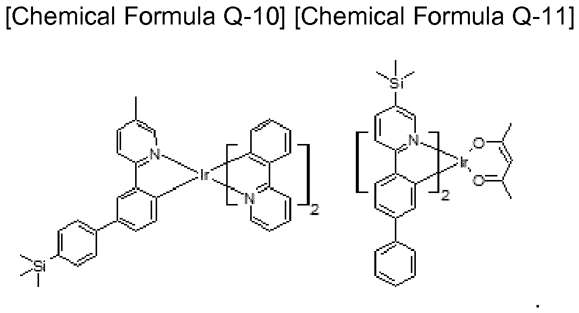

14. The composition for an organic light emitting diode of claim 1, wherein the above Chemical Formula X-1 is one of the following Chemical Formulae B-1 to B-65, Chemical Formulae C-1 to C-18, or Chemical Formulae D-1 to D-6:

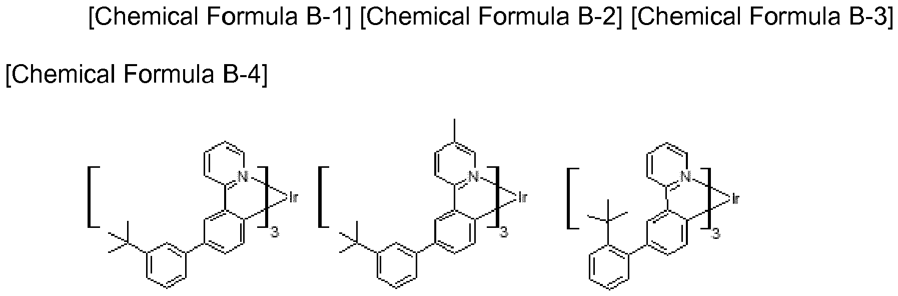

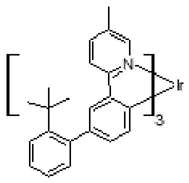

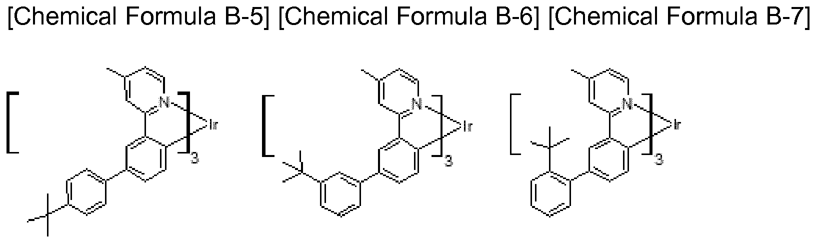

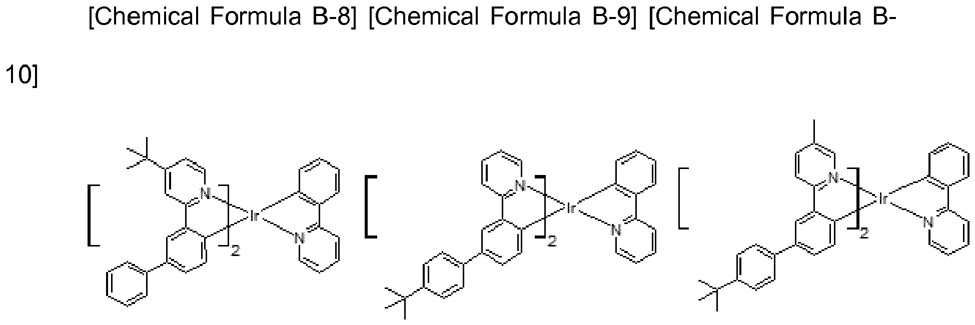

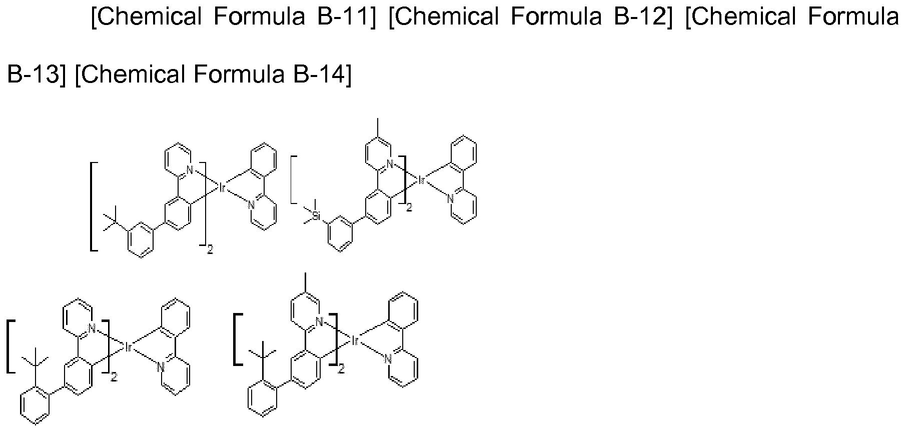

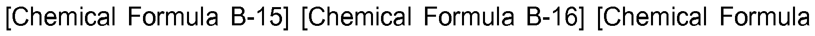

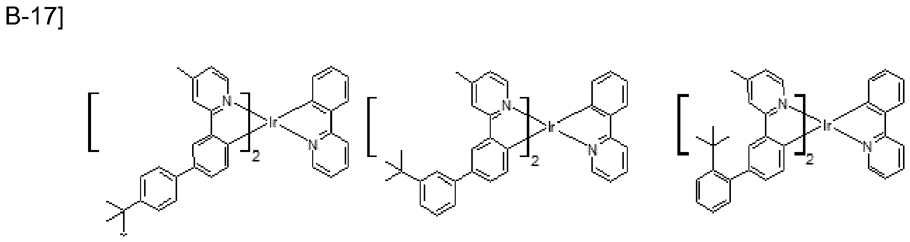

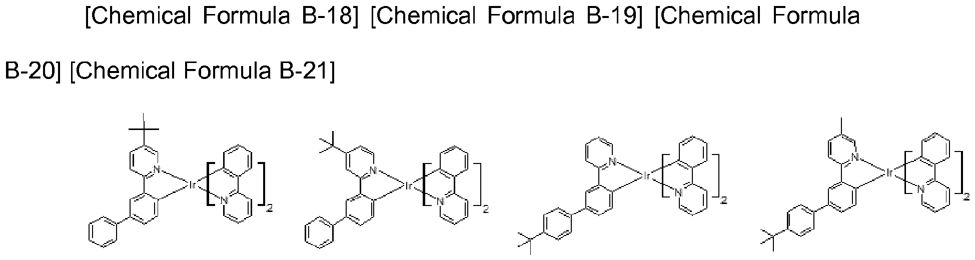

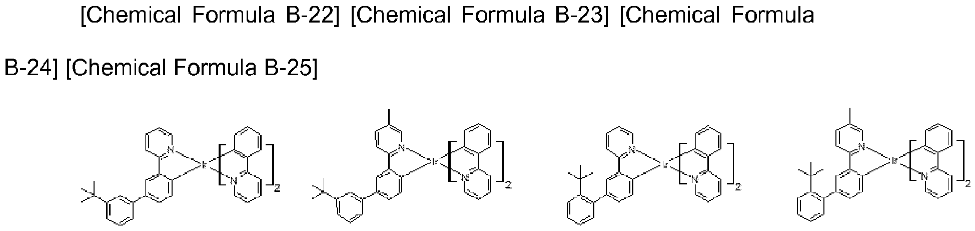

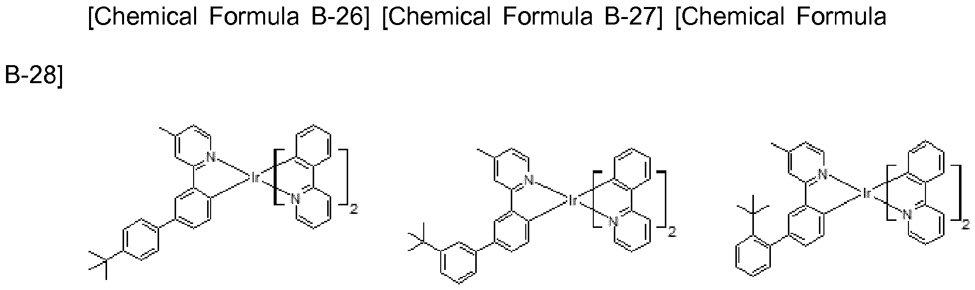

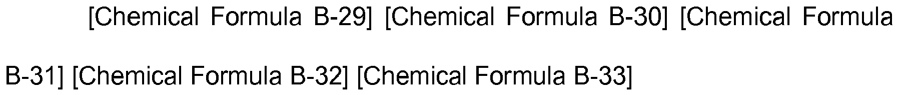

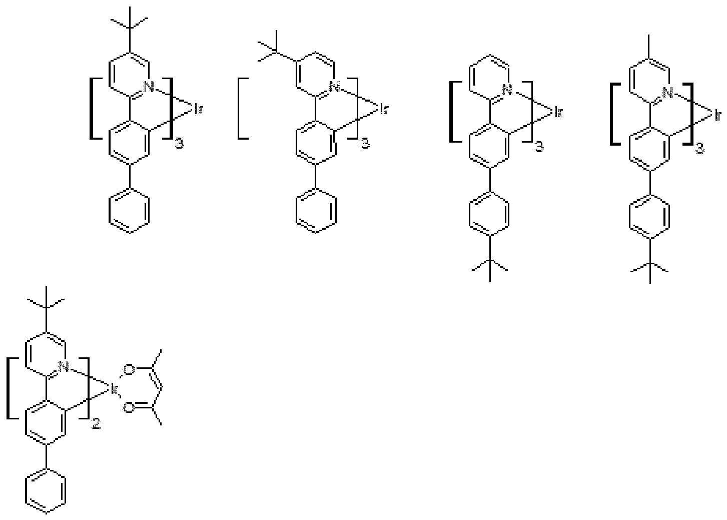

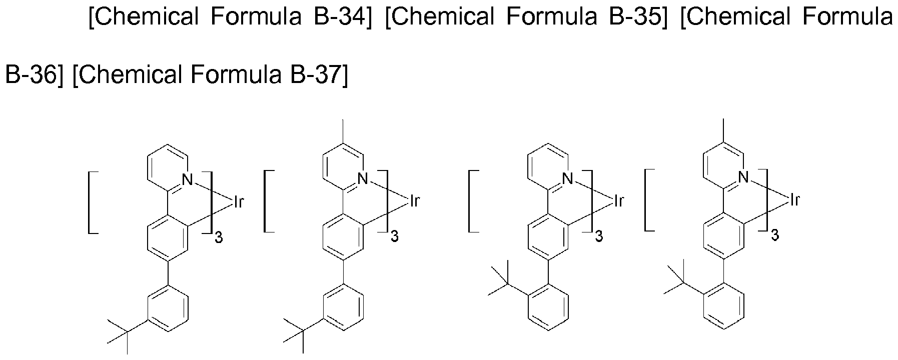

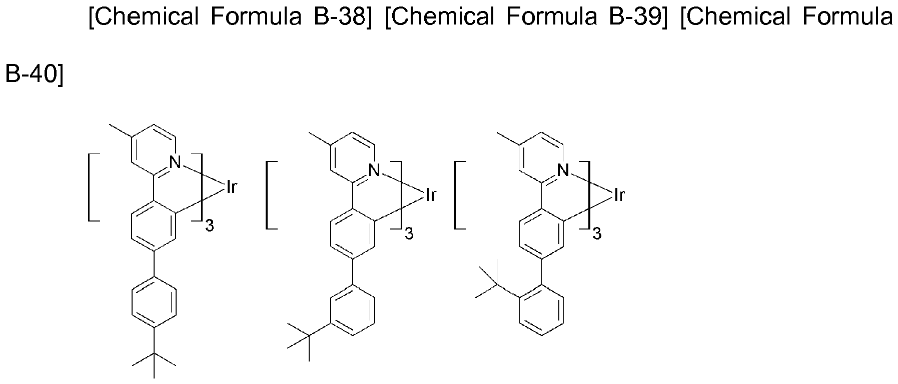

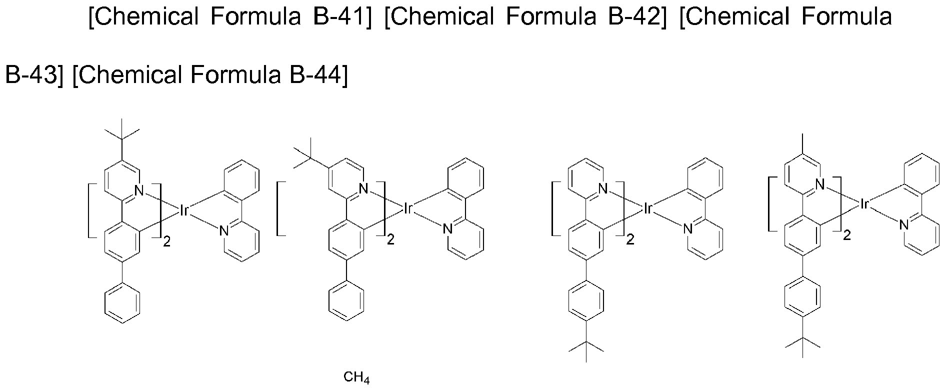

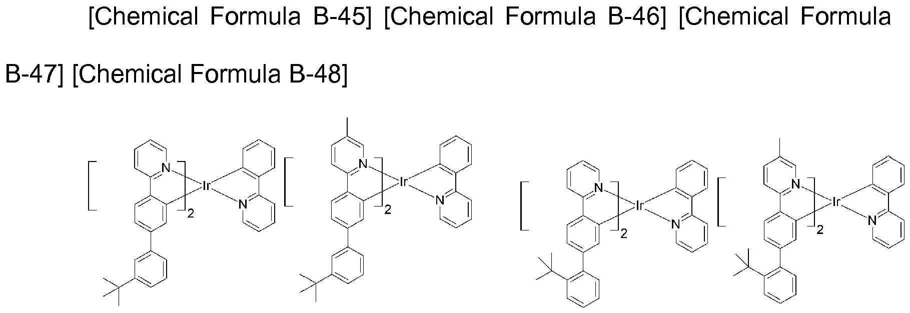

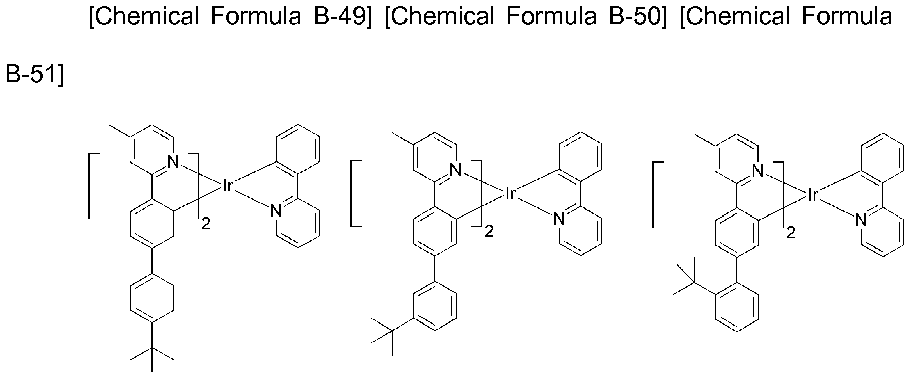

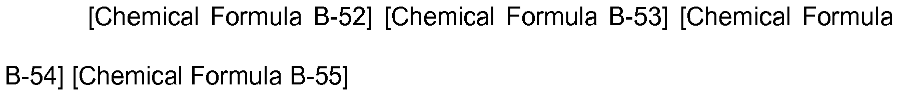

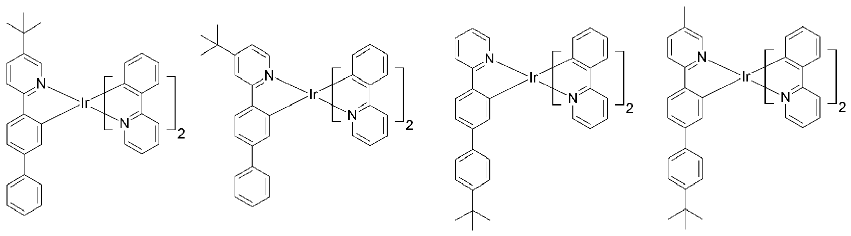

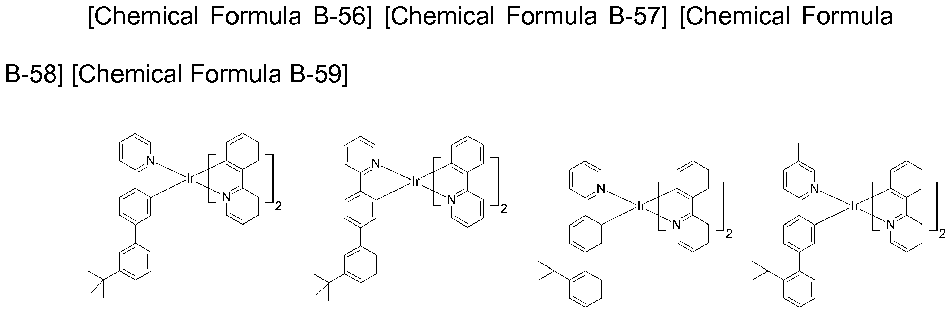

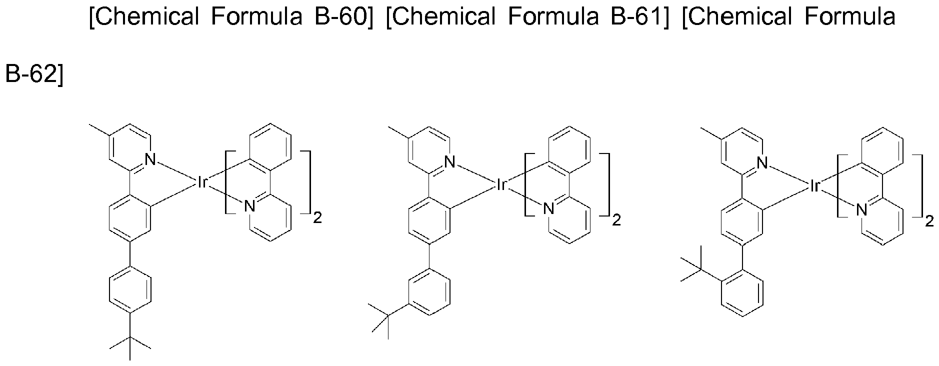

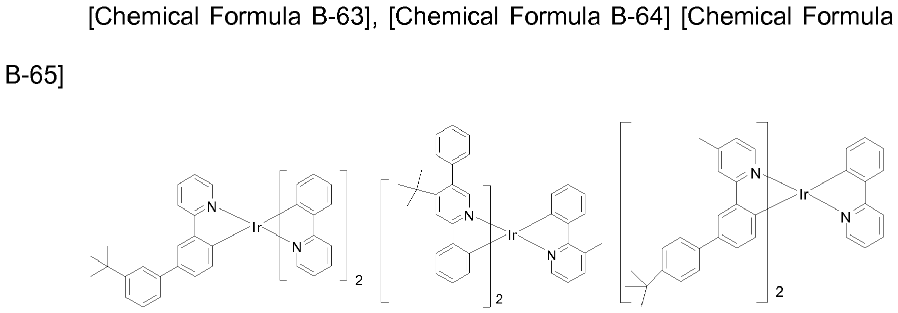

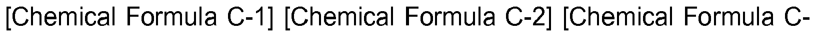

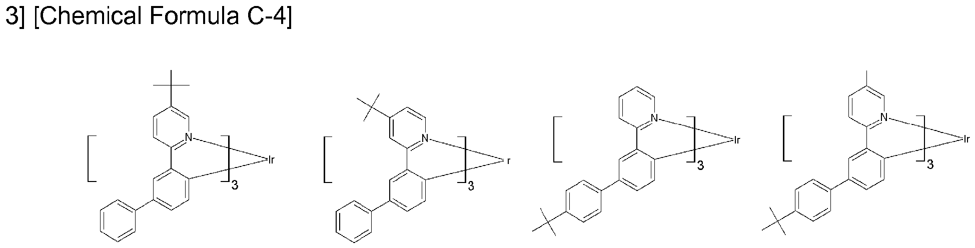

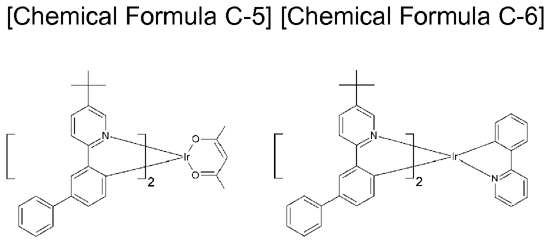

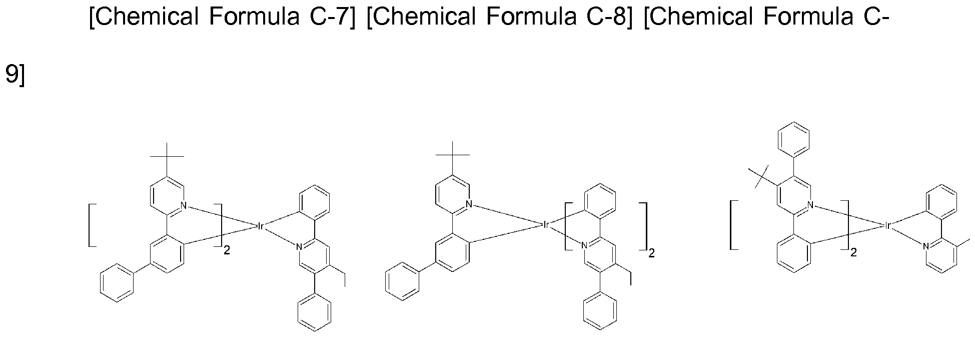

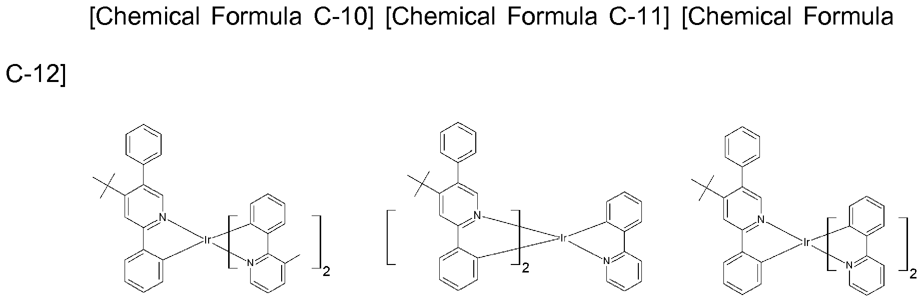

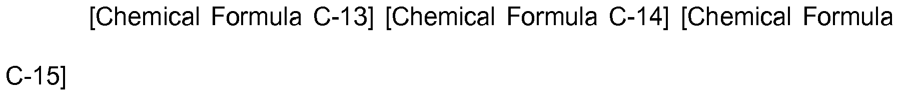

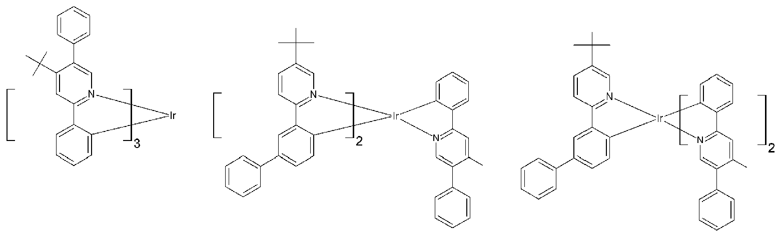

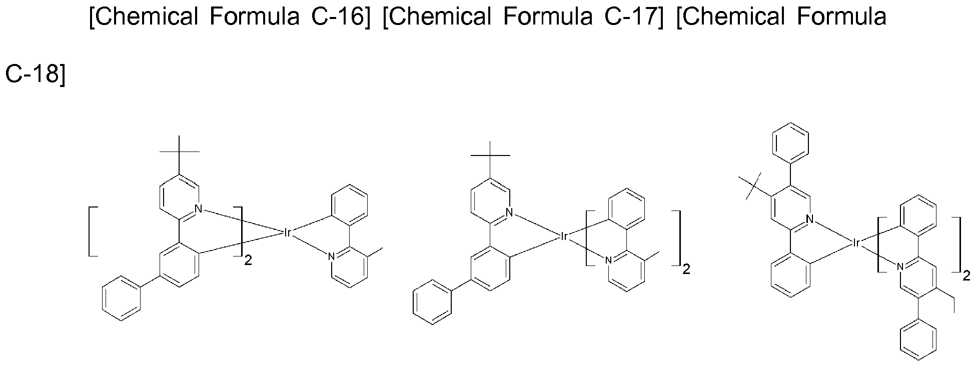

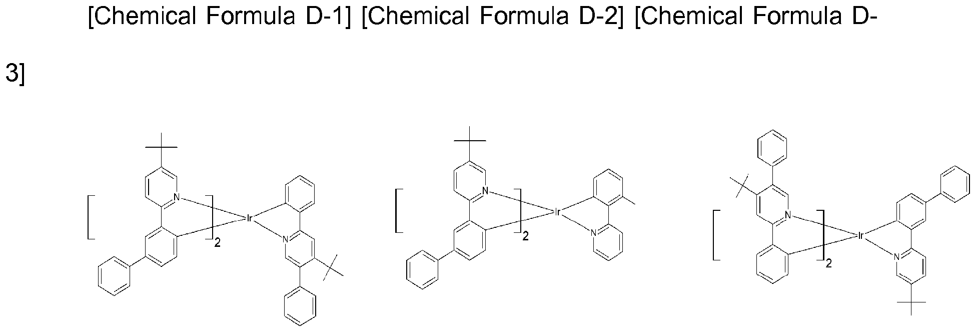

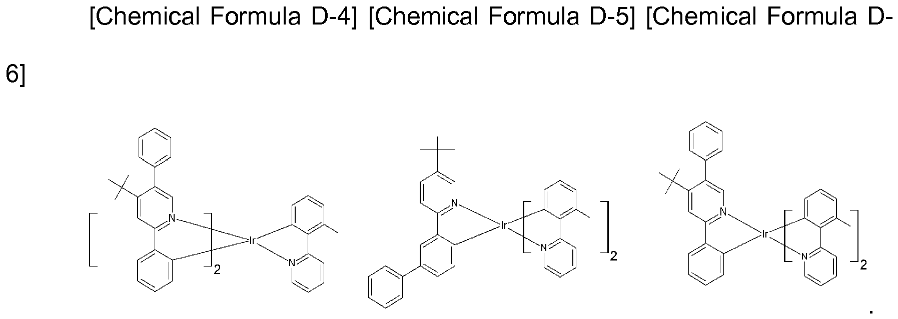

15. The composition for an organic light emitting diode of claim 1, wherein the above Chemical Formula S-1 is represented by the following Chemical Formula S-2: 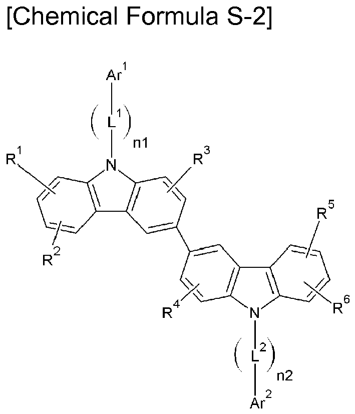 wherein, in the above Chemical Formula S-2,
Ar¹ and Ar² are independently a substituted or unsubstituted C6 to C30 aryl group or a substituted or unsubstituted C2 to C30 heteroaryl group,
at least one of Ar¹ or Ar² is a substituted or unsubstituted C2 to C30 heteroaryl group having electron characteristics,
L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 and n2 are independently integers of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

16. The composition for an organic light emitting diode of claim 1, wherein the above Chemical Formula S-1 is represented by the following Chemical Formula S-3: 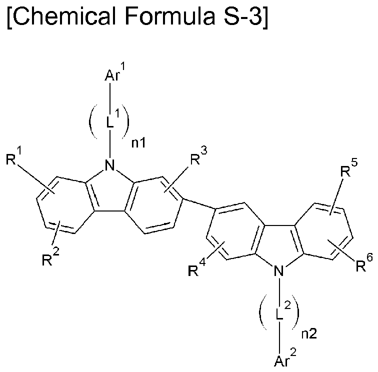 wherein, in the above Chemical Formula S-3,
Ar¹ and Ar² are independently a substituted or unsubstituted C6 to C30 aryl group or a substituted or unsubstituted C2 to C30 heteroaryl group,
at least one of Ar¹ or Ar² is a substituted or unsubstituted C2 to C30 heteroaryl group having electron characteristics,
L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 and n2 are independently integers of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

17. The composition for an organic light emitting diode of claim 1, wherein the above Chemical Formula S-1 is represented by the following Chemical Formula S-4: 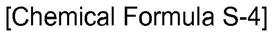 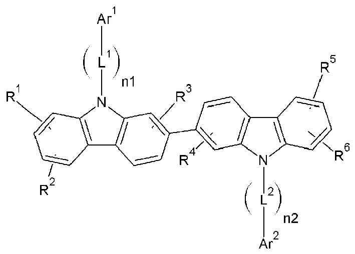 wherein, in the above Chemical Formula S-4,
Ar¹ and Ar² are independently a substituted or unsubstituted C6 to C30 aryl group or a substituted or unsubstituted C2 to C30 heteroaryl group,
at least one of Ar¹ or Ar² is a substituted or unsubstituted C2 to C30 heteroaryl group having electron characteristics,
L¹ and L² are independently a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 and n2 are independently integers of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

18. The composition for an organic light emitting diode of claim 1, wherein the above Chemical Formula S-1 is represented by the following Chemical Formula S-5: 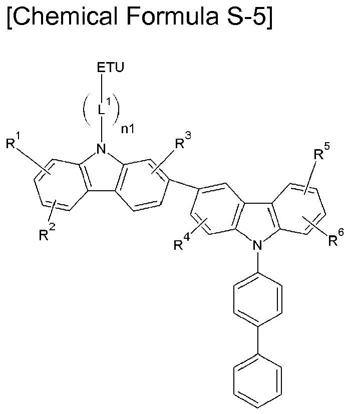 wherein, in the above Chemical Formula S-5,
ETU is a substituted or unsubstituted C2 to C30 heteroaryl group having electron characteristics,
L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 is an integer of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

19. The composition for an organic light emitting diode of claim 1, wherein the above Chemical Formula S-1 is represented by the following Chemical Formula S-6: 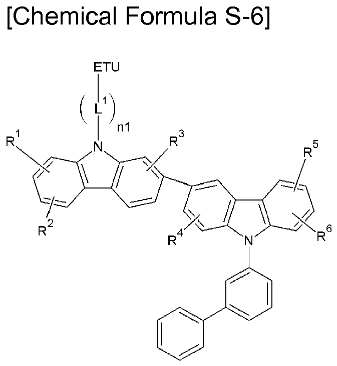 wherein, in the above Chemical Formula S-6,
ETU is a substituted or unsubstituted C2 to C30 heteroaryl group having electron characteristics,
L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 is an integer of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

20. The composition for an organic light emitting diode of claim 1, wherein the above Chemical Formula S-1 is represented by the following Chemical Formula S-7: 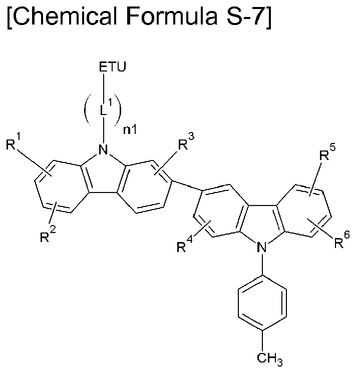 wherein, in the above Chemical Formula S-7,
ETU is a substituted or unsubstituted C2 to C30 heteroaryl group having electron characteristics,
L¹ is a single bond, a substituted or unsubstituted C2 to C6 alkenylene group, a substituted or unsubstituted C2 to C6 alkynylene group, a substituted or unsubstituted C6 to C30 arylene group, a substituted or unsubstituted C2 to C30 heteroarylene group, or a combination thereof,
n1 is an integer of 1 to 3, and
R¹ to R⁶ are independently hydrogen, deuterium, a halogen, a cyano group, a hydroxyl group, an amino group, a substituted or unsubstituted C1 to C20 amine group, a nitro group, a carboxyl group, a ferrocenyl group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

21. The composition for an organic light emitting diode of claim 1, wherein the substituted or unsubstituted C2 to C30 heteroaryl group having electron characteristics is selected from the group consisting of a substituted or unsubstituted imidazolyl group, a substituted or unsubstituted triazolyl group, a substituted or unsubstituted tetrazolyl group, a substituted or unsubstituted oxadiazolyl group, a substituted or unsubstituted oxatriazolyl group, a substituted or unsubstituted thiatriazolyl group, a substituted or unsubstituted benzimidazolyl group, a substituted or unsubstituted benzotriazolyl group, a substituted or unsubstituted pyridinyl group, a substituted or unsubstituted pyrimidinyl group, a substituted or unsubstituted triazinyl group, a substituted or unsubstituted pyrazinyl group, a substituted or unsubstituted pyridazinyl group, a substituted or unsubstituted purinyl group, a substituted or unsubstituted quinolinyl group, a substituted or unsubstituted isoquinolinyl group, a substituted or unsubstituted phthalazinyl group, a substituted or unsubstituted benzoquinolinyl group, a substituted or unsubstituted quinoxalinyl group, a substituted or unsubstituted quinazolinyl group, a substituted or unsubstituted acridinyl group, a substituted or unsubstituted phenanthrolinyl group, and a substituted or unsubstituted phenazinyl group.

22. The composition for an organic light emitting diode of claim 1, wherein the substituted or unsubstituted C2 to C30 heteroaryl group having electron characteristics is one of the following Chemical Formulae E-1 to E-5:

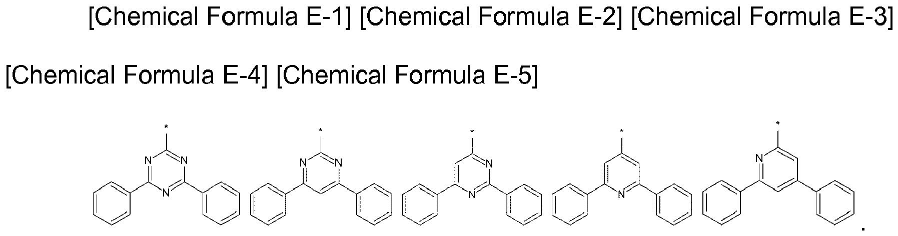

23. The composition for an organic light emitting diode of claim 1, wherein the above Chemical Formula S-1 is represented by one of the following Chemical Formulae 3 to 5, A-10, A-11, A-19, A-20, A-21, A-22, A-23, A-24, A-25, A-26, Chemical Formula T-11, Chemical Formula T-14, Chemical Formula T-15, Chemical Formula T-19, Chemical Formula T-24, Chemical Formula T-25, Chemical Formula T-35, Chemical Formula T-36, Chemical Formula T-40, Chemical Formula T-41, Chemical Formula T-45, Chemical Formula T-46, Chemical Formula T-65 or Chemical Formula T-66:

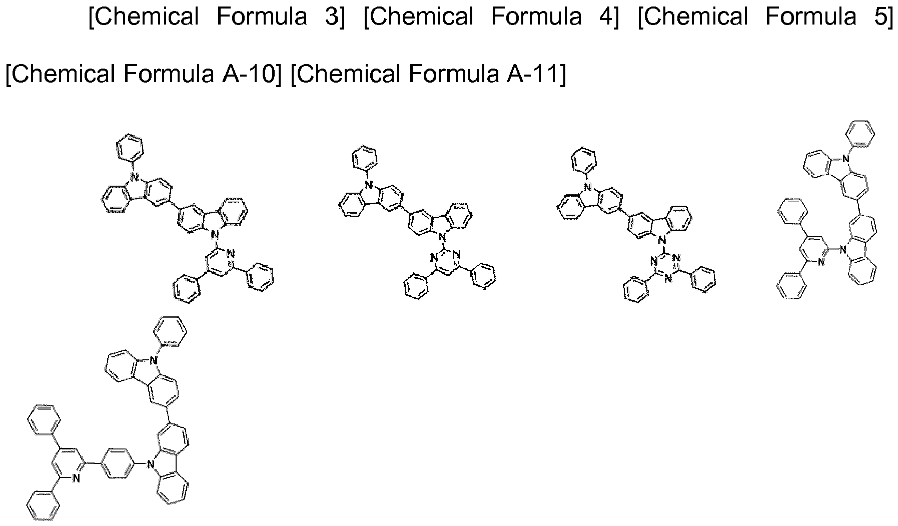

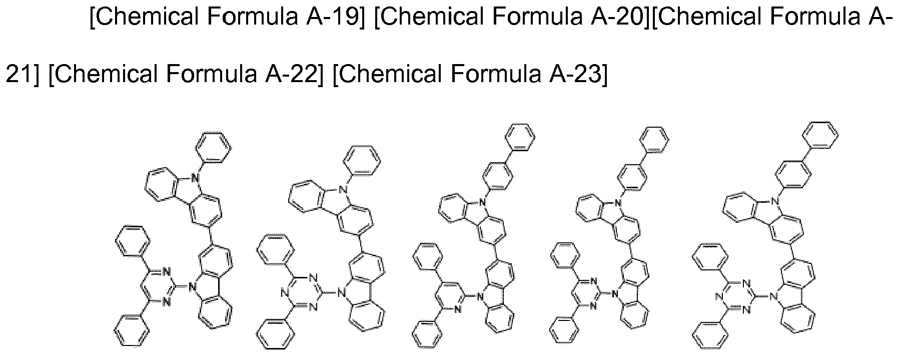

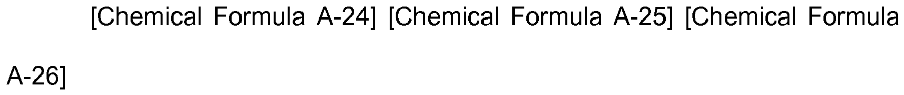

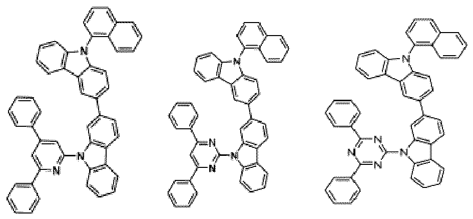

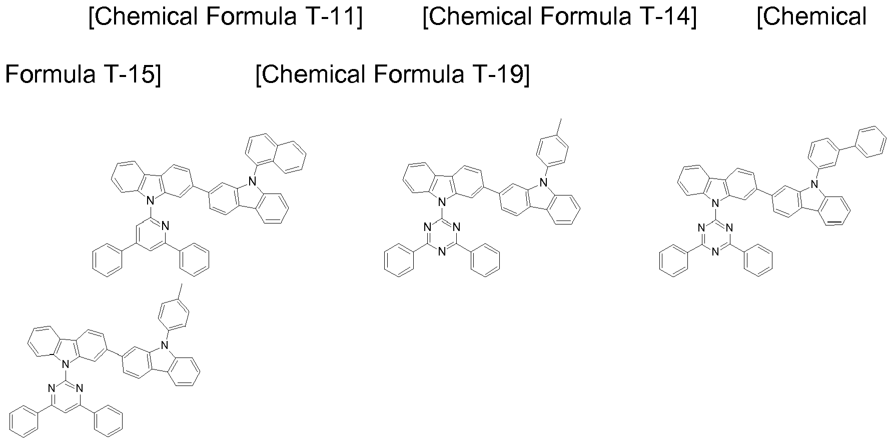

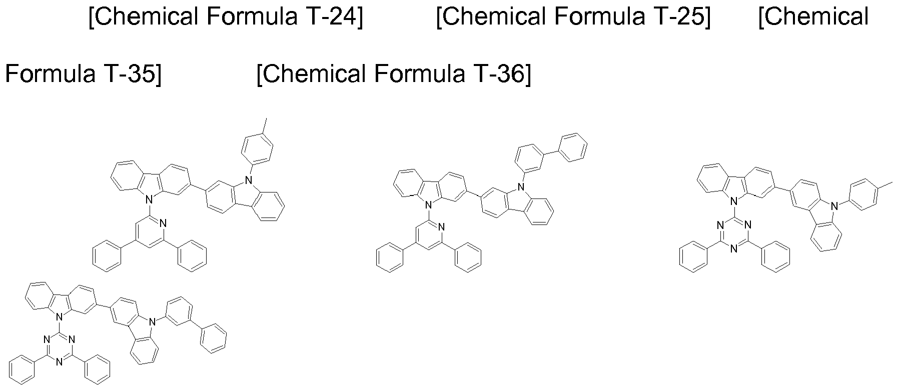

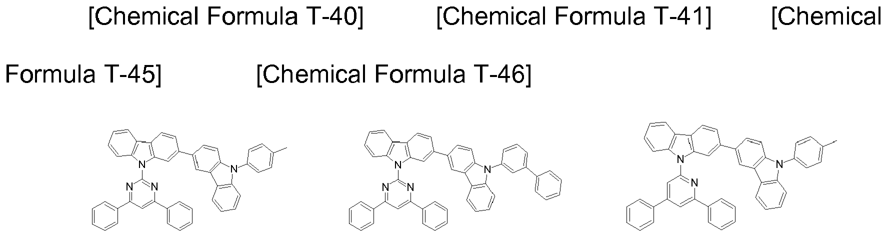

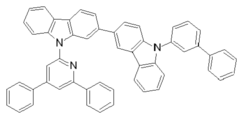

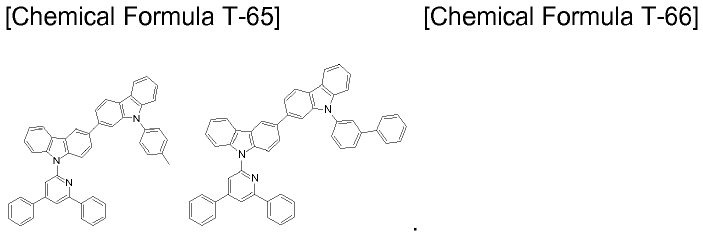

24. The v composition for an organic light emitting diode of claim 1, wherein the compound for an organic optoelectric device represented by the above Chemical Formula S-1 is one of Chemical Formula A-19, Chemical Formula A-20, Chemical Formula A-22, Chemical Formula A-23, Chemical Formula T-35, Chemical Formula T-36, Chemical Formula T-40, Chemical Formula T-41, Chemical Formula T-77, Chemical Formula T-81, Chemical Formula T-82, Chemical Formula T-96, Chemical Formula 4, Chemical Formula 5, Chemical Formula 53 or Chemical Formula 54, and the compound represented by the above Chemical Formula X-1 is one of Chemical Formula M-1, P-2, P-3, C-1, C-6 or B-18:

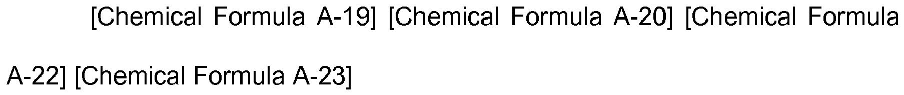

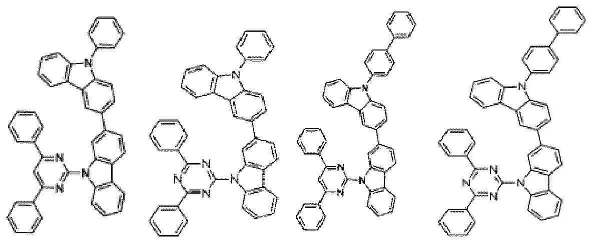

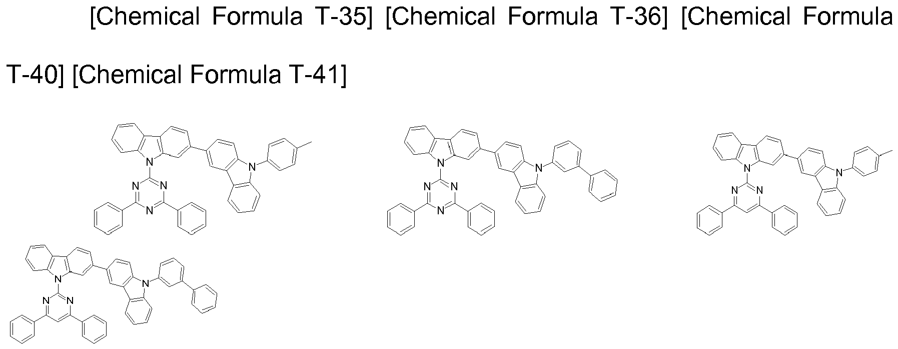

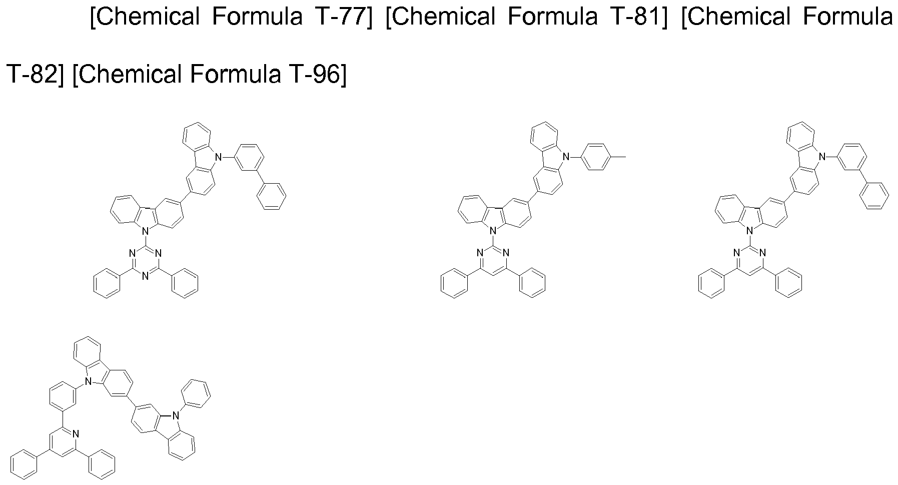

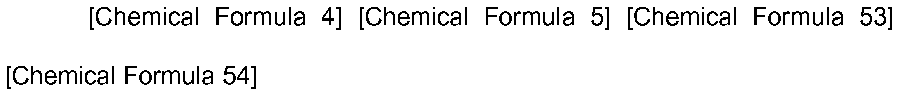

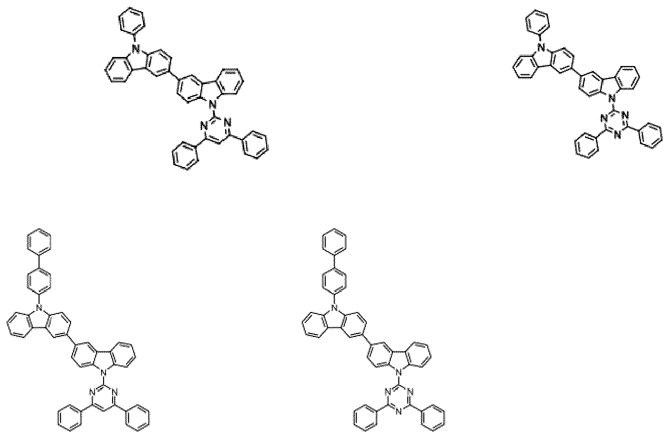

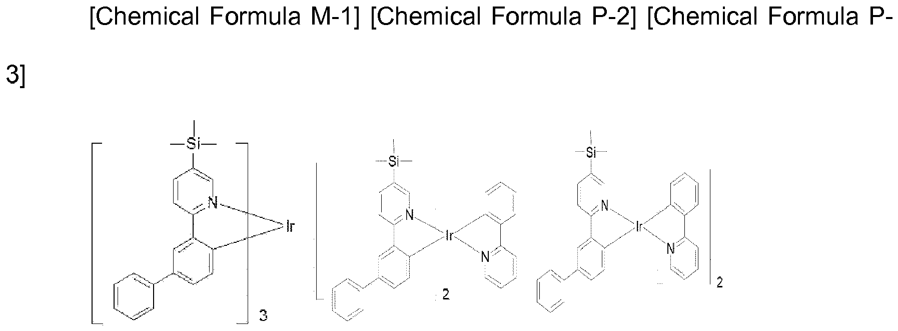

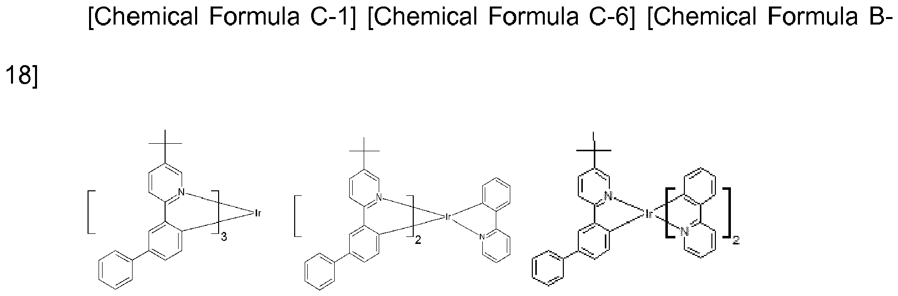

25. The composition for an organic light emitting diode of claim 1, wherein a weight ratio of the compound for an organic optoelectric device represented by the above Chemical Formula S-1 and the compound for an organic optoelectric device represented by the above Chemical Formula X-1 is 1:99 to 99:1.

26. An organic thin layer comprising the composition for an organic light emitting diode of any one of claim 1 to claim 25.

27. The organic thin layer of claim 26, wherein the organic thin layer is an emission layer.

28. An organic light emitting diode, comprising
an anode, a cathode, and
at least one organic thin layer interposed between the anode and the cathode,
wherein the organic thin layer is the organic thin layer of claim 26.
